# EUROPEAN PATENT APPLICATION

(11) **EP 4 572 541 A1**
(43) Date of publication of application: **18.06.2025**
(21) Application number: 23852260.1
(22) Date of filing: 26.06.2023
(51) Int. Cl.: H05K 3/46, B32B 15/08, H05K 1/03

(54) **METHOD FOR MANUFACTURING METAL FOIL CLAD LAMINATED SHEET, RESIN COMPOSITION, RESIN COMPOSITE SHEET, METHOD FOR MANUFACTURING PRINTED WIRING BOARD, AND METHOD FOR MANUFACTURING SEMICONDUCTOR DEVICE**

(30) Priority: 09.08.2022 JP 2022127244
(71) Applicant: MITSUBISHI GAS CHEMICAL COMPANY, INC., Chiyoda-ku Tokyo 100-8324 (JP)
(72) Inventor: OKUMURA, Keisuke, Tokyo 125-8601 (JP); KOMATSU, Kouki, Tokyo 125-8601 (JP); HASEBE, Keiichi, Tokyo 125-8601 (JP); HIRANO, Shunsuke, Tokyo 125-8601 (JP)
(74) Representative: Hoffmann Eitle
(86) International application number: PCT/JP2023/023658
(87) International publication number: WO 2024/034276

(57) **Abstract**

Provided are a method for producing a metal foil-clad laminate excellent in mass productivity and enabled to suppress delamination between a resin composition layer and a metal foil; a resin composition; a resin composite sheet; a method for producing a printed wiring board; and a method for producing a semiconductor device. A method for producing a metal foil-clad laminate, which is a method where a vacuum laminator is used to produce a metal foil-clad laminate in which a resin composite sheet C including a metal foil and a resin composition layer disposed on one side of the metal foil is laminated on a surface of a circuit board A including an insulating layer and a conductor circuit layer, the method including steps set forth below: Step 1: a step of reducing the content of moisture and/or a solvent contained in the circuit board A to obtain a circuit board B; Step 2: a step of disposing the circuit board B and the resin composite sheet C, and heating and applying pressure under an environment of reduced pressure or vacuum to obtain a laminated substrate D; and Step 3: a step of smoothing a surface of the resin composition layer of the laminated substrate D to obtain a laminated substrate E.

## Description

### Technical Field

The present invention relates to a method for producing a metal foil-clad laminate, a resin composition, a resin composite sheet, a method for producing a printed wiring board, and a method for producing a semiconductor device.

### Background Art

In recent years, a production technology of a printed wiring board in which an insulating layer is provided on a conductor circuit layer of an internal layer circuit board has been attracting attention.

For example, Patent Document 1 discloses a method for producing a multilayer printed wiring board, in which a resin composition layer of an adhesive film including a support base film and the resin composition layer laminated on a surface of the support base film is vacuum-laminated on a circuit board under heating and pressing conditions,
the method is characterized by conducting:
1) a step in which the adhesive film is heated and pressed from the support base film side with a heat-resistant rubber interposed therebetween whereby the adhesive film is vacuum-laminated on each side of the circuit board; and
2) a step in which both sides of the circuit board on which the adhesive films are vacuum-laminated are heated and pressed from the support base film side of the adhesive film with a pressing metal plate or a laminating metal roll to smooth a surface of the resin composition layer in contact with the support base film.

### Citation List

### Patent Document

Patent Document 1: JP 2009-105446 A

### Summary of Invention

### Technical Problem

Here, known manufacturing methods of printed wiring boards include a vacuum hot press process and a vacuum lamination process.

The vacuum hot press process is a method for producing a printed wiring board in a batch process and is, for example, a method in which a laminate of a circuit board and a resin sheet is placed in a vacuum hot press machine and thermally cured while being pressed under a reduced pressure or vacuum environment. This method is a useful method, but has an issue in terms of mass productivity because of long lamination time.

The vacuum lamination process is a method using a vacuum laminator to manufacture a printed wiring board in a continuous process. Specifically, this is a method in which a laminate of a circuit board and a resin sheet is hot-pressed under reduced pressure or vacuum, followed by hot-pressing with a pressing metal plate or a laminating metal roll to continuously produce a printed wiring board in a short time. For example, the method described in Patent Literature 1 is relevant to this. The vacuum lamination process is advantageous in terms of mass productivity.

However, the present inventors have conducted studies and found that when the resin sheet contains a metal foil in producing a metal foil-clad laminate by using a vacuum lamination process, the resultant metal foil-clad laminate has a delamination occurred between the metal foil and the resin composition layer. Such delamination of the metal foil may cause insufficient circuit formation or decrease in reliability, for example, during conductor circuit formation to be conducted thereafter.

An object of the present invention is to solve such an issue, and the present invention aims to provide: a method for producing a metal foil-clad laminate by using a circuit board and a resin composite sheet including a metal foil and a resin composition layer, which is the method for producing a metal foil-clad laminate excellent in mass productivity and enabled to suppress delamination between the resin composition layer and the metal foil; a resin composition to be used in the method for producing a metal foil-clad laminate; a resin composite sheet; a method for producing a printed wiring board; and a method for producing a semiconductor device.

### Solution to Problem

It has been found from a result of studies conducted by the present inventors in view of the previously mentioned issues that the delamination of the metal foil is caused by moisture and a solvent remaining in the circuit board. It has been found that the previously mentioned issues can be solved by reducing moisture and a solvent remaining in the circuit board before laminating the circuit board and the resin composite sheet and performing hot pressing under reduced pressure or vacuum.

Specifically, the previously mentioned issues have been solved by the below-mentioned steps.
<1> A method for producing a metal foil-clad laminate, which is a method where a vacuum laminator is used to produce a metal foil-clad laminate in which a resin composite sheet C including a metal foil and a resin composition layer disposed on one side of the metal foil is laminated on a surface of a circuit board A including an insulating layer and a conductor circuit layer, the method including the following steps:
   Step 1: a step of reducing a content of moisture and/or a solvent contained in the circuit board A to obtain a circuit board B;
   Step 2: a step of disposing the resin composite sheet C including a metal foil and a resin composition layer disposed on one side of the metal foil on at least one surface of the circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
   Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.
<2> The method for producing a metal foil-clad laminate according to <1>, further including, after the step 3, conducting a below-mentioned step; Step 4: a step of heating the laminated substrate E obtained in the step 3 to cure the resin composition layer to obtain a cured board F.
<3> The method for producing a metal foil-clad laminate according to <2>, wherein a mass reduction ratio of the laminated substrate E by the heating in the step 4 is 1.0 mass% or less.
<4> The method for producing a metal foil-clad laminate according to <2> or <3>, wherein the steps 2 to 4 are conducted repeatedly for the cured board F.
<5> The method for producing a metal foil-clad laminate according to any one of <2> to <4>, wherein the heating in the step 4 is conducted at a temperature of from 100 to 250°C.
<6> The method for producing a metal foil-clad laminate according to any one of <2> to <5>, wherein in the heating of the step 4, the temperature is raised in stages with two or more stages.
<7> The method for producing a metal foil-clad laminate according to any one of <2> to <6>, wherein the heating in the step 4 is conducted at temperature of from 100 to 180°C, and then further conducted at a temperature of higher than 180°C and 250°C or lower.
<8> The method for producing a metal foil-clad laminate according to any one of <1> to <7>, wherein the circuit board B obtained in the step 1 is made less likely to absorb moisture.
<9> The method for producing a metal foil-clad laminate according to any one of <1> to <8>, wherein the step 2 is conducted immediately after the step 1.
<10> The method for producing a metal foil-clad laminate according to any one of <1> to <9>, wherein the circuit board B obtained in the step 1 is stored in an atmosphere where moisture absorption is less likely to occur, and then the step 2 is conducted.
<11> The method for producing a metal foil-clad laminate according to any one of <1> to <10>, including, in the step 1, obtaining the circuit board B in which a content of moisture contained in the circuit board A is reduced.
<12> The method for producing a metal foil-clad laminate according to any one of <1> to <11>, wherein the heating in the step 1 is conducted at a temperature of from 30 to 200°C.
<13> The method for producing a metal foil-clad laminate according to any one of <1> to <12>, wherein the heating in the step 2 is conducted at a temperature of from 80 to 190°C and at a pressure of from 3 to 30 kgf/cm².
<14> The method for producing a metal foil-clad laminate according to any one of <1> to <13>, wherein the heating in the step 3 is conducted at a temperature of from 80 to 190°C and at a pressure of from 3 to 30 kgf/cm².
<15> The method for producing a metal foil-clad laminate according to any one of <1> to <14>, wherein the metal foil is a copper foil.
<16> The method for producing a metal foil-clad laminate according to any one of <1> to <15>, wherein the resin composite sheet C includes a carrier substrate, the metal foil, and the resin composition layer, in this order.
<17> The method for producing a metal foil-clad laminate according to any one of <1> to <16>, wherein the resin composition contains a thermosetting resin, and an inorganic filler is contained in an amount of from 0 to 250 parts by mass per 100 parts by mass of a resin solid content contained in the resin composition.
<18> A resin composition, which is a resin composition to be used for producing a metal foil-clad laminate, in which a resin composite sheet C including a metal foil and a resin composition layer disposed on one side of the metal foil is laminated on a surface of a circuit board A including an insulating layer and a conductor circuit layer, by a method using a vacuum laminator and including steps set forth below, the resin composition containing a thermosetting resin, wherein a content of an inorganic filler is from 0 to 250 parts by mass per 100 parts by mass of a resin solid content contained in the resin composition:
   Step 1: a step of reducing a content of moisture and/or a solvent contained in the circuit board A to obtain a circuit board B;
   Step 2: a step of disposing the resin composite sheet C including a metal foil and a resin composition layer disposed on one side of the metal foil on at least one surface of the circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
   Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.
<19> The resin composition according to <18>, wherein the thermosetting resin contains at least one selected from the group consisting of a polymer having a constitutional unit represented by the Formula (V), a polyphenylene ether compound with a terminal unsaturated carbon-carbon double bond, a maleimide compound, a cyanate ester compound, an epoxy compound, a phenolic compound, an oxetane resin, a benzoxazine compound, and an alkenyl-substituted nadimide compound, 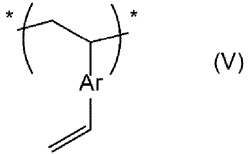 where in Formula (V), Ar represents an aromatic hydrocarbon linking group; and * represents a bonding position.
<20> The resin composition according to <18> or <19>, wherein the resin composition contains an inorganic filler, and
   the inorganic filler contains silica.
<21> The resin composition according to any one of <18> to <20>, wherein
   the resin composition contains an inorganic filler, and
   the inorganic filler has an average particle diameter (D50) of 0.1 µm or more and 5 µm or less.
<22> A resin composite sheet, which is a resin composition sheet to be used for producing a metal foil-clad laminate, in which the resin composite sheet including a metal foil and a resin composition layer disposed on one side of the metal foil is laminated on a surface of a circuit board A including an insulating layer and a conductor circuit layer, by a method using a vacuum laminator and including steps set forth below,
   the resin composition containing a thermosetting resin, wherein a content of an inorganic filler is from 0 to 250 parts by mass per 100 parts by mass of a resin solid content contained in the resin composition;
   Step 1: a step of reducing a content of moisture and/or a solvent contained in the circuit board A to obtain a circuit board B;
   Step 2: a step of disposing the resin composite sheet including a metal foil and a resin composition layer disposed on one side of the metal foil on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet is laminated on at least one surface of the circuit board B; and
   Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.
<23> The resin composite sheet according to <22>, wherein the resin composite sheet comprises a carrier substrate, the metal foil, and the resin composition layer, in this order.
<24> The resin composite sheet according to <22> or <23>, wherein the metal foil is a copper foil.
<25> The resin composite sheet according to any one of <22> to <24>, wherein the thermosetting resin contains at least one selected from the group consisting of a polymer having a constitutional unit represented by Formula (V), a polyphenylene ether compound with a terminal unsaturated carbon-carbon double bond, a maleimide compound, a cyanate ester compound, an epoxy compound, a phenolic compound, an oxetane resin, a benzoxazine compound, and an alkenyl-substituted nadimide compound, 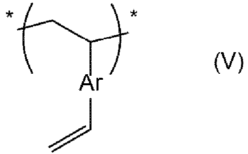 where in Formula (V), Ar represents an aromatic hydrocarbon linking group; and * represents a bon ding position.
<26> The resin composite sheet according to any one of <22> to <25>, wherein the resin composition contains an inorganic filler, and
   the inorganic filler contains silica.
<27> The resin composite sheet according to any one of <22> to <26>, wherein the resin composition contains an inorganic filler, and
   the inorganic filler has an average particle diameter (D50) of 0.1 µm or more and 5 µm or less.
<28> A method for producing a printed wiring board, the method including the method for producing a metal foil-clad laminate according to any one of <1> to <17>.
<29> A method for producing a semiconductor device, the method including the method for producing a metal foil-clad laminate according to any one of <1> to <17>.

### Advantageous Effects of Invention

The present invention enables to provide a method for producing a metal foil-clad laminate by using a circuit board and a resin composite sheet including a metal foil and a resin composition layer, which is the method for producing a metal foil-clad laminate excellent in mass productivity and enabled to suppress delamination between the resin composition layer and the metal foil; a resin composition and a resin composite sheet to be used in the method for producing a metal foil-clad laminate; a method for producing a printed wiring board; and a method for producing a semiconductor device.

### Brief Description of Drawings

FIG. 1 is a schematic view illustrating steps of a method for producing a metal foil-clad laminate of the present invention.
FIG. 2 is a schematic view illustrating steps of a known method for producing a metal foil-clad laminate using a vacuum lamination process.
FIG. 3 is a schematic view illustrating an example of a layer configuration of the metal foil-clad laminate of the present invention.

### Description of Embodiments

Hereinafter, embodiments for carrying out the present invention (hereinafter referred to simply as "the present embodiment") will be described in detail. Note that, the present embodiment described below is an example for describing the present invention, and the present invention is not limited only to the present embodiment.

Note that, as used herein, a range of "A to B" in numerical description is used in a meaning that numerical values "A" and "B" set forth before and after the "to" are both included in the range as the respective lower limit value and upper limit value thereof.

As used herein, various physical property values and characteristic values are those at 23°C unless otherwise noted.

In a description of a group (atomic group) in the present specification, a notation that does not indicate substitution or no substitution is meant to include a group (atomic group) with a substituent as well as a group (atomic group) with no substituent. For example, the "alkyl group" includes not only an alkyl group with no substituent (unsubstituted alkyl group) but also an alkyl group with a substituent (substituted alkyl group). As used herein, a notation that does not indicate substitution or no substitution preferably means unsubstituted one.

As used herein, the term "resin solid content" refers to a component other than a filler and a solvent, and is intended to include a thermosetting resin, an elastomer, and other resin additive components (e.g., an additive such as a flame retardant).

As used herein, the terms "relative permittivity" and "permittivity" are used with the same meaning.

The term "step" as used herein includes not only an independent step but also a step that cannot be clearly distinguished from other steps as long as an intended action of the step is achieved.

When the measurement method or the like described in the standard indicated in the present specification differs depending on the year, the measurement method or the like is based on the standard as of January 1, 2022, unless otherwise stated.

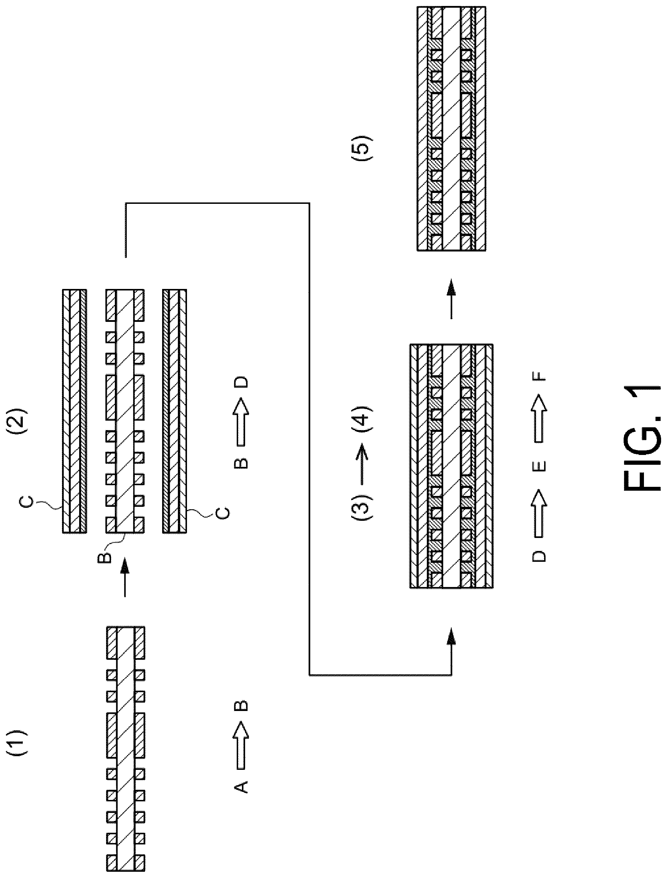

FIGs. 1 to 3 each are a schematic diagram, and scales and the like may be not consistent with reality.

The method for producing a metal foil-clad laminate according to the present embodiment is a method for producing a metal foil-clad laminate, in which a resin composite sheet C including a metal foil and a resin composition layer disposed on one side of the metal foil is laminated on a surface of a circuit board A including an insulating layer and a conductor circuit layer, by using a vacuum laminator, and the method is characterized by including the following steps.
Step 1: a step of reducing the content of moisture and/or a solvent contained in the circuit board A to obtain the circuit board B;
Step 2: a step of disposing the resin composite sheet C including a metal foil and a resin composition layer disposed on one side of the metal foil on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

With such a configuration, an excellent mass productivity can be achieved and also the delamination between the resin composition layer and the metal foil in the metal foil-clad laminate can be effectively suppressed. Furthermore, delamination and blister at the interface between the circuit board and the resin composition layer can also be effectively suppressed.

Specifically, as described above, the known vacuum hot press process is a batch process and hence is poor in terms of mass productivity. Accordingly, a vacuum lamination process is thought to be employed.

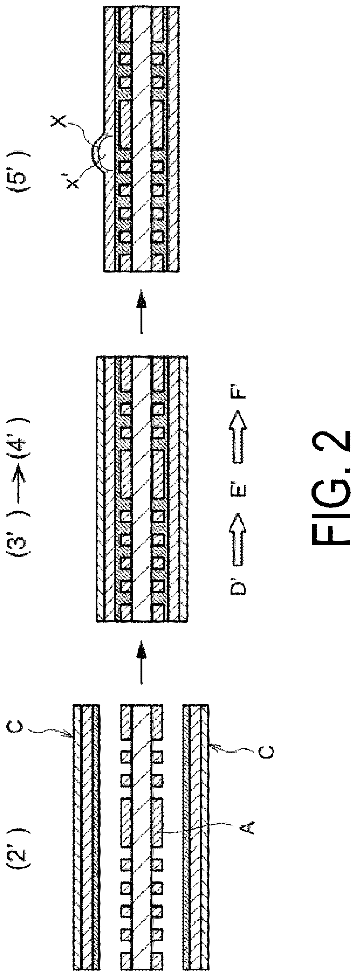

The reason will be explained later, in the vacuum hot press process, an intentional reduction of the contents of moisture and/or of a solvent contained in a circuit board on which the resin composite sheet is to be laminated is not implemented. FIG. 2 is a schematic view illustrating steps in the case of producing a metal foil-clad laminate using a vacuum lamination process without including a step of reducing the contents of moisture and/or of a solvent contained in a circuit board on which a resin composite sheet is to be laminated. Specifically, it is a schematic view illustrating steps of a method for producing a metal foil-clad laminate, not including a step of reducing the contents of moisture and/or of a solvent contained in the circuit board A to obtain the circuit board B.

In the step (2') of FIG. 2, A is a circuit board, and C is a resin composite sheet including a metal foil and a resin composition layer disposed on one side of the metal foil. In FIG. 2, the resin composite sheets C are set in a vacuum laminator in a way that the resin composite sheets C sandwich the circuit board A, and hot pressing (heating and the application of pressure) is conducted in an environment of reduced pressure or vacuum to obtain a laminated substrate D'. The resultant laminated substrate D' is heated and pressed from the surface on the metal foil side with a pressing metal plate or a laminating metal roll to smooth the surface of the resin composition layer of the laminated substrate D', whereby a laminated substrate E' can be obtained (step (3') in FIG. 2). Subsequently, the laminated substrate E' is usually heated to cure the resin composition layer, thereby giving a cured board F' (step (4') in FIG. 2).

Here, as described in Patent Document 1, in a case where a resin film without a metal foil is laminated as a support on a surface of a circuit board, there is no particular issue with delamination between a resin composition layer and the support, while it has been found that, in a case where a laminated substrate E' is obtained by using a resin composite sheet C having a metal foil, when the laminated substrate E' is further thermally cured to give a cured board F', delamination occurs between the resin composition layer and the metal foil (FIG. 2 (5')). Specifically, it has been found that a part of the metal foil becomes a blister as illustrated by X in FIG. 2. This blister of the metal foil has a size ranging from a few millimeters in diameter to 10 cm or more in diameter when it comes to big one.

The present inventors have conducted detailed studies on the cause of this phenomenon, and found that the circuit board A contains moisture and a solvent, and this blister is caused by vaporization of the moisture and/or of the solvent upon heating. Especially, it has been found that this blister is caused by the vaporization upon heating in the step (step (4') in FIG. 2) in which the laminated substrate E' is further thermally cured to give the cured board F'. That is, in the case of the resin film as described in Patent Document 1, the gas generated during heat curing process passes through the resin film and is discharged to the outside of the laminated substrate, but the metal foil is excellent in gas barrier properties and hence does not allow the generated gas to pass therethrough. Accordingly, it has been found that the gas remains inside of the laminated substrates D' to E', and the gas remaining in the inside becomes an air bubble X' to cause the blister X of the metal foil mainly in the step of further thermally curing the laminated substrate E' to give the cured board F' (step (4') in FIG. 2). Furthermore, it has been also found that delamination may occur due to similar air bubbles that are formed between the circuit board A and the resin composite sheet C.

In the present invention, the contents of moisture and/or of a solvent in the circuit board A has been reduced before placement of the circuit board A in the vacuum laminator, and thereby enabling to suppress the blister of the metal foil and to suppress the delamination between the resin composition layer and the metal foil.

In addition, it was found that the delamination can be effectively suppressed by reducing the content of an inorganic filler in the resin composition layer. This is presumed to be due to that an inorganic filler is prone to absorb moisture. Note that, the details of the resin composition are preferably the matters described in the section of <Resin composition> described later.

On the other hand, the vacuum hot press process thermally cures the laminated substrate with pressing with a metal plate and hence can physically suppress the blister. Also, the vacuum hot press process thermally cures the laminated substrate over a sufficient amount of time under an environment of reduced pressure or vacuum, and therefore the outgassing from the laminated substrate is promoted, and the blister can be suppressed. Hence, the vacuum hot press process can successfully produce the metal foil-clad laminate without any issue even without any intentional reduction of the contents of moisture and/or of a solvent contained in the circuit board on which the resin composite sheet is to be laminated. That is, the issue of the present embodiment is an issue peculiar to the case of using a vacuum laminator and using a resin composite sheet including a metal foil and a resin composition layer disposed on one side of the metal foil. Furthermore, in the vacuum lamination process, since the thermal curing step (step 4) may be conducted in an unpressed condition or can be conducted even under atmospheric pressure, outgassing is less likely to occur and the gas tends to accumulate inside, and the blister of the metal foil is prone to occur.

Hereinafter, details of the present embodiment will be described with reference to FIG. 1. It is needless to say that the present embodiment is not limited to FIG. 1.

The production method of the present embodiment is a method for producing a metal foil-clad laminate as described above. In the metal foil-clad laminate in the present embodiment, a resin composite sheet C including a metal foil and a resin composition layer disposed on one side of the metal foil is laminated on a surface of a circuit board A including an insulating layer and a conductor circuit layer. In the present embodiment, such a metal foil-clad laminate is produced by using a vacuum laminator in order to improve mass productivity. The use of a vacuum laminator enables to continuously produce the metal foil-clad laminate, and can reduce the amount of time required for the lamination step (of embedding the resin composition in the circuit board and causing the resin composition to adhere to the circuit board, mainly the step 2), and thus the method is excellent in mass productivity.

### <Step 1>

The step 1 includes a step of reducing the content of moisture and/or of a solvent contained in the circuit board A to obtain the circuit board B ((1) in FIG. 1). The circuit board A includes an insulating layer and a conductor circuit layer. An insulating layer usually contains an organic substance and water or a residual solvent. In the present embodiment, the circuit board B is obtained by reducing the content of moisture and/or of a solvent from the circuit board A, thereby enabling to effectively suppress delamination caused by the blister of the metal foil in the step 4 described later. That is, the circuit board A absorbs water naturally or a residual solvent remains therein. This moisture and/or the solvent volatilizes to become a gas in the step 4. In contrast, in the present embodiment, the metal foil is included in between the circuit board and the resin composite sheet laminated thereon, and thus the gas does not easily pass therethrough and forms a blister, thereby causing the delamination between the metal foil of the resin composition sheet and the resin composition layer. The present embodiment includes the step of obtaining the circuit board B having a content of moisture and/or of a solvent reduced from those contained in the circuit board A, and hence can effectively suppress such a blister. Moreover, the amount of time for vacuum lamination can be reduced, and mass productivity can be improved.

In the present embodiment, the mass reduction ratio of the circuit board B to the circuit board A is preferably 0.01 mass% or more, more preferably 0.05 mass% or more, and still more preferably 0.10 mass% or more. With the mass reduction ratio being greater than or equal to the lower limit value, the amount of gas generated from the circuit board B during heating (particularly in the process of thermal curing) tends to be enabled to be effectively suppressed. The upper limit value of the mass reduction ratio of the circuit board B to the circuit board A is not particularly limited, but is preferably 5% or less, more preferably 3% or less, and still more preferably 2% or less.

Here, the mass reduction ratio of the circuit board B to the circuit board A is defined by [(Mass of circuit board A - Mass of circuit board B) / Mass of circuit board A] × 100 (unit: mass%).

The total amount of moisture and the solvent contained in the circuit board B is preferably 0.25 mg or less, more preferably 0.15 mg or less, and still more preferably 0.10 mg or less per cm² of the area of the circuit board B. The lower limit value of the total amount of moisture and the solvent contained in the circuit board B is not particularly limited, but is practically 0.001 mg or greater per cm² of the area. Specifically, for example, in the case of a substrate having a substrate size of 515 × 415 mm, the total amount of moisture and the solvent contained in the circuit board B is indicated by [Substantial amount (mg) of the amount of moisture and the amount of solvent / (51.5 cm × 41.5 cm)] per cm² of the area of the circuit board B.

Here, the total amount of moisture and the solvent contained in the circuit board B is a value with the total amount of moisture and the solvent after heating of the circuit board A at the heating temperature and the heating time in the step 4 being 0.

Note that the resin composition layer contained in the resin composite sheet may also contain moisture and/or a solvent, but as a result of studies conducted by the present inventors, the amount of moisture and/or a solvent derived from the resin composition layer is much smaller than the amount contained in the circuit board A. This is because the resin composition **layer is** usually very thin. Therefore, the amount of moisture in the circuit board A has been found to have a major effect on the blister.

The reason for this is assumed to be based on things such as low content of moisture and/or of a solvent in the resin composite sheet C because of its relatively small thickness.

In the present embodiment, the step 1 preferably includes an obtainment of the circuit board B with reduced moisture content contained in the circuit board A. This is because the moisture contained in the circuit board A is more likely to have an influence.

Examples of a method for obtaining the circuit board B with reduced content of moisture and/or a solvent contained in the circuit board A include heating under atmospheric pressure, drying under reduced pressure or vacuum, heating under reduced pressure or vacuum, and drying using a desiccant. In the present embodiment, examples that may be mentioned include heating under atmospheric pressure.

In the step 1, the temperature for heating and drying the circuit board A is preferably 30°C or higher, more preferably 50°C or higher, still more preferably 80°C or higher, further more preferably 90°C or higher, even more preferably 100°C or higher, yet still more preferably 110°C or higher, and especially more preferably 120°C or higher. When the temperature is adjusted to be higher than or equal to the lower limit value, the contents of moisture and/or of a solvent contained in the circuit board A tend to be enabled to be more effectively reduced. The temperature for heating and drying the circuit board A under atmospheric pressure is preferably 200°C or lower, more preferably 185°C or lower, still more preferably 170°C or lower, and even more preferably 155°C or lower. When the temperature is adjusted to be lower than or equal to the upper limit value, deteriorations of conductor circuits tend to be enabled to be effectively suppressed.

The temperature during heating or drying in the step 1 may be a constant temperature, or the temperature may be raised and/or lowered during the course of the step. When the temperature is raised and/or lowered during heating or drying in the step 1, the average value of the temperatures is preferably included in the range set forth above.

In the step 1, the temperature and pressure during heating or drying are preferably substantially constant except for the initial stage (e.g., at the start of heating or drying,) and the final stage (e.g., at the end of heating or drying,) in the step 1. The wording "substantially constant" means that the fluctuation ranges of the temperature and/or the pressure other than the initial stage and the final stage are each within ±10%.

The heating or drying temperature in the step 1 is preferably equal to or lower than the heating temperature in the step 2. Specifically, the heating or drying temperature is preferably lower by 5 to 40°C compared to the heating temperature in the step 2. However, when the step 1 is conducted in a situation where the surface of the conductor circuit layer is less likely to be oxidized under a nitrogen atmosphere or the like, the heating or drying in the step 1 can be conducted at a temperature higher than the heating temperature in the step 2.

The drying time during heating or drying under atmospheric pressure is preferably 30 minutes or more, more preferably 60 minutes or more, further preferably 120 minutes or more, still more preferably 180 minutes or more, and even more preferably 240 minutes or more. When the drying time is adjusted to be longer than or equal to the lower limit value, the effect of reducing the contents of moisture and/or of a solvent contained in the circuit board A tends to be further enhanced. The drying time in the case of drying under atmospheric pressure is preferably 600 minutes or less, more preferably 540 minutes or less, further preferably 480 minutes or less, still more preferably 420 minutes or less, and further more preferably 360 minutes or less. When the drying time adjusted to be less than or equal to the upper limit value, deteriorations of conductor circuits tend to be enabled to be effectively suppressed.

When step 1 is conducted under reduced pressure or vacuum, the drying time can be shortened.

In the present embodiment, it is preferable to further make the circuit board B obtained in the step 1 less likely to absorb moisture.

When the circuit board B obtained in the step 1 is made less likely to absorb moisture, the effect of the present embodiment is more effectively exhibited.

Examples of making the circuit board B obtained in the step 1 less likely to absorb moisture include an implementation of the step 2 immediately after the step 1. That is, the circuit board B may absorb moisture when the circuit board B is obtained and then stored, but when the step 2 is conducted immediately after the circuit board B is obtained, the metal foil-clad laminate can be produced before the circuit board absorbs moisture again, and delamination of the metal foil can be effectively suppressed.

Here, the wording "immediately after" includes a case where the circuit board B is obtained in the step 1 and then continuously moved onto the step 2 without storing the circuit board B. More specifically, for example, the circuit board is obtained in the step 1 and then moved on to the step 2 within, for example, 2 hours, moreover within 90 minutes, particularly within 10 minutes.

Another example of making the circuit board B obtained in the step 1 less likely to absorb moisture includes a storage of the circuit board B obtained in the step 1 in an atmosphere where moisture absorption is less likely to occur prior to conducting the step 2. This is advantageous in a case where the circuit board B is obtained but cannot be immediately moved onto the step 2. Examples of the method for storing the circuit board B in an atmosphere where moisture absorption is less likely to occur include a storage in an atmosphere with desiccant.

### <Step 2>

Step 2 includes a step in which a resin composite sheet C including a metal foil and a resin composition layer disposed on one side of the metal foil is disposed on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B ((2) of FIG. 1). In the present embodiment, the step 2 is conducted with the vacuum laminator and therefore the laminated substrate D can be effectively obtained in a short time. The resin composite sheet C may be disposed on only one side of the circuit board B but is preferably disposed on both sides of the circuit board B.

The step 2 includes, for example, a step also called cold isostatic press (CIP) or rubber press.

In the step 2, the circuit board B and the resin composite sheet C are placed in a vacuum laminator, and then heated and pressed in an environment of reduced pressure or vacuum.

In the step 2, the lamination of the circuit board B and the resin composite sheet C is conducted under reduced pressure or vacuum (e.g., at 5.0 hPa or lower, moreover at 1.0 hPa or lower, or may be under vacuum).

The heating temperature in the step 2 is preferably 80°C or higher, more preferably 90°C or higher, further preferably 100°C or higher, still more preferably 110°C or higher, and even more preferably 120°C or higher. When the heating temperature is adjusted to be higher than or equal to the lower limit value, the embeddability of the resin composition between conductor circuits can be further improved. The heating temperature in the step 2 is preferably 190°C or lower, more preferably 180°C or lower, further preferably 170°C or lower, still more preferably 160°C or lower, and even more preferably 150°C or lower. When the heating temperature is adjusted to be lower than or equal to the upper limit value, the effect of suppressing excessive flow of the resin composition tends to be further improved. Furthermore, it is also possible to effectively suppress a decrease in the thickness of the resin composition layer due to outflow of the resin composition from the edge of the laminate due to decreased melt viscosity of the resin composition.

The heating temperature in the step 2 may be a constant temperature, or the temperature may be raised and/or lowered during the course of the step. When the temperature is raised and/or lowered during the heating in the step 2, the average value of the temperatures is preferably included in the range set forth above.

In the step 2, pressure is applied from the surface on the metal foil side. The pressure at this time is preferably 3 kgf/cm² or higher, more preferably 7 kgf/cm² or higher, still more preferably 9 kgf/cm² or higher, and may be 10 kgf/cm² or higher. When the pressure is adjusted to be higher than or equal to the lower limit value, the embeddability of the resin composition into a circuit tends to be further improved. The pressure is preferably 30 kgf/cm² or lower, more preferably 25 kgf/cm² or lower, still more preferably 20 kgf/cm² or lower, and may be 15 kgf/cm² or higher. When the pressure is adjusted to be lower than or equal to the upper limit value, excessive flow of the resin composition tends to be enabled to be effectively suppressed.

The amount of time for heating and pressure application in the step 2 is preferably 5 seconds or more, more preferably 10 seconds or more, further more preferably 15 seconds or more, still more preferably 20 seconds or more, and even more preferably 25 seconds or more. When the amount of the time is adjusted to be greater than or equal to the lower limit value, the embeddability of the resin composition into a circuit tends to improve. The amount of time for heating and pressure application in the step 2 is preferably 10 minutes or less, more preferably 7 minutes or less, further more preferably 5 minutes or less, still more preferably 3 minutes or less, and even more preferably 60 seconds or less. When the amount of time is adjusted to be less than or equal to the upper limit value, excessive flow of the resin composition tends to be enabled to be more effectively suppressed.

The pressure application in the step 2 may be a pressure application at a constant pressure, or the pressure may be varied during the course of the step. When the pressure is varied in the step 2, the average value of the pressures is preferably included in the range set forth above.

In the step 2, the temperature during heating and the pressure during pressure application are preferably substantially constant except at the initial stage (e.g., at the start of rubber press) and at the final stage (e.g., at the end of rubber press) of the step 2. The wording "substantially constant" means that the fluctuation ranges of the temperature and the pressure other than the initial stage and the final stage are each within ±10%.

### <Step 3>

Step 3 includes a step of heating and applying pressure from the surface on the metal foil side of the laminated substrate D obtained in the step 2 by using a pressing metal plate or a laminating metal roll to smooth the surface of the resin composition layer of the laminated substrate D to obtain a laminated substrate E ((3) of FIG. 1).

In the step 3, mainly, the resin composition of the resin composition layer is semi-cured while sufficiently entering into the circuit board B, and the surface of the resin composition layer is smoothed.

The step 3 includes a step called flat pressing, for example.

In the step 3, the laminated substrate D may be heated and pressed with a protective film having a smooth surface and an area larger than that of the resin composite sheet C being further interposed between the laminated substrate D and a pressing metal plate or a laminating metal roll. With such a configuration, the contamination of equipment can be effectively suppressed. In particular, using of a protective film tends to enable to appropriately transport the circuit board, and to effectively suppress the contamination of the pressing metal plate or the metal roll.

The step 3 may be conducted under atmospheric pressure, or may be conducted under reduced pressure or vacuum. In one embodiment, the step 3 is to be conducted under atmospheric pressure. When the step 3 is conducted under reduced pressure or vacuum, for example, the step 3 may be conducted at 5.0 Pa or lower, further at 1.0 Pa or lower, or under vacuum.

The heating temperature in the step 3 is preferably 80°C or higher, more preferably 90°C or higher, further more preferably 100°C or higher, still more preferably 110°C or higher, even more preferably 120°C or higher, and may be 130°C or higher or 140°C or higher. When the heating temperature is adjusted to be higher than or equal to the lower limit value, the surface of the resin composition layer tends to be further smoothed. The heating temperature in the step 3 is preferably 190°C or lower, more preferably 180°C or lower, further more preferably 170°C or lower, still more preferably 160°C or lower, even more preferably 155°C or lower, and may be 150°C or lower. When the heating temperature is adjusted to be lower than or equal to the upper limit value, an excessive flow of the resin composition tends to be effectively suppressed.

The heating temperature in the step 3 may be a constant temperature, or the temperature may be raised and/or lowered during the course of the step. When the temperature is raised and/or lowered during the heating in the step 3, the average value of the temperatures is preferably included in the range set forth above.

The pressure during pressure application in the step 3 is preferably 3 kgf/cm² or higher, more preferably 7 kgf/cm² or higher, further more preferably 9 kgf/cm² or higher, and may be 10 kgf/cm² or higher. When the pressure is adjusted to be higher than or equal to the lower limit value, the surface of the resin composition layer tends to be effectively smoothed. The pressure during pressure application in the step 3 is preferably 30 kgf/cm² or lower, more preferably 25 kgf/cm² or lower, further more preferably 20 kgf/cm² or lower, and may be 15 kgf/cm² or higher. When the pressure is adjusted to be lower than or equal to the upper limit value, excessive flow of the resin composition tends to be effectively suppressed.

The pressure application in the step 3 may be a pressure application at a constant pressure, or the pressure may be varied during the course of the step. When the pressure is varied in the step 3, the average value of the pressures is preferably included in the range set forth above.

In the step 3, the temperature during heating and the pressure during pressure application are each preferably substantially constant except for the initial stage (e.g., at the start of flat pressing) and the final stage (e.g., at the end of flat pressing,) of the step 3. The wording "substantially constant" means that the fluctuation ranges of the temperature and the pressure other than the initial stage and the final stage are each within ±10%.

The amount of time for heating and pressure application in the step 3 is preferably 5 seconds or more, more preferably 10 seconds or more, further more preferably 15 seconds or more, still more preferably 20 seconds or more, even more preferably 25 seconds or more, and moreover may be 35 seconds or more, 45 seconds or more, or 50 seconds or more. When the amount of the time is adjusted to be greater than or equal to the lower limit value, the surface of the resin composition layer tends to be more effectively smoothed. The amount of time for heating and pressure application in the step 3 is preferably 10 minutes or less, more preferably 5 minutes or less, and still more preferably 3 minutes or less. When the time is adjusted to be less than or equal to the upper limit value, an excessive flow of the resin composition tends to be enabled to be effectively suppressed.

The heating in the step 3 may be constant heating, or the temperature may be varied during the course of the step. When the temperature is varied in the step 3, the average value of the temperatures is preferably included in the range set forth above.

### <Step 4>

The method for producing a metal foil-clad laminate of the present embodiment preferably further includes the following step after the step 3 in addition to the steps 1 to 3.

Step 4: a step of heating the laminated substrate E obtained in the step 3 to cure the resin composition layer to obtain a cured board F.

The step 4 is, for example, a step illustrated by (4) in FIG. 1.

Through the step 4, the resin composition layer in the semi-cured state can be adequately cured.

The step 4 includes a step called post-baking, for example.

In the step 4, a dryer or the like is usually used for heating.

The heating temperature in the step 4 is preferably 100°C or higher, more preferably 110°C or higher, further more preferably 120°C or higher, still more preferably 130°C or higher, and even more preferably 140°C or higher. When the heating temperature is adjusted to be higher than or equal to the lower limit value, the resin composition layer can be more adequately cured. The heating temperature in the step 4 is preferably 250°C or lower, more preferably 240°C or lower, further more preferably 230°C or lower, still more preferably 225°C or lower, and even more preferably 220°C or lower. When the heating temperature is adjusted to be lower than or equal to the upper limit value, thermal damage to the circuit board tends to be enabled to be suppressed.

The heating temperature in the step 4 may be a constant temperature, or may be raised and/or lowered during the course of the step. When the temperature is raised and/or lowered during the heating in the step 4, the average value of the temperatures is preferably included in the range set forth above.

The heating time in the step 4 is preferably 15 minutes or longer, more preferably 30 minutes or longer, further more preferably 60 minutes or longer, still more preferably 90 minutes or longer, and even more preferably 100 minutes or longer. When the heating time is adjusted to be longer than or equal to the lower limit value, the resin composition layer can be more adequately cured. The amount of time for heating and pressure application in the step 4 is preferably 10 hours or less, more preferably 7 hours or less, and still more preferably 5 hours or less. When the amount of the time is adjusted to be less than or equal to the upper limit value, thermal damage to the circuit board can be further suppressed.

The heating in the step 4 may be constant heating, or heating may be varied during the course of the step. When the temperature is varied in the step 4, the average value of the temperatures is preferably within the range set forth above.

In the heating of the step 4, preferably the temperature is raised in stages (in particular, in two or three stages, preferably in two stages). With such a configuration, the moisture and/or the solvent in the circuit board B which cannot be removed by the first heating in the step 1 can be sufficiently vaporized, and the moisture absorbed in the step 2 and the subsequent steps and the moisture and/or the solvent contained in the resin composition layer and the like can be effectively removed as well. Subsequently, the second heating can sufficiently cure the resin composition layer. As a result, blister of the metal foil can be more effectively suppressed, and delamination between the resin composition layer and the metal foil can be more effectively suppressed. In particular, it is possible to more effectively suppress the rapid vaporization of remaining trace amount of moisture and solvent and the resulting blister. The blister at the interface between the circuit board and the resin composition layer and delamination associated therewith can also be effectively suppressed.

For example, in cases where the resin composition layer contains a large amount of inorganic filler, or in cases where the resin composition layer contains a large amount of moisture, heating in stages can effectively suppress the blister of metal foil.

When the heating in the step 4 is conducted by raising temperature in stages, the temperature of the first heating is preferably 100°C or higher, more preferably 110°C or higher, further more preferably 120°C or higher, still more preferably 130°C or higher, even more preferably 140°C or higher, and may be 145°C or higher. When the temperature of the first heating is adjusted to be higher than or equal to the lower limit value, the moisture and/or the solvent in the laminated substrate E tends to be enabled to be easily removed gradually. The temperature of the first heating is preferably 180°C or lower, more preferably 170°C or lower, further more preferably 160°C or lower, and still more preferably 155°C or lower. When the temperature of the first heating is adjusted to be lower than or equal to the upper limit value, the moisture and/or the solvent in the laminated substrate E tends to be enabled to be easily removed gradually.

The amount of time for the first heating is preferably 10 minutes or longer, more preferably 20 minutes or longer, further more preferably 30 minutes or longer, still more preferably 40 minutes or longer, and even more preferably 50 minutes or longer. The amount of time for the first heating is preferably 5 hours or shorter, more preferably 4 hours or shorter, and still more preferably 2 hours or shorter. When the amount of the time is adjusted to be less than or equal to the upper limit value, thermal damage to the circuit board tends to be enabled to be effectively suppressed.

When the heating in the step 4 is conducted by raising temperature in stages, the temperature for the second heating is preferably higher than 180°C, more preferably 190°C or higher, further more preferably 200°C or higher, still more preferably 210°C or higher, and even more preferably 215°C or higher. When the temperature for the second heating is adjusted to be higher than or equal to the lower limit value, the resin composition layer can be more adequately cured. The temperature for the second heating is preferably 250°C or lower, more preferably 240°C or lower, still more preferably 230°C or lower, and even more preferably 225°C or lower. When the temperature for the second heating is adjusted to be lower than or equal to the upper limit value, thermal damage to the circuit board tends to be enabled to be effectively suppressed.

The amount of time for the first heating is preferably 20 minutes or longer, more preferably 40 minutes or longer, further more preferably 60 minutes or longer, still more preferably 80 minutes or longer, and even more preferably 100 minutes or longer. The amount of time for the first heating is preferably 7 hours or shorter, more preferably 5 hours or shorter, and further more preferably 3 hours or shorter. When the first heating time is adjusted to be shorter than or equal to the upper limit value, thermal damage to the circuit board tends to be enabled to be effectively suppressed.

In the step 4, when heating is conducted in stages, the temperature for the second heating is preferably higher than the temperature of the first heating, and more preferably at least 10°C higher than the temperature of the first heating. When the difference in temperature between the first heating and the second heating (the temperature for the second heating - the temperature of the first heating) is 10°C or more, the resin composition layer can be more sufficiently cured. The difference in temperature between the first heating and the second heating is more preferably 20°C or more, further more preferably 35°C or more, still more preferably 50°C or more, and even more preferably 60°C or more. The upper limit value of the difference in temperature between the first heating and the second heating is preferably 110°C or less, more preferably 100°C or less, further more preferably 90°C or less, still more preferably 80°C or less, and even more preferably 75°C or less. When the difference in temperature is adjusted to be less than or equal to the upper limit value, thermal damage to the circuit board tends to be enabled to be effectively suppressed.

Note that, in the present embodiment, the first heating and the second heating need not be the first heating in the step 4 and the subsequent heating. For example, the present embodiment also includes a case where preheating is further conducted before the first heating, a case where, in between the first heating and the second heating, heating is conducted while increasing the temperature, and a case where post-heating is further conducted after the second heating.

The step 4 is typically conducted under atmospheric pressure.

**In** the present embodiment, the mass reduction ratio of the laminated substrate E by the heating in the step 4 is preferably 1.0 mass% or less. For reducing the amount of gas generated from the laminated substrate E in this way, examples thereof include a method of reducing the contents of moisture and/or of a solvent contained in the circuit board A, and a method in which the circuit board B made to be less likely to absorb moisture is placed in a vacuum laminator.

The mass reduction ratio is more preferably 0.5 mass% or less, still more preferably 0.1 mass% or less based on the mass of the laminated substrate E before heating. With the mass reduction ratio being less than or equal to the upper limit value, delamination in the step 4 tends to be enabled to be effectively suppressed. The lower limit value of the mass reduction ratio is ideally 0 mass%, but an adequate performance is exhibited even when the mass reduction ratio is 0.01 mass% or more based on the mass of the laminated substrate E.

The mass reduction ratio of the laminated substrate E by the heating in the step 4 is defined by [(Mass of the laminated substrate E before heating - Mass of the laminated substrate E after heating) / Mass of the laminated substrate E before heating] × 100 (unit: mass%).

The mass reduction ratio is calculated by measuring the mass before and after heating with an electronic balance.

### <Other steps>

The method for producing a metal foil-clad laminate of the present embodiment may further include a repetition of the steps 2 to 4 for the cured board F. The repetition of the steps 2 to 4 provides a printed wiring board having a multilayer structure. When the resin composite sheet C includes a carrier substrate to be detailed later, the carrier substrate is preferably peeled off ((5) in FIG. 1) prior to the repetition of the steps 2 to 4. The number of the repetitions of the steps 2 to 4 can be determined according to the desired number of conductor circuit layers, and is typically from 2 to 10, for example. Processes such as formation of a photoresist layer, etching, and copper plating for the cured board F may be combined to form a conductor circuit layer, and a known process (e.g., a semi-additive process or the like) can be used for the formation of the conductor circuit layer.

### <Metal foil-clad laminate>

**In** the metal foil-clad laminate obtained by the method of the present embodiment, a resin composite sheet C including a metal foil and a resin composition layer disposed on one side of the metal foil is laminated on a surface of a circuit board A including an insulating layer and a conductor circuit layer.

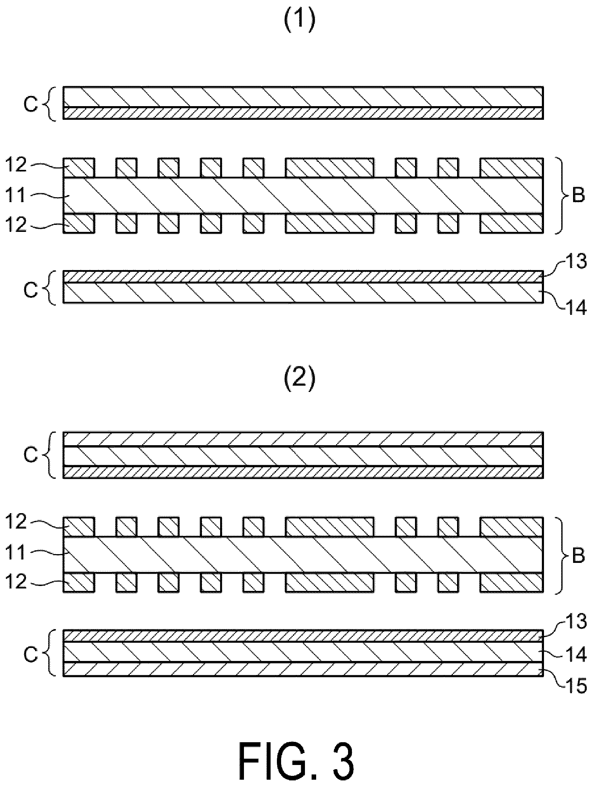

Hereinafter, the metal foil-clad laminate will be described with reference to FIG. 3. FIG. 3 is a schematic cross-sectional view illustrating a layer configuration of the metal foil-clad laminate in the present embodiment, and resin composite sheets C and C are provided on both surfaces of a circuit board B. The circuit board B is provided with an insulating layer 11 and conductor circuit layers 12 and 12 provided on both surfaces of the insulating layer 11. The insulating layer 11 is formed of an insulating material, and is usually of an organic material containing a resin (preferably a thermosetting resin), and a thermosetting resin is preferably makes up 80 mass% or more of the insulating layer 11. Because the insulating layer 11 is formed of an organic material, a solvent that has been used when forming the insulating layer or when forming the conductor circuit layer may still remain in the insulating layer, or the insulating layer tends to absorb moisture. The organic material is not particularly limited, and usually, a composition to be used for forming an insulating layer of a printed wiring board can be suitably used.

The thickness of the insulating layer 11 is, for example, 30 µm or more and 1000 µm or less.

On the other hand, conductor circuit layer 12 is made of a conductive metal, and an example thereof is copper. The thickness of the conductor circuit layer 12 (the average thickness of the portion where the conductor circuit is provided) is, for example, 1 µm or more and 100 µm or less.

The surface roughness (specifically, surface roughness of a surface in contact with the conductor circuit layer) of the insulating layer (insulating layer 11 in FIG. 3) is not particularly limited, but the surface roughness Rz of the insulating layer is preferably adjusted to 0.2 to 7.0 µm as measured in accordance with JIS B0601:2013. When the surface roughness Rz of the insulating layer is adjusted to at least 0.2 µm, the surface roughness of the insulating layer has a suitable value, and the adhesive strength between the conductor circuit layer and the insulating layer tends to be further improved. In contrast, when the surface roughness Rz of the insulating layer is adjusted to 7.0 µm or less, the roughness of the conductor circuit layer to be formed on the insulating layer has a suitable value, and the transmission characteristics of the conductor circuit tend to be further improved. The surface roughness Rz of the insulating layer is appropriately selected in terms of balancing the transmission characteristics of the conductor circuit with the adhesive strength between the conductor circuit layer and the insulating layer, and thus is not particularly limited, but is more preferably 0.5 µm or more, still more preferably 0.6 µm or more, and particularly preferably 0.7 µm or more, and may be 4.5 µm or more depending on the intended use or the like, and is more preferably 5.5 µm or less, further more preferably 4.0 µm or less, still more preferably 3.5 µm or less, even more preferably 3.0 µm or less, and yet still more preferably 2.0 µm or less.

On the surface of the circuit board B is provided a resin composite sheet C including a metal foil and a resin composition layer disposed on one side of the metal foil. The resin composite sheet C illustrated in FIG. 3 includes a resin composition layer 13, a metal foil 14, and a carrier substrate 15 in this order from the side closest to the circuit board B. Details of the resin composite sheet are preferably the matters described in the section of <Resin composite sheet C> described later.

The total thickness of the metal foil-clad laminate (after step 4) obtained in the present embodiment is preferably 50 µm or more, more preferably 80 µm or more, further more preferably 100 µm or more, still more preferably 120 µm or more, and even more preferably 160 µm or more. When the total thickness is adjusted to be greater than or equal to the lower limit value, handleability tends to improve. Moreover. The layer thickness of the metal foil-clad laminate (after step 4) is preferably 2000 µm or less, more preferably 1800 µm or less, further more preferably 1600 µm or less, still more preferably 1400 µm or less, and even more preferably 1200 µm or less. When the layer thickness is adjusted to be less than or equal to the upper limit value, the amount of residual moisture and solvent in the circuit board tends to be enabled to be effectively reduced.

The total thickness (excluding the carrier substrate) of the metal foil-clad laminate (after the step 4, when the conductor circuit layer is a single layer) obtained in the present embodiment is preferably 50 µm or more, more preferably 80 µm or more, further more preferably 100 µm or more, still more preferably 120 µm or more, and even more preferably 140 µm or more. When the total thickness is adjusted to be greater than or equal to the lower limit value, handleability tends to improve. The total thickness (excluding the carrier substrate) of the metal foil-clad laminate (after the step 4, when the conductor circuit layer is a single layer) is preferably 2000 µm or less, more preferably 1800 µm or less, further more preferably 1600 µm or less, still more preferably 1400 µm or less, and even more preferably 1200 µm or less. When the total thickness is adjusted to be less than or equal to the upper limit value, the amount of residual moisture and solvent in the circuit board tends to be enabled to be effectively reduced.

### <Resin composite sheet C>

In the present embodiment, the resin composite sheet C may include only the metal foil and the resin composition layer disposed on one side of the metal foil, but may have another layer. Specifically, the resin composite sheet C may include only the resin composition layer 13 and the metal foil 14 as illustrated in FIG. 3(1), or may include a carrier substrate 15 as well as the resin composition layer 13 and the metal foil 14 as illustrated in FIG. 3(2). In the present embodiment, when the resin composite sheet C includes the carrier substrate 15, the handleability tends to improve. The resin composite sheet C may further include another layer (such as an adhesive layer, a roughening treatment layer, a heat-resistant treatment layer, a rustproofing treatment layer, and a silane coupling agent layer) in between the metal foil 14 and the carrier substrate 15. In the present embodiment, the resin composite sheet C preferably includes a carrier substrate 15 as well as the resin composition layer 13 and the metal foil 14.

That is, a preferred example of the present embodiment is a configuration in which the resin composite sheet C includes a carrier substrate, a metal foil, and a resin composition layer in this order.

The metal foil (metal foil 14 in FIG. 3) may be a single-layer metal foil or a multilayer metal foil, but is typically a single-layer metal foil. A thinner metal foil is desirable. The thickness of the metal foil is, for example, 0.5 µm or more and 40 µm or less. When the thickness is adjusted to be greater than or equal to the lower limit value, handleability tends to improve. When the thickness is adjusted to be less than or equal to the upper limit value, etching property tends to be further improved.

In particular, when the resin composite sheet C includes a carrier substrate, the thickness of the metal foil is preferably 0.8 µm or more, more preferably 1.0 µm or more, and still more preferably 1.2 µm or more, and is preferably 3 µm or less, more preferably 2.5 µm or less, still more preferably 2.0 µm or less, and may be 1.8 µm or less. When the thickness is adjusted to be greater than or equal to the lower limit value, handleability tends to improve. When the thickness is adjusted to be less than or equal to the upper limit value, etching property tends to be further improved.

On the other hand, when the resin composite sheet C does not include a carrier substrate, the thickness of the metal foil is preferably 7 µm or more, more preferably 9 µm or more, and is preferably 40 µm or less, more preferably 36 µm or less. In particular, when the resin composite sheet C does not include a carrier substrate, when the metal foil has a thickness of 7 µm or more, production management at a metal foil manufacturer tends to be facilitated, and handleability during further processing the metal foil-clad laminate can be improved.

The surface roughness (specifically, the surface roughness of the surface in contact with the resin composition layer) of the metal foil is not particularly limited, but surface roughness Rz of the metal foil is preferably adjusted to 0.2 to 7.0 µm as measured in accordance with JIS B0601:2013. With the surface roughness Rz of the metal foil being 0.2 µm or greater, the surface roughness of the metal foil has a suitable value, and the peel strength of metal foil tends to be further improved. On the other hand, with the surface roughness Rz of the metal foil being 7.0 µm or less, the surface roughness of the metal foil has a suitable value, and the dielectric dissipation factor characteristic of a resultant cured product tends to be further improved. The roughness Rz of the surface of the copper foil is appropriately selected in terms of the balance between the peel strength of metal foil and the dielectric dissipation factor characteristic and hence is not particularly limited, but is more preferably 0.5 µm or more, still more preferably 0.6 µm or more, and particularly preferably 0.7 µm or more, and may be 4.5 µm or more depending on the purpose or the like, and is more preferably 5.5 µm or less, further more preferably 4.0 µm or less, still more preferably 3.5 µm or less, even more preferably 3.0 µm or less, and yet still more preferably 2.0 µm or less.

The metal foil is not particularly limited as long as it is a base material containing metal that can be used as a wiring (a conductor circuit) of a printed wiring board (hereinafter, also referred to as a wiring board). The metal foil is preferably a copper foil in terms of an enhancement of signal transmission rate or the like, for example. Any foil that contains copper can be used as the copper foil, and examples thereof include a foil-shaped base material made of copper or of a copper alloy. Examples of the copper alloy include an alloy containing copper and at least one selected from the group consisting of nickel, phosphorus, tungsten, arsenic, molybdenum, chromium, cobalt, and zinc.

The copper foil is not particularly limited, but preferably has a large crystal grain size of copper or of an alloy containing copper in terms of increasing the signal transmission rate and reducing the transmission loss. Specifically, the copper foil preferably contains crystal grains of copper or of an alloy containing copper having a maximum grain size of at least 5 µm, and more preferably contains crystal grains having a maximum grain size of at least 10 µm. The crystal grains having a maximum grain size of at least 5 µm preferably accounts for 20% or more in the area, and more preferably 40% or more in the area. Note that, the maximum grain size as used herein refers to the longest diameter (major axis diameter) in each crystal grain of copper or of an alloy containing copper.

As a method for measuring the crystal grain size of the copper foil, reference can be made to the description in paragraph [0155] of WO 2021/079817 A, and the contents thereof are incorporated herein.

As described above, the metal foil is preferably a copper foil, and it has been traditionally common that an electrolytic copper foil is used as a copper foil for a rigid substrate or the like, and a rolled copper foil is used as a copper foil for a flexible substrate or the like, however, in recent years, particularly with the rise of the flexible substrate market, an electrolytic copper foil having characteristics comparable to those of a rolled copper foil has been developed, and these days a rolled copper foil and an electrolytic copper foil are equally used in both types of the substrates. Therefore, the copper foil to be used in the present embodiment is not limited to a rolled copper foil or an electrolytic copper foil, and any copper foil may be used for the copper foil to be used in the present embodiment.

The metal foil may be subjected to various treatments for a foil-shaped base material (metal foil base material) containing metal that can be used as a wiring of wiring boards. Such a treatment is not particularly limited as long as it is a treatment applied to a metal foil, and examples thereof include a roughening treatment, a heat-resistant treatment, a rustproofing treatment, and a silane coupling agent treatment. The metal foil 14 may be subjected to any one of the treatments, or may be subjected to a combination of two or more types of the treatments. When conducting two or more types of the treatments, these treatments are preferably conducted in the order of the roughening treatment, the heat-resistant treatment, the rustproofing treatment, and the silane coupling agent treatment.

That is, in the present embodiment, an example of the embodiment of the resin composite sheet C further includes a roughening treatment layer, a heat-resistant treatment layer, a rustproofing treatment layer, and a silane coupling agent treatment layer, as well as the metal foil and the resin composition layer.

The roughening treatment may be a roughening treatment commonly conducted when producing metal foils, and examples thereof include, but are not particularly limited to, a treatment in which roughening particles are formed on the surface of a treatment object such as the metal foil base material. When the metal foil is a copper foil, by this roughening treatment, the surface of the copper foil is covered with roughening particles containing copper or a copper alloy.

One example of the roughening treatment layer includes a layer made up of fine metal particles having a particle diameter of from 40 to 200 nm. More specifically, copper particles having a particle diameter of from 40 to 200 nm preferably account for 90% or greater, and more preferably 95% or greater of fine metal particles contained in the roughening treatment layer. Note that, the particle diameter as used herein refers to a value of particle diameter as a height of a metal particle observed at 80000-fold magnification on a sample stage at an inclined angle of 40° with a field emission scanning electron microscope FE-SEM (JSM-7800F available from JEOL Ltd.). The particle diameter of the fine copper particles in the roughening treatment layer preferably has a maximum value of 200 nm and a minimum value of 40 nm in the area observed and measured by the above-mentioned method.

The roughening treatment layer may be formed by an electrolytic plating process. The particle diameter of the fine copper particles is strongly influenced by the electrolytic current density as well as the bath composition for plating treatment. For example, the roughening particles tend to have small particle diameters when the electrolytic current density is high, and in contrast, the roughening particles tend to have large particle diameters when the electrolytic current density is low. Therefore, an appropriate setting of the electrolytic current density is preferable in order to obtain roughening particles having an intended particle diameter.

Regarding the bath composition and the electrolysis conditions for forming the roughening treatment layer of copper, reference can be made to the description of paragraphs [0106] to [0108] of WO 2020/162056, the contents thereof are incorporated herein.

The heat-resistant treatment may be a heat-resistant treatment commonly conducted when producing metal foils, and is not particularly limited, and examples thereof include a treatment of forming a heat-resistant treatment layer containing a simple substance or an alloy of nickel, cobalt, copper, and zinc. Even if a region formed by this heat-resistant treatment is not formed into a complete layer, this layer is referred to as a heat-resistant treatment layer. The metal foil may include a layer (heat-resistant treatment layer) formed by the heat-resistant treatment.

More specifically, the heat-resistant treatment layer preferably contains nickel or nickel and phosphorus, and the nickel deposit amount in the heat-resistant treatment layer is preferably from 30 to 60 mg/m².

When the nickel deposit amount is from 30 to 60 mg/m², the transmission characteristics and the basic characteristics can be more effectively improved. The more preferable range of the nickel deposit amount is from 40 to 50 mg/m². As used herein, the term "deposit amount" refers to a mass per unit area of the metal foil on the roughening treatment layer side where nickel is deposited by plating (such as, electrolytic plating process). The deposit amount can be measured by, for example, a method in which the copper foil to be treated is dissolved with nitric acid or the like and diluted, and nickel concentration is analyzed with an ICP optical emission spectrometer.

The heat-resistant treatment layer is preferably composed of nickel (Ni), or of nickel (Ni) and phosphorus (P).

More specifically, the heat-resistant treatment layer is a second surface treatment layer to be formed after the formation of the roughening treatment layer, and can be formed by an electrolytic plating process. The nickel deposit amount can be adjusted by a current condition when this electrolytic plating is conducted.

Regarding examples of the bath composition and the electrolysis conditions for creating the heat-resistant treatment layer including nickel and phosphorus, reference can be made to the description of paragraphs [0115] to [0116] of WO 2020/162056, and the contents thereof are incorporated herein.

The rustproofing treatment may be a rustproofing treatment commonly conducted when producing metal foils, and is not particularly limited, but is preferably a treatment of forming a rustproofing treatment layer containing nickel. Examples of the rustproofing treatment include chromate conversion coating. Even if a region formed by this rustproofing treatment is not formed into a completely layer, this region is referred to as a rustproofing treatment layer. The metal foil 14 may include a layer formed by rustproofing treatment (rustproofing treatment layer).

More specifically, the rustproofing treatment layer is usually a third surface treatment layer formed after formation of the heat-resistant treatment layer, and can be formed by an electrolytic plating process. Any known bath composition for forming rustproofing treatment layer may be used, and examples thereof include bath compositions including hexavalent chromium such as chromic acid, sodium dichromate, and potassium dichromate. Note that, the deposit form of chromium after formation of the rustproofing treatment layer is a mixed state of Cr(OH)₃ and Cr₂0₃, and no deposit of hexavalent chromium having a negative effect on the human body, and chromium is deposited in the form of trivalent chromium. Alkaline and acidic chromic acid solution are both acceptable.

As the alkaline chromic acid solution, an alkaline zinc chromate solution containing a zinc ion and a hexavalent chromium ion described in JP S58-15950 B2 may be used, and using this chromic acid solution can improve rust prevention property of the rustproofing treatment as compared with the rustproofing treatment layer created from a chromic acid solution only containing chromium.

Regarding the electrolytic bath and the electrolytic conditions for applying rustproofing treatment layer, for example, reference can be made to the description in paragraph [0122] of WO 2020/162056, and the contents thereof are incorporated herein.

The silane coupling agent treatment may be a rustproofing treatment commonly conducted when producing metal foils, and is not particularly limited, and examples thereof include a treatment of applying a silane coupling agent to a surface of a treatment object such as metal foil base material. As the silane coupling agent treatment, heating or drying may be conducted after the application of silane coupling agent. The treatment with the silane coupling agent allows an alkoxy group included in the silane coupling agent to react with and bond to a metal included in the treatment object. A region formed by this bonded silane coupling agent is a silane coupling agent treatment layer. The metal foil 14 may include a layer formed by a silane coupling agent treatment (a silane coupling agent treatment layer).

More specifically, the silane coupling agent treatment layer is usually a fourth surface treatment layer formed after the formation of rustproofing treatment layer, and is a layer provided for further improving adhesion between the resin composition layer and the metal foil. When the silane coupling agent treatment layer is further provided, not only the peel strength can be improved, but also deterioration of the peel strength after a severe test can be suppressed, moreover rust prevention property is improved, and a metal foil for a circuit board having excellent versatility is obtained.

The silane coupling agent treatment layer can be formed by a step in which an appropriate amount of a silane coupling agent is added into water or the like to make an aqueous solution, and then the silane coupling agent as the aqueous solution is applied by immersing process, by spraying process, or by another process, followed by washing with water and drying. The silane coupling agent to be used can be selected from a wide variety of silane coupling agents such as an epoxy group, an amino group, a mercapto group, a vinyl group, a methacryloxy group, and a styryl group. However, the silane coupling agents are required to be appropriately selected and used because they have different properties and compatibilities with the base material.

Preferred examples of the silane coupling agent include a silane coupling agent having an amino group in the molecule, and a silane coupling agent having an unsaturated carbon-carbon double bond in the molecule. For details of the silane coupling agent having an amino group in the molecule and the silane coupling agent having an unsaturated carbon-carbon double bond in the molecule, reference may be made to the description in paragraphs [0165] to [0168] of WO 2021 079817, and the contents thereof are incorporated herein.

Regarding the bath for forming the silane coupling agent treatment layer, for example, the composition and conditions as described below, reference may be made to the description of paragraph [0125] of WO 2020/162056, and the contents thereof are incorporated herein.

The resin composite sheet C including such a metal foil, a roughening treatment layer, a heat-resistant treatment layer, a rustproofing treatment layer, a silane coupling agent treatment layer, and a resin composition layer can be produced, for example, in view of the description of paragraphs [0126] and [0127] of WO 2020-162056, the contents of which are incorporated herein.

As one embodiment of the resin composite sheet C in the present embodiment, examples include a resin composite sheet C in which a surface (contact surface) of the metal foil (preferably copper foil) on the side in contact with the resin composition layer has a first nickel element content of 4.5 atom% or less as measured by XPS based on the total element content measured by XPS, and when the surface on the side in contact with the resin composition layer is sputtered for 1 minute under a condition of a speed of 3 nm/min in terms of SiO₂, the surface has a second nickel element content of 4.5 atom% or less as measured by XPS based on the total element content measured by XPS.

Note that, the "surface of the metal foil on the side in contact with the resin composition layer" is a surface of the metal foil with which the resin composition layer is brought into contact. Specifically, when the resin composite sheet C is produced by laminating a metal foil and a resin composition layer, the surface of the metal foil on the side in contact with the resin composition layer means a surface of the metal foil to be in contact with the resin composition layer, which includes a surface before coming into contact with the resin composition layer. The surface on the side in contact with the resin composition layer is also referred to as a contact surface in the present specification. The surface at the time when the surface on the side in contact with the resin composition layer is sputtered for 1 minute under the condition of a speed of 3 nm/min in terms of SiO₂ is a position where the sputtering is conducted from the contact surface before the surface is brought into contact with the resin composition layer. That is, the surface at the time when the surface on the side in contact with the resin composition layer is sputtered for 1 minute under the condition of a speed of 3 nm/min in terms of SiO₂ is a position where the surface is sputtered for 1 minute under the condition of a speed of 3 nm/min in terms of SiO₂ from the contact surface, and hereinafter, is sometimes referred like this. Note that, the sputtering as used herein refers to a sputtering under vacuum. Therefore, the resin composite sheet C is preferably a resin composite sheet C produced by using, as a metal foil, a metal foil having a nickel element contents at the contact surface and the position as measured by XPS are each within the range set forth above.

In the metal foil, the first nickel element content on the contact surface, as measured by XPS, is usually 4.5 atom% or less as described above, preferably 3.5 atom% or less, and more preferably 2.5 atom% or less based on the total element content measured by XPS. The second nickel element content, as measured by XPS, at the position sputtered from the contact surface for 1 minute under the condition of a speed of 3 nm/min in terms of SiO₂ is 4.5 atom% or less as described above, preferably 4.0 atom% or less, and more preferably 3.0 atom% or less based on the total element content measured by XPS. The arithmetic average value of the first nickel element content and the second nickel element content is preferably 3.0 atom% or less, more preferably 2.5 atom% or less, and still more preferably 2.0 atom% or less. When the first nickel element content is too small or the second nickel element content is too small, insulation reliability is deteriorated, and there is a tendency in a wiring board produced from a metal-clad laminate to be incapable of adequately suppressing the occurrence of ion migration between adjacent wirings. For this reason, the less both the first nickel element content and the second nickel element content are, the better, but in practice, the limits of the first nickel element content and of the second nickel element content are each approximately 0.1 atom%. From this, the first nickel element content and the second nickel element content are each preferably within a range from 0.1 to 4.5 atom% based on the total element content measured by XPS. The arithmetic average value of each of the first nickel element content and the second nickel element content is preferably within a range from 0.5 to 3.0 atom%.

Note that, XPS measurement can be conducted by using commonly used X-ray photoelectron spectroscopy. Specifically, the measurement can be conducted by irradiating the sample with X-rays under vacuum with PHI 5000 VersaProbe available from ULVAC-PHI, Inc.

A nitrogen element that can be confirmed by XPS is preferably present on the surface (contact surface) on the side in contact with the resin composition layer. Note that, the nitrogen element that can be confirmed by XPS is a nitrogen element content greater than or equal to the detection limit of XPS, specifically, it is 0.05 atom% or more. The contact surface preferably contains the nitrogen element content of 2.0 atom% or more, more preferably 2.5 atom% or more, and still more preferably 3.0 atom% or more as measured by XPS based on the total element content measured by XPS. When the nitrogen-element-containing compound is present on the contact surface, insulation reliability is further enhanced. On the other hand, when the nitrogen element content is too small, there is a tendency to be incapable of sufficiently exhibiting the effect of enhancing the insulation reliability owing to the presence of the nitrogen element. From this, the larger the nitrogen element content is, the better, but in practice, the limit is approximately 7.0 atom%. From this, the nitrogen element content is preferably within a range from 2.0 to 7.0 atom%.

The nitrogen element is preferably derived from a nitrogen atom contained in the compound having an amino group, and more preferably derived from a nitrogen atom contained in the silane coupling agent having an amino group. When the nitrogen element is derived from a nitrogen atom contained in the compound having an amino group, the compound containing the nitrogen element is thought to be a compound having an amino group. Specifically, such a metal foil is thought to be a metal foil including a silane coupling agent layer as a layer treated with a silane coupling agent having an amino group in the molecule. This compound having an amino group, that is, the silane coupling agent having an amino group in the molecule is thought to more effectively achieve the effect of enhancing the insulation reliability. It is thought from this that the resin composite sheet C capable of suitably producing a wiring board having higher insulation reliability can be obtained.

At the surface (contact surface) on the side in contact with the resin composition layer and at the position sputtered for 1 minute under the condition of a speed of 3 nm/min in terms of SiO₂ from the contact surface may present as an element that can be confirmed by XPS at least one element selected from a copper (Cu) element, a carbon (C) element, an oxygen (O) element, a silicon (Si) element, a chromium (Cr) element, a zinc (Zn) element, a cobalt (Co) element, etc., as well as the nickel (Ni) element and the nitrogen (N) element. The element contents of these elements are each, for example, preferably within a range from 0 to 90 atom%, more preferably from 0 to 80 atom%, and still more preferably from 0 to 70 atom% based on the total element content measured by XPS.

The first nickel element content and the second nickel element content can be adjusted, for example, by adjusting a thickness of a layer containing nickel such as an anti-rust layer containing nickel in the coating layer, a nickel concentration in a layer containing nickel, or the like.

The nitrogen element can be present by forming a layer using a silane coupling agent having an amino group in the molecule as the silane coupling agent layer. Furthermore, the amount (nitrogen element content) can be adjusted by adjusting the thickness or the like of a layer obtained by using a silane coupling agent having an amino group in the molecule as the silane coupling agent layer.

The average roughness of the surface (contact surface) on the side in contact with the resin composition layer is 2.0 µm or less, preferably 1.8 µm or less, and more preferably 1.5 µm or less as a ten-point average roughness. It is believed that the lower the surface roughness of the contact surface of the metal foil in contact with the resin composition layer is, the higher the smoothness of the contact surface between the wiring and the resin composition layer is, this is preferable in terms of capable of reducing the loss during signal transmission. Even if reducing the surface roughness of the contact surface, the surface roughness is practically approximately 0.2 µm as a ten-point average roughness Rz. When the surface roughness of the contact surface is too low, it is believed that the smoothness of the contact surface between the metal foil and the resin composition layer will also become too high, and the adhesiveness between the metal foil and the resin composition layer tends to be deteriorated. Also, in terms of this, the surface roughness of the contact surface is preferably 0.2 µm or more as a ten-point average roughness Rz. Therefore, the surface roughness of the contact surface is preferably 0.2 µm or more, more preferably 0.5 µm or more, and still more preferably 0.6 µm or more as a ten-point average roughness Rz.

The surface with large average roughness, a so-called M-surface, of the metal foil is a surface to be in contact with the resin composition layer. That is, the M-surface of the metal foil is the contact surface. The coating layer as described above is required to be formed on the side of this M-surface. The coating layer as described above may be formed on the surface with small average roughness, that is, a so-called S-surface, of the copper foil, as with the M-surface, but only the anti-rust layer may be formed on the S-surface, or no coating layer may be formed on the S-surface.

Apart from the description set forth above, regarding details of the metal foil, the roughening treatment layer, the heat-resistant treatment layer, the rustproofing treatment layer, the silane coupling agent treatment layer, and other layers to be used in the resin composite sheet C in the present embodiment, reference may be made to, as well as the descriptions set forth above, the descriptions of WO 2021/079819, WO 2021/079817, WO 2020/230870, and WO 2020/162056 without departing from the spirit of the present invention, and the contents thereof are incorporated herein.

The resin composition layer (the resin composition layer 13 in FIG. 3) is formed of a resin composition. The resin composition preferably includes a thermosetting resin, and the inorganic filler is preferably contained in an amount of from 0 to 250 parts by mass per 100 parts by mass of the resin solid content contained in the resin composition. When a resin composition having a small content of the inorganic filler is used, or when a resin composition containing no inorganic filler is used, the ratio of highly hygroscopic inorganic filler is reduced, and thus delamination between the resin composition layer and the metal foil can be more effectively suppressed.

Details of the composition of the resin composition are preferably the matters described in the section of <Resin composition> described later.

The thickness of the resin composition layer is, for example, 5 µm or more, preferably 10 µm or more, more preferably 15 µm or more, further more preferably 20 µm or more, and still more preferably 25 µm or more, and is preferably 100 µm or less, more preferably 80 µm or less, further more preferably 60 µm or less, still more preferably 50 µm or less, even more preferably 40 µm or less, and particularly preferably 35 µm or less. When the thickness is adjusted to be greater than or equal to the lower limit value, the insulation reliability tends to improve. When the thickness is adjusted to be less than or equal to the upper limit value, product thickness tends to be enabled to be reduced.

Examples of the carrier substrate (the carrier substrate 15 in FIG. 3) include a metal foil and a resin film, and a metal foil is preferable, and a copper foil is more preferable. When the carrier substrate is a copper foil, this is often referred to as a carrier copper foil. Regarding the resin film, reference may be made to the description in paragraph [0031] of WO 2017/086418, and the contents thereof are incorporated herein.

The thickness of the carrier substrate is, for example, 5 µm or more, preferably 8 µm or more, and is 100 µm or less, preferably 50 µm or less, more preferably 30 µm or less, and still more preferably 30 µm or less.

The total thickness of the resin composite sheet (before step 4) to be used in the present embodiment is preferably 5 µm or more, more preferably 6 µm or more, further more preferably 7 µm or more, still more preferably 8 µm or more, and even more preferably 9 µm or more. When the total thickness is adjusted to be greater than or equal to the lower limit value, insulation reliability tends to be further improved. The total thickness of the resin composite sheet (before Step 4) is preferably 30 µm or less, more preferably 25 µm or less, further more preferably 20 µm or less, still more preferably 15 µm or less, and even more preferably 10 µm or less. When the total thickness is adjusted to be less than or equal to the upper limit value, product thickness tends to be enabled to be reduced.

The total thickness (excluding the carrier substrate) of the resin composite sheet (before step 4) to be used in the present embodiment can be appropriately determined depending on the intended use. In one example, the total thickness (excluding the carrier substrate) of the resin composite sheet (before step 4) to be used in the present embodiment is preferably 5 µm or more, more preferably 6 µm or more, further more preferably 7 µm or more, still more preferably 8 µm or more, and even more preferably 9 µm or more. When the total thickness is adjusted to be greater than or equal to the lower limit value (in µm), insulation reliability tends to be further improved. The total thickness (excluding the carrier substrate) of the resin composite sheet (before step 4) to be used in the present embodiment is preferably 30 µm or less, more preferably 25 µm or less, further more preferably 20 µm or less, still more preferably 15 µm or less, and even more preferably 10 µm or less. When the total thickness is adjusted to be less than or equal to the upper limit value (in µm), product thickness tends to be enabled to be reduced.

### <Resin composition>

The resin composition of the present embodiment is a resin composition, which is to be used for producing a metal foil-clad laminate in which a resin composite sheet C including a metal foil and a resin composition layer disposed on one side of the metal foil is laminated on a surface of a circuit board A including an insulating layer and a conductor circuit layer, by a method using a vacuum laminator and including the following steps, the resin composition containing a thermosetting resin, wherein a content of an inorganic filler is from 0 to 250 parts by mass per 100 parts by mass of a resin solid content contained in the resin composition.
Step 1: a step of reducing the content of moisture and/or a solvent contained in the circuit board A to obtain the circuit board B;
Step 2: a step of disposing the resin composite sheet C including a metal foil and a resin composition layer disposed on one side of the metal foil on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

That is, the resin composition in the present embodiment is preferably a resin composition to be used in the method for producing a metal foil-clad laminate. Accordingly, the method for producing a metal foil-clad laminate has same meaning as stated in the section of the method for producing the metal foil-clad laminate.

Hereinafter, details of the resin composition will be described.

### <<Thermosetting resin>>

The resin composition of the present embodiment usually contains a thermosetting resin. The thermosetting resin preferably contains at least one selected from the group consisting of a polymer having a constitutional unit represented by Formula (V), a polyphenylene ether compound with a terminal unsaturated carbon-carbon double bond, a maleimide compound, a cyanate ester compound, an epoxy compound, a phenolic compound, an oxetane resin, a benzoxazine compound, and an alkenyl-substituted nadimide compound. 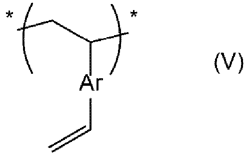 (In Formula (V), Ar represents an aromatic hydrocarbon linking group; and * represents a bonding position.)

### <<<Polymer having constitutional unit represented by Formula (V)>>>

The resin composition of the present embodiment preferably contains a polymer having a constitutional unit represented by Formula (V). Inclusion of the resin composition contains a polymer having a constitutional unit represented by Formula (V) can provide a resin composition excellent in low dielectric properties (low permittivity and low dielectric dissipation factor). 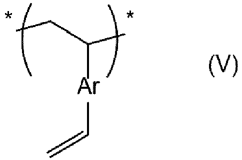 (In Formula (V), Ar represents an aromatic hydrocarbon linking group; and * represents a bonding position.)

The aromatic hydrocarbon linking group may be a group containing only an aromatic hydrocarbon optionally having a substituent, or a group containing a combination of an aromatic hydrocarbon optionally having a substituent and any other linking group, and is preferably a group containing only an aromatic hydrocarbon optionally having a substituent. Note that, examples of the substituent that the aromatic hydrocarbons optionally have include a substituent Z (such as an alkyl group having from 1 to 6 carbons, an alkenyl group having from 2 to 6 carbons, an alkynyl group having from 2 to 6 carbons, an alkoxy group having from 1 to 6 carbons, a hydroxy group, an amino group, a carboxy group, or a halogen atom). The aromatic hydrocarbon preferably has no substituent.

The aromatic hydrocarbon linking group is typically a divalent linking group.

Specific examples of the aromatic hydrocarbon linking group include a phenylene group, a naphthalenediyl group, an anthracenediyl group, a phenanthrenediyl group, a biphenyldiyl group, and a fluorenediyl group, all of which optionally have a substituent, and among these, a phenylene group optionally having a substituent is preferred. Examples of the substituent include the substituent Z set forth above, but the previously mentioned groups, such as a phenylene group, preferably have no substituent.

The constitutional unit represented by Formula (V) more preferably contains at least one of the group consisting of a constitutional unit represented by Formula (V1) set forth below, a constitutional unit represented by Formula (V2) set forth below, and a constitutional unit represented by Formula (V3) set forth below. Note that, * in Formulae set forth below denoted a bonding position. Hereinafter, the constitutional units represented by Formulae (V1) to (V3) may be collectively referred to as "constitutional unit (a)".

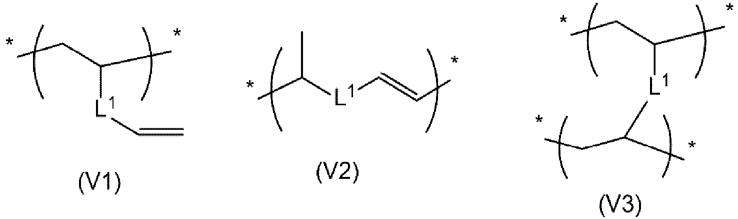

**In** Formulae (V1) to (V3), L¹ is an aromatic hydrocarbon linking group (preferably having from 6 to 22 carbons, more preferably from 6 to 18 carbons, and further more preferably from 6 to 10 carbons). Specific examples thereof include a phenylene group, a naphthalenediyl group, an anthracenediyl group, a phenanthrenediyl group, a biphenyldiyl group, and a fluorendiyl group, all of which optionally have a substituent, and above all, a phenylene group optionally having a substituent is preferable. Examples of the substituent include the substituent Z set forth above, but the previously mentioned groups, such as a phenylene group, preferably have no substituent.

The compound forming the constitutional unit (a) is preferably a divinyl aromatic compound, and examples thereof include divinylbenzene, bis(1-methylvinyl)benzene, divinylnaphthalene, divinylanthracene, divinylbiphenyl, and divinylphenanthrene. Among them, divinylbenzene is particularly preferable. One of these divinyl aromatic compounds may be used singly, or two or more types thereof may be used as necessary.

As described above, the polymer having the constitutional unit represented by Formula (V) may be a homopolymer of the constitutional unit (a), or may be a copolymer with a constitutional unit derived from another monomer.

When the polymer having the constitutional unit represented by Formula (V) is a copolymer, the copolymerization ratio of the constitutional unit (a) is preferably 3 mol% or more, more preferably 5 mol% or more, still more preferably 10 mol% or more, and may be 15 mol% or more. The upper limit value is preferably 90 mol% or less, more preferably 85 mol% or less, further more preferably 80 mol% or less, still more preferably 70 mol% or less, more preferably 60 mol% or less, even more preferably 50 mol% or less, yet even more preferably 40 mol% or less, particularly preferably 30 mol% or less, and may be 25 mol% or less or 20 mol% or less.

Examples of the constitutional unit derived from another monomer include the constitutional unit (b) derived from an aromatic compound having one vinyl group (monovinyl aromatic compound).

The constitutional unit (b) derived from the monovinyl aromatic compound is preferably a constitutional unit represented by Formula (V4) set forth below.

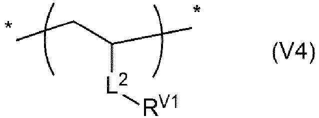

**In** Formula (V4), L² is an aromatic hydrocarbon linking group, and preferred specific examples include the L¹ set forth above.

R^{V1} is a hydrogen atom or a hydrocarbon group having from 1 to 12 carbons (preferably an alkyl group). When R^{V1} is a hydrocarbon group, the number of its carbons is preferably from 1 to 6 and more preferably from 1 to 3. R^{V1} and L² optionally have the substituent Z set forth above.

When the polymer having the constitutional unit represented by Formula (V) is a copolymer containing the constitutional unit (b) derived from a monovinyl aromatic compound, examples of the monovinyl aromatic compound include: vinyl aromatic compounds such as styrene, vinylnaphthalene, and vinylbiphenyl; and nucleophilic alkyl-substituted vinyl aromatic compounds such as o-methylstyrene, m-methylstyrene, p-methylstyrene, o,p-dimethylstyrene, o-ethylvinylbenzene, m-ethylvinylbenzene, p-ethylvinylbenzene, methylvinylbiphenyl, and ethylvinylbiphenyl. The monovinyl aromatic compounds exemplified here optionally have the substituent Z set forth above as appropriate. One of these monovinyl aromatic compounds may be used singly, or two or more of them may be used.

When the polymer having the constitutional unit represented by Formula (V) is a copolymer containing the constitutional unit (b), the copolymerization ratio of the constitutional unit (b) is preferably 10 mol% or more, and more preferably 15 mol% or more, and moreover may be 20 mol% or more, 30 mol% or more, 40 mol% or more, 50 mol% or more, 60 mol% or more, 70 mol% or more, or 75 mol% or more. The upper limit value thereof is preferably 98 mol% or less, more preferably 90 mol% or less, and further more preferably 85 mol% or less.

The polymer having the constitutional unit represented by Formula (V) may have an additional constitutional unit other than the constitutional unit (a) and the constitutional unit (b). Examples of the additional constitutional unit include a constitutional unit (c) derived from a cycloolefin compound. Examples of the cycloolefin compound include hydrocarbons having a double bond in the ring structure. Specific examples thereof include monocyclic olefins, such as cyclobutene, cyclopentene, cyclohexene, and cyclooctene; compounds having a norbomene ring structure, such as norbornene and dicyclopentadiene; and cycloolefin compounds fused with an aromatic ring, such as indene and acenaphthylene. Examples of the norbornene compound include those described in paragraphs [0037] to [0043] of JP 2018-39995 A, the content of which is incorporated herein by reference. Note that, the cycloolefin compounds exemplified here may further have the substituent Z set forth above.

When the polymer having the constitutional unit represented by Formula (V) is a copolymer containing the constitutional unit (c), the copolymerization ratio of the constitutional unit (c) is preferably 10 mol% or more, more preferably 20 mol% or more, and further more preferably 30 mol% or more. The upper limit value thereof is preferably 90 mol% or less, more preferably 80 mol% or less, further more preferably 70 mol% or less, and may be 50 mol% or less or 30 mol% or less.

The polymer having the constitutional unit represented by Formula (V) may further contain a constitutional unit (d) derived from yet another polymerizable compound (hereinafter may be referred to as the other polymerizable compound). Examples of the other polymerizable compound (monomer) include compounds containing three vinyl groups. Specific examples thereof include 1,3,5-trivinylbenzene, 1,3,5-trivinylnaphthalene, and 1,2,4-trivinylcyclohexane. Alternatively, examples that may be mentioned include ethylene glycol diacrylate or butadiene. The copolymerization ratio of the constitutional unit (d) derived from the other polymerizable compound is preferably 30 mol% or less, more preferably 20 mol% or less, and further more preferably 10 mol% or less.

An embodiment of the polymer having the constitutional unit represented by Formula (V) is exemplified by a polymer containing the constitutional unit (a) as an essential unit and at least one of the constitutional units (b) to (d). Furthermore, there is exemplified an aspect in which the total of the constitutional units (a) to (d) accounts for at least 95 mol% or even at least 98 mol% of all the constitutional units.

As another embodiment of the polymer having the constitutional unit represented by Formula (V), a polymer contains the constitutional unit (a) as an essential unit, and in which constitutional units containing an aromatic ring preferably account for 90 mol% or more, and more preferably 95 mol% or more, or may account for 100 mol% of all the constitutional units excluding the termini.

Note that, when calculating the mol% per all the constitutional units, one constitutional unit is defined as a unit derived from one molecule of a monomer (such as a divinyl aromatic compound, a monovinyl aromatic compound, or the like) used for producing the polymer having the constitutional unit represented by Formula (V).

The method for producing the polymer having the constitutional unit represented by Formula (V) is not particularly limited, and a common method can be used, and examples that may be mentioned include a method in which a feedstock containing a divinyl aromatic compound is polymerized in the presence of a Lewis acid catalyst (if needed, in the coexistence of a monovinyl aromatic compound, a cycloolefin compound, or the like). As the Lewis acid catalyst, a metal fluoride such as boron trifluoride or a complex thereof can be used.

The structure of the chain terminus of the polymer having the constitutional unit represented by Formula (V) is not particularly limited, but regarding the structure of the chain terminus of the group derived from the divinyl aromatic compound, mention may be made of a structure of Formula (E1) below. Note that, L¹ in Formula (E1) is the same as that defined in Formula (V1) set forth above, and * denotes a bonding position.

*-CH=CH-L¹-CH=CH₂ (E1)

When the group derived from a monovinyl aromatic compound becomes a chain terminus, as an example, the group has a structure of the following Formula (E2). In the formula, L² and R^{V1} each have the same meaning as defined in Formula (V4) set forth above, and * denotes a bonding position.

*-CH=CH-L²-R^{V1} (E2)

The molecular weight of the polymer having the constitutional unit represented by Formula (V) is preferably 300 or more, more preferably 500 or more, still more preferably 1000 or more, and further preferably 1500 or more as a number average molecular weight Mn. The upper limit value is preferably 130000 or less, more preferably 120000 or less, even more preferably 110000 or less, and still more preferably 100000 or less.

The molecular weight of the polymer having the constitutional unit represented by Formula (V) is preferably 1000 or more, more preferably 1500 or more, more preferably 2000 or more, more preferably 2500 or more, still more preferably 3000 or more, and may be 3500 or more or 4000 or more as a weight average molecular weight Mw. With the molecular weight being greater than or equal to the lower limit value, a cured product of the resin compositionis enabled to effectively exhibit the excellent low dielectric properties possessed by the polymer having the constitutional unit represented by Formula (V), particularly the Df and the dielectric properties after moisture absorption. The upper limit value is preferably 160000 or less, more preferably 150000 or less, even more preferably 140000 or less, and still more preferably 130000 or less, and may be 120000 or less or 110000 or less. With the molecular weight being less than or equal to the upper limit value, a poor embedding tends to be less likely to occur when a prepreg or a resin composite sheet is laminated on the circuit board.

The monodispersity represented by the ratio of weight average molecular weight Mw to number average molecular weight Mn (Mw/Mn) is preferably 100 or less, more preferably 50 or less, and even more preferably 20 or less. The lower limit value thereof is practically at least 1.1, and may be at least 5 or at least 7, and even if the monodispersity is 10 or more, the required performance will be met.

The Mw and Mn set forth above are measured in accordance with the description of Examples set forth below.

When the resin composition of the present embodiment contains two or more polymers having the constitutional unit represented by Formula (V), the Mw, Mn, and Mw/Mn of the mixture are preferably within the respective ranges set forth above.

The equivalent of the vinyl group of the polymer having the constitutional unit represented by Formula (V) is preferably 200 g/eq. or greater, more preferably 230 g/eq. or greater, still more preferably 250 g/eq. or greater, and may be 300 g/eq. or greater, or 350 g/eq. or greater. The equivalent of the vinyl group is preferably 1200 g/eq. or less, and more preferably 1000 g/eq. or less, and moreover may be 800 g/eq. or less, 600 g/eq. or less, 500 g/eq. or less, 400 g/eq. or less, or 350 g/eq or less. With the vinyl group equivalent being equal to or higher than the lower limit value, the storage stability of the resin composition tends to improve, and the fluidity of the resin composition tends to be enhanced. Therefore, moldability is improved, voids are less likely to occur during forming a prepreg etc., and a printed wiring board having higher reliability tends to be obtained. On the other hand, with the vinyl group equivalent being equal to or lower than the upper limit value, the thermal resistance of the resulting cured product tends to improve.

A cured product of the polymer having the constitutional unit represented by Formula (V) used in the present embodiment is preferably excellent in low dielectric properties. For example, the cured product of the polymer having the constitutional unit represented by Formula (V) used in the present embodiments has a relative permittivity (Dk) of preferably 2.80 or less, more preferably 2.60 or less, still more preferably 2.50 or less, and further preferably 2.40 or less, as measured at 10 GHz according to a resonance cavity perturbation method. The lower limit value of the relative permittivity is practically at least 1.80, for example. The cured product of the polymer having the constitutional unit represented by Formula (V) used in the present embodiments has a dielectric dissipation factor (Df) of preferably 0.0030 or less, more preferably 0.0020 or less, and still more preferably 0.0010 or less, as measured at 10 GHz according to a resonance cavity perturbation method. The lower limit value of the dielectric dissipation factor is practically at least 0.0001, for example.

The relative permittivity (Dk) and the dielectric dissipation factor (Df) are measured by the method set forth below.

Over a stainless steel mold having a frame of 100 mm × 30 mm × 1.0 mm (height) is spread 4.5 g of the resin powder, the mold is then set in a vacuum press machine (available from KITAGAWA SEIKI CO.,LTD.), held at 200°C, 220°C, and 240°C each for 1.5 hours, and pressed at a specific pressure of 1.9 MPa to produce a cured plate.

The cured plate is downsized to a width of 1.0 mm and dried at 120°C for 60 minutes, and then a relative permittivity (Dk) and a dielectric dissipation factor (Df) of the dried plate are measured at 10 GHz with a cavity resonator based on the perturbation method. The measurement is to be conducted at a temperature of 23°C.

Agilent 8722ES (available from Agilent Technologies Inc.) is used as the cavity resonator based on the perturbation method.

For the polymer having the constitutional unit represented by Formula (V) in the present specification, reference can be made to compounds, their synthesis conditions, and the like described in paragraphs [0029] to [0058] of WO 2017/115813, compounds, their synthesis conditions, and the like described in paragraphs [0013] to [0058] of JP 2018-039995 A, compounds, their synthesis conditions, and the like described in paragraphs [0008] to [0043] of JP 2018-168347 A, compounds, their synthesis conditions, and the like described in paragraphs [0014] to [0042] of JP 2006-070136 A, compounds, their synthesis conditions, and the like described in paragraphs [0014] to [0061] of JP 2006-089683 A, and compounds, their synthesis conditions, and the like described in paragraphs [0008] to [0036] of JP 2008-248001 A, and the contents thereof are incorporated herein by reference.

When the resin composition of the present embodiment contains a polymer having a constitutional unit represented by Formula (V), the content of the polymer having a constitutional unit represented by Formula (V) is preferably 1 part by mass or more and preferably 70 parts by mass or less with the resin solid content in the resin composition being 100 parts by mass. The lower limit value of the content of the polymer having the constitutional unit represented by Formula (V) is more preferably 3 parts by mass or more, still more preferably 5 parts by mass or more, and may be 10 parts by mass or more with the resin solid content in the resin composition being 100 parts by mass. When the content of the polymer having the constitutional unit represented by Formula (V) is adjusted to be equal to or higher than the lower limit value, low dielectric properties, particularly low relative permittivity can be effectively achieved. On the other hand, the upper limit value of the content of the polymer having the constitutional unit represented by Formula (V) is preferably 60 parts by mass or less, more preferably 50 parts by mass or less, still more preferably 40 parts by mass or less, even more preferably 30 parts by mass or less, and may be 20 parts by mass or less, or 15 parts by mass or less with the resin solid content in the resin composition being 100 parts by mass. When the content is adjusted to be less than or equal to the upper limit value, the peel strength of metal foil from the resulting cured product can be effectively increased.

Only one of the polymers having the constitutional unit represented by Formula (V) may be contained in the resin composition, or two or more of them may be contained in the resin composition. When two or more of the polymers are contained, the total amount thereof is preferably within the range set forth above.

### <<<Polyphenylene ether compound with a terminal unsaturated carbon-carbon double bond>>>

The resin composition of the present embodiment may contain (preferably contains two or more of) a polyphenylene ether compound with a terminal unsaturated carbon-carbon double bond.

The polyphenylene ether compound with a terminal unsaturated carbon-carbon double bond is preferably a polyphenylene ether compound having two or more groups selected from the group consisting of a (meth)acrylic group, a maleimide group, and a vinylbenzyl group at the terminus. A polyphenylene ether compound having two or more groups represented by Formula (Rx-1) and/or Formula (Rx-2) described later at the terminus is also preferable. When this polyphenylene ether compound is used, a printed wiring board or the like tends to be enabled to be more effectively improved in dielectric properties, low water absorption and the like.

Hereinafter, these details will be described.

Examples of the polyphenylene ether compound with a terminal unsaturated carbon-carbon double bond include a compound having a phenylene ether skeleton represented by Formula (X1) below. 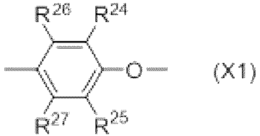 (In Formula (X1), R²⁴, R²⁵, R²⁶, and R²⁷ may be the same or different, and each represent an alkyl group having 6 or less carbons, an aryl group, a halogen atom, or a hydrogen atom.)

The polyphenylene ether compound with a terminal unsaturated carbon-carbon double bond may further contain a repeating unit represented by Formula (X2): 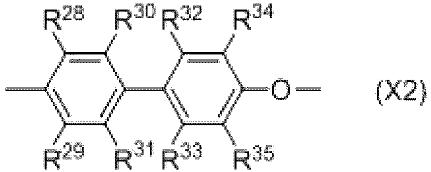
(In Formula (X2), R²⁸, R²⁹, R³⁰, R³⁴, and R³⁵ may be the same or different and each represent an alkyl group having 6 or less carbon atoms or a phenyl group; and R³¹, R³², and R³³ may be the same or different and each represent a hydrogen atom, an alkyl group having 6 or fewer carbon atoms, or a phenyl group)
and/or a repeating unit represented by Formula (X3): 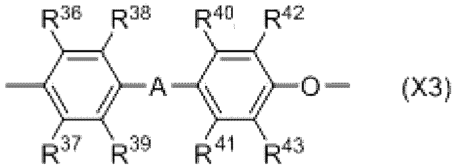
(In Formula (X3), R³⁶, R³⁷, R³⁸, R³⁹, R⁴⁰, R⁴¹, R⁴², and R⁴³ may be the same or different and each represent a hydrogen atom, an alkyl group having 6 or less carbon atoms, or a phenyl group; and -A- is a linear, branched, or cyclic divalent hydrocarbon group having 20 or fewer carbon atoms).

The polyphenylene ether compound having two or more terminal unsaturated carbon-carbon double bonds is preferably a modified polyphenylene ether compound in which some or all of the termini are functionalized with an ethylenically unsaturated group (hereinafter, referred to as a "modified polyphenylene ether compound (g)" in some cases), more preferably a modified polyphenylene ether compound having a terminus with two or more groups selected from the group consisting of a (meth)acrylic group, a maleimide group, a (meth)allyl group, and a vinylbenzyl group, and more preferably a modified polyphenylene ether compound having a terminus with two or more groups selected from the group consisting of a (meth)acrylic group, a maleimide group, and a vinylbenzyl group. Alternatively, a modified polyphenylene ether compound having a terminus with two or more groups represented by Formula (Rx-1) and/or Formula (Rx-2) described later is also preferable. Employing such a modified polyphenylene ether compound (g) enables the cured product of the resin composition to have further reduced dielectric dissipation factor (Df) and to exhibit enhanced low water absorption and increased the peel strength of metal foil. One of the modified polyphenylene ether compounds may be used singly, or two or more of them may be used in combination.

Examples of the modified polyphenylene ether compound (g) include a polyphenylene ether compound represented by Formula (OP). 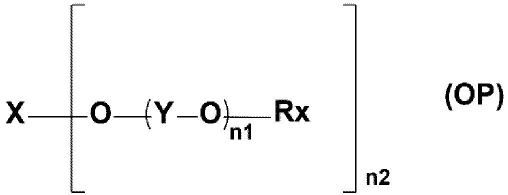 (In Formula (OP), X represents an aromatic group; -(Y-O)ₙ₁- represents a polyphenylene ether structure; n1 represents an integer of 1 to 100; n2 represents an integer of 1 to 4; and Rx is a group represented by Formula (Rx-1) or Formula (Rx-2).) 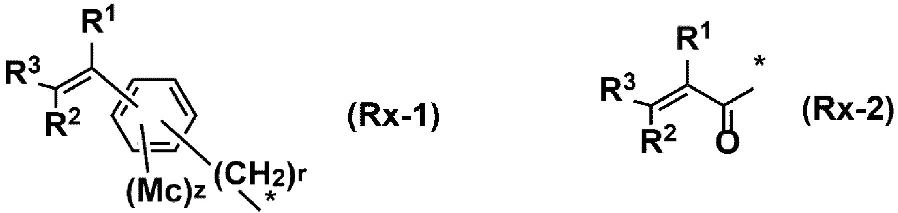 (In Formula (Rx-1) and Formula (Rx-2), R¹, R², and R³ each independently represent a hydrogen atom, an alkyl group, an alkenyl group, or an alkynyl group; * is a bonding site to an oxygen atom; Mc each independently represents a hydrocarbon group having from 1 to 12 carbons; z represents an integer of 0 to 4; and r represents an integer of 1 to 6).

When n₁ and/or n₂ is an integer of 2 or more, n₁ constitutional units (Y-O) and/or n₂ constitutional units may be the same or different. n₂ is preferably 2 or more, and more preferably 2.

In Formula (Rx-1) and Formula (Rx-2), R¹, R², and R³ each independently represent a hydrogen atom, an alkyl group, an alkenyl group, or an alkynyl group.

R¹ is preferably a hydrogen atom or an alkyl group, more preferably a hydrogen atom or a methyl group, and still more preferably a hydrogen atom.

R² and R³ are each independently preferably a hydrogen atom or an alkyl group, more preferably a hydrogen atom or a methyl group, and still more preferably a hydrogen atom.

When R¹, R², and R³ each are an alkyl group, an alkenyl group, or an alkynyl group, the number of carbons in each of them is preferably 5 or less, and more preferably 3 or less.

In Formula (Rx-1), r represents an integer of 1 to 6, and is preferably an integer of 1 to 5, more preferably an integer of 1 to 4, still more preferably an integer of 1 to 3, even more preferably 1 or 2, and further more preferably 1.

In Formula (Rx-1), Mc each independently represents a hydrocarbon group having from 1 to 12 carbons, and is preferably a hydrocarbon group having from 1 to 10 carbons, more preferably a linear or branched alkyl group having from 1 to 10 carbons, still more preferably a methyl group, an ethyl group, an isopropyl group, an isobutyl group, a t-butyl group, a pentyl group, an octyl group, or a nonyl group, and even more preferably a methyl group, an ethyl group, an isopropyl group, an isobutyl group, or a t-butyl group.

In Formula (Rx-1), z represents an integer of 0 to 4, and is preferably an integer of 0 to 3, more preferably an integer of 0 to 2, still more preferably 0 or 1, and even more preferably 0.

A specific example of the group represented by Formula (Rx-1) is a vinylbenzyl group, and a specific example of the group represented by Formula (Rx-2) is a (meth)acryloyl group.

Examples of the modified polyphenylene ether compound (g) include a compound represented by Formula (OP-1): 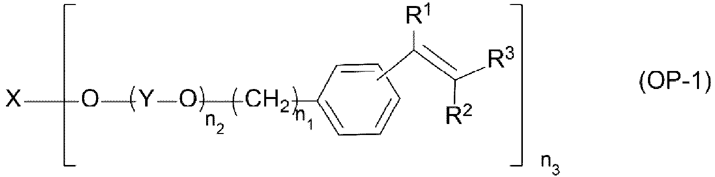 (In Formula (OP-1), X represents an aromatic group; -(Y-O)n₂- represents a polyphenylene ether structure; R¹, R², and R³ each independently represent a hydrogen atom, an alkyl group, an alkenyl group, or an alkynyl group; n₁ represents an integer of 1 to 6; n₂ represents an integer of 1 to 100; and n₃ represents an integer of 1 to 4.)

In a case where n₂ is an integer of 2 or more, and for n₃, n₂ constitutional units (Y-O) and/or n₃ constitutional units may be the same or different; and n₃ is preferably from 2 to 4, and more preferably 2.

The modified polyphenylene ether compound (g) in the present embodiments is preferably a compound represented by Formula (OP-2): 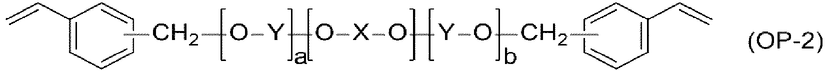
where -(O-X-O)- is preferably represented by Formula (OP-3): 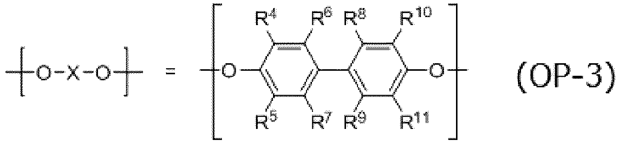
(In Formula (OP-3), R⁴, R⁵, R⁶, R¹⁰, and R¹¹ may be the same or different and are each an alkyl group having 6 or less carbon atoms or a phenyl group; and R⁷, R⁸, and R⁹ may be the same or different and are each a hydrogen atom, an alkyl group having 6 or less carbon atoms, or a phenyl group)
and/or Formula (OP-4): 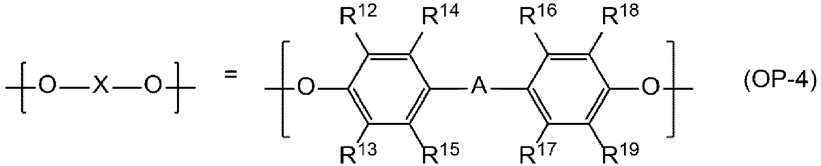
(In Formula (OP-4), R¹², R¹³, R¹⁴, R¹⁵, R¹⁶, R¹⁷, R¹⁸, and R¹⁹ may be the same or different and are each a hydrogen atom, an alkyl group having 6 or less carbon atoms, or a phenyl group; and -A- is a linear, branched, or cyclic divalent hydrocarbon group having 20 or less carbons.)
-(Y-O)- is preferably represented by Formula (OP-5): 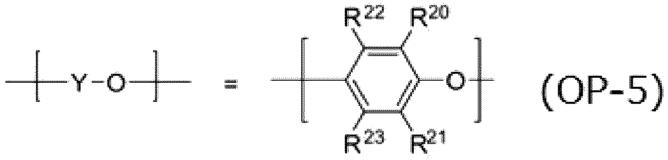
(In Formula (OP-5), R²⁰ and R²¹ may be the same or different, and are each an alkyl group having 6 or less carbon atoms or a phenyl group, R²² and R²³ may be the same or different, and are each a hydrogen atom, an alkyl group having 6 or less carbons, or a phenyl group.)

R²⁰ and R²¹ each independently are preferably a group having one or more methyl groups and/or one or more cyclohexyl groups, because the resulting resin molecules have an increased rigidity, the mobility of the molecules with high rigidity is lower than that of the molecules with low rigidity, and hence the relaxation time during dielectric relaxation increases and the low dielectric properties (Dk and/or Df) are enhanced.

An example of Formula (OP-5) is the structure set forth below.

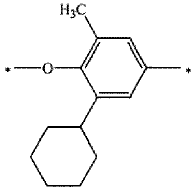

For the polyphenylene compound having the structure set forth above, reference can be made to the description of JP 2019-194312 A, the content thereof is incorporated herein by reference.

In Formula (OP-2), "a" and "b" each independently represent an integer of 0 to 100, and "a" and/or "b" is an integer of 1 to 100. "a" and "b" are preferably each independently an integer of 0 to 50, more preferably an integer of 1 to 30, and preferably an integer of 1 to 10. When "a" and/or "b" is an integer of 2 or more, two or more -(Y-O)- may each independently be in an arrangement of one type of structure or a block or random arrangement of two or more types of structures.

When a plurality of compounds represented by Formula (OP-2) are contained, an average value of "a" is preferably 1 < a < 10, and an average value of "b" is preferably 1 < b < 10.

Examples of -A- in Formula (OP-4) include, but are not limited to, divalent organic groups such as a methylene group, an ethylidene group, a 1-methylethylidene group, a 1,1-propylidene group, a 1,4-phenylenebis(1-methylethylidene) group, a 1,3-phenylenebis(1-methylethylidene) group, a cyclohexylidene group, a phenylmethylene group, a naphthylmethylene group, and a 1-phenylethylidene group.

Among the compounds represented by Formula (OP-2), preferred is a polyphenylene ether compound in which R⁴, R⁵, R⁶, R¹⁰, R¹¹, R²⁰, and R²¹ are each an alkyl group having 3 or less carbons, and R⁷, R⁸, R⁹, R¹², R¹³, R¹⁴, R¹⁵, R¹⁶, R¹⁷, R¹⁸, R¹⁹, R²² and R²³ are each a hydrogen atom or an alkyl group having 3 or less carbons, and in particular, -(O-X-O)-represented by Formula (OP-3) or Formula (OP-4) is preferably Formula (OP-9), Formula (OP-10), and/or Formula (OP-11), and -(Y-O)- represented by Formula (OP-5) is preferably Formula (OP-12) or Formula (OP-13). When a and/or b is an integer of 2 or more, two or more -(Y-O)-may each independently have a structure in which two or more of Formula (OP-12) and/or two or more of Formula (OP-13) are arranged, or a structure in which different blocks of Formula (OP-12) and Formula (OP-13) are arranged or Formula (OP-12) and Formula (OP-13) are randomly arranged. 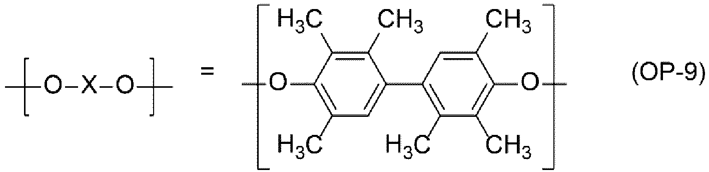 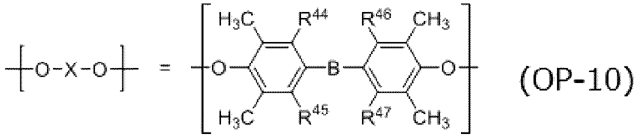 (In Formula (OP-10), R⁴⁴, R⁴⁵, R⁴⁶, and R⁴⁷ may be the same or different, and are each a hydrogen atom or a methyl group; and -B- is a linear, branched, or cyclic divalent hydrocarbon group having 20 or less carbons.)

Specific examples of -B- include the same as those for the specific examples of -A- in Formula (OP-4). 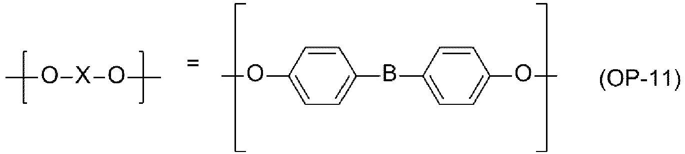 (In Formula (OP-11), -B- is a linear, branched, or cyclic divalent hydrocarbon group having 20 or less carbons.)

Specific examples of -B- include the same as those for the specific examples of -A- in Formula (OP-4).

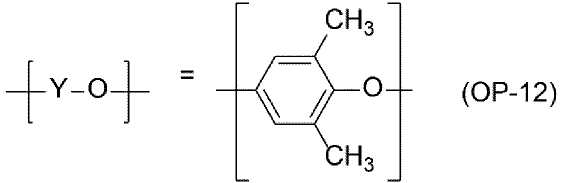

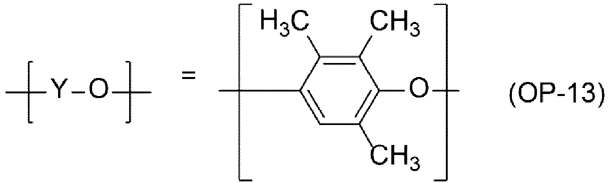

The modified polyphenylene ether compound (g) to be used in the present embodiment is more preferably a compound represented by Formula (OP-14) and/or a compound represented by Formula (OP-15), and still more preferably a compound represented by Formula (OP-15). 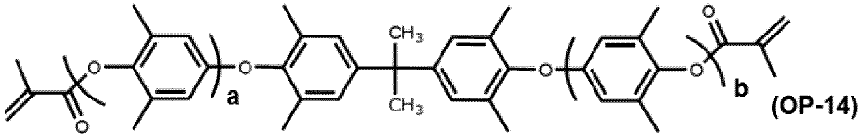 (In Formula (OP-14), "a" and "b" each independently represent an integer of 0 to 100, and "a" and/or "b" is an integer of 1 to 100.)

In Formula (OP-14), "a" and "b" each have the same meanings as "a" and "b" in Formula (OP-2), and preferred ranges thereof are also the same. 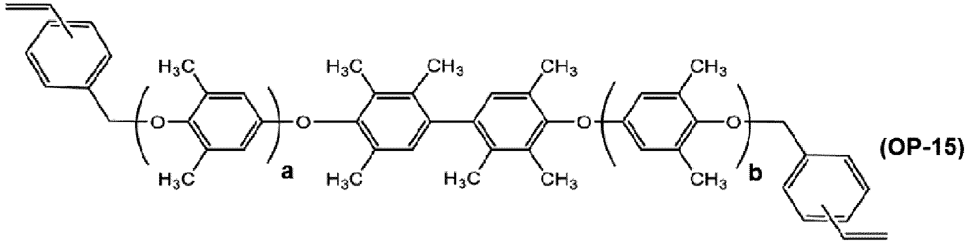 (In Formula (OP-15), "a" and "b" each independently represent an integer of 0 to 100, and "a" and/or "b" is an integer of 1 to 100.)

In Formula (OP-15), "a" and "b" each have the same meanings as a and b in Formula (OP-2), and preferred ranges thereof are also the same.

The polyphenylene ether compound with a terminal unsaturated carbon-carbon double bond may be produced by a known method, or a commercially available product thereof may be used. Examples of the commercially available product include "SA9000" available from SABIC Innovative Plastics, which is a modified polyphenylene ether compound with a methacrylic group at the terminus. Examples of the modified polyphenylene ether compound with a vinylbenzyl group at the terminus include "OPE-2St1200" and "OPE-2st2200" available from MITSUBISHI GAS CHEMICAL COMPANY, INC. As the modified polyphenylene ether compound with a vinylbenzyl group at the terminus, there can be used a modified product of a polyphenylene ether compound with a hydroxyl group at the terminus, such as "SA90" available from SABIC Innovative Plastics, by modifying the terminus to a vinylbenzyl group with the use of vinylbenzyl chloride or the like.

Apart from the description set forth above, regarding details of the polyphenylene ether compound with a terminal unsaturated carbon-carbon double bond, reference may be made to descriptions of JP 2006 028111 A, JP 2018-131519 A, WO 2019/138992, and WO 2022/054303, and the contents thereof are incorporated herein.

The number average molecular weight of the polyphenylene ether compound with a terminal unsaturated carbon-carbon double bond (preferably, the modified polyphenylene ether compound (g)) is preferably 500 or more and 3000 or less in terms of polystyrene by a GPC (gel permeation chromatography) method. When the number average molecular weight is 500 or greater, stickiness tends to be further suppressed when forming a coating film of the resin composition of the present embodiment. When the number average molecular weight is 3000 or less, the solubility in a solvent tends to be further improved.

The weight average molecular weight of the polyphenylene ether compound (preferably, the modified polyphenylene ether compound (g)) with a terminal unsaturated carbon-carbon double bond is preferably 800 or more and 10000 or less, more preferably 800 or more and 5000 or less in terms of polystyrene by GPC. With the weight average molecular weight being greater than or equal to the lower limit value, a cured product of the resin composition tends to have lower permittivity (Dk) and lower dielectric dissipation factor (Df), whereas with the weight average molecular weight being equal to or lower than the upper limit value, the resin composition tends to have a further improved solubility in a solvent, and further enhanced low viscosity properties and moldability when preparing varnish to be described below or the like.

Furthermore, the terminal unsaturated carbon-carbon double bond equivalent of the modified polyphenylene ether compound (g) is preferably from 400 to 5000 g and more preferably from 400 to 2500 g per unsaturated carbon-carbon double bond. With the terminal unsaturated carbon-carbon double bond equivalent being greater than or equal to the lower limit value, the cured product of the resin composition tends to have lower relative permittivity (Dk) and dielectric dissipation factor (Df). With the terminal unsaturated carbon-carbon double bond equivalent being equal to or lower than the above upper limit value, the resin composition tends to have a further increased solubility in a solvent, and further enhanced low viscosity properties and moldability.

When the resin composition of the present embodiment contains a polyphenylene ether compound with a terminal unsaturated carbon-carbon double bond, the lower limit value of the content of the polyphenylene ether compound with a terminal unsaturated carbon-carbon double bond is preferably 1 part by mass or more, more preferably 3 parts by mass or more, further more preferably 5 parts by mass or more, still more preferably 7 parts by mass or more, and even more preferably 10 parts by mass or more, per 100 parts by mass of the resin solid content in the resin composition. When it is adjusted to be greater than or equal to the lower limit value, the low water absorption and low dielectric properties (Dk and/or Df) of the resulting cured product tend to be further improved. The upper limit value of the content of the polyphenylene ether compound with a terminal unsaturated carbon-carbon double bond is preferably 70 parts by mass or less, more preferably 60 parts by mass or less, further more preferably 50 parts by mass or less, still more preferably 40 parts by mass or less, even more preferably 35 parts by mass or less, and yet even more preferably 30 parts by mass or less, per 100 parts by mass of the resin solid content in the resin composition. When it is adjusted to be less than or equal to the upper limit value, the thermal resistance and chemical resistance of the resulting cured product tend to be further improved.

The resin composition of the present embodiment may contain only one of, or two or more of the polyphenylene ether compounds with a terminal unsaturated carbon-carbon double bond. When two or more of them are contained, the total amount thereof is preferably within the range set forth above.

### <<<Maleimide compound>>>

The resin composition of the present embodiment may contain a maleimide compound. The resin composition of the present embodiment is not particularly limited as long as it is a compound having one or more (preferably 2 or more, more preferably from 2 to 12, still more preferably from 2 to 6, even more preferably from 2 to 4, even more preferably 2 or 3, even more preferably 2) maleimide groups per molecule, and a wide variety of compounds commonly used in the field of printed wiring boards can be used.

In the present embodiment, the maleimide compound is preferably a compound represented by any of Formula (M0) to Formula (M5), more preferably a compound represented by any of Formula (M0) to Formula (M4), still more preferably a compound represented by Formula (M0), Formula (M1), or Formula (M3), and still more preferably a compound represented by Formula (M1). When such a maleimide compound is used in a material for a printed wiring board (such as a metal foil-clad laminate), an excellent thermal resistance can be provided. In particular, when the compound represented by Formula (M1) is used, low dielectric properties tend to be more effectively achieved. 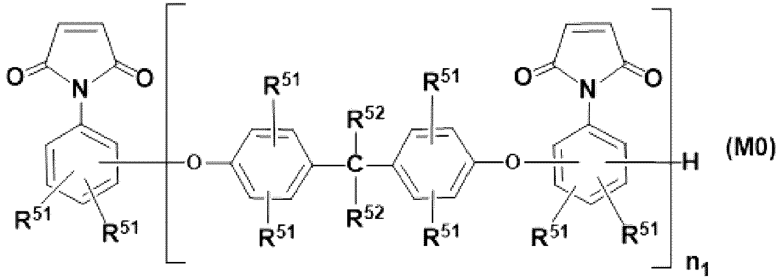 (In Formula (M0), R⁵¹ each independently represents a hydrogen atom, an alkyl group having from 1 to 8 carbons, or a phenyl group; R⁵² each independently represents a hydrogen atom or a methyl group; and n₁ represents an integer of 1 or more.)

R⁵¹ is preferably each independently a hydrogen atom, a methyl group, an ethyl group, a n-propyl group, an isopropyl group, a n-butyl group, an isobutyl group, a t-butyl group, a n-pentyl group, or a phenyl group, more preferably a hydrogen atom or a methyl group, and still more preferably a hydrogen atom.

R⁵² is preferably a methyl group.

n₁ is preferably an integer of 1 to 10, more preferably an integer of 1 to 5, still more preferably an integer of 1 to 3, further preferably 1 or 2, and further still more preferably 1.

The compound represented by Formula (M0) may be one type, or a mixture of two or more types. Examples of such a mixture include a mixture of compounds having different n₁, a mixture of compounds having different types of substituents of R⁵¹ and/or R⁵², a mixture of compounds having different bonding positions (meta-position, para-position, ortho-position) of a maleimide group and an oxygen atom in relation to each other on a benzene ring, and a mixture of compounds that combine two or more different points described above. Hereinafter, the same applies to the compounds represented by Formulas (M1) to (M5). 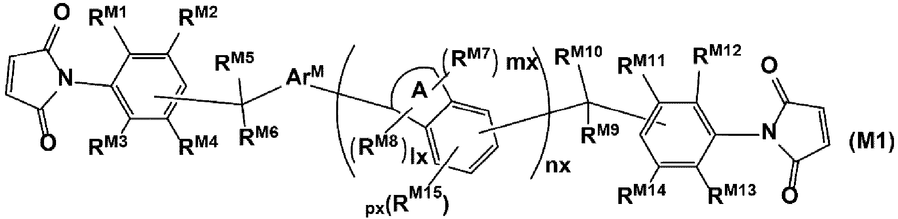 (In Formula (M1), R^{M1}, R^{M2}, R^{M3}, and R^{M4} each independently represent a hydrogen atom or an organic group; R^{M5} and R^{M6} each independently represent a hydrogen atom or an alkyl group; Ar^{M} represents a divalent aromatic group; A is a four- to six-membered alicyclic group; R^{M7} and R^{M8} are each independently an alkyl group; mx is 1 or 2; lx is 0 or 1; R^{M9} and R^{M10} each independently represent a hydrogen atom or an alkyl group; R^{M11}, R^{M12}, R^{M13}, and R^{M14} each independently represent a hydrogen atom or an organic group; R^{M15} each independently represents an alkyl group having from 1 to 10 carbon atoms, an alkyloxy group having from 1 to 10 carbon atoms, an alkylthio group having from 1 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, px represents an integer of 0 to 3; and nx represents an integer of 1 to 20).

R^{M1}, R^{M2}, R^{M3}, and R^{M4} in Formula each independently represent a hydrogen atom or an organic group. The organic group here is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and among them, a methyl group is particularly preferable. R^{M1} and R^{M3} are each independently preferably an alkyl group, and R^{M2} and R^{M4} are preferably a hydrogen atom.

R^{M5} and R^{M6} each independently represent a hydrogen atom or an alkyl group, and are preferably an alkyl group. The alkyl group here is preferably an alkyl group having from 1 to 12 carbons, more preferably an alkyl group having from 1 to 6 carbons, even more preferably a methyl group, an ethyl group, a propyl group, or a butyl group, and particularly preferably a methyl group.

Ar^{M} represents a divalent aromatic group and is preferably a phenylene group, a naphthalenediyl group, a phenanthrenediyl group, or an anthracenediyl group, more preferably a phenylene group, and even more preferably a m-phenylene group. Ar^{M} may have a substituent, and the substituent is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and particularly preferably a methyl group. However, Ar^{M} is preferably unsubstituted.

A is a four- to six-membered alicyclic group and more preferably a five-membered alicyclic group (preferably a group that together with the benzene ring forms an indane ring). R^{M7} and R^{M8} each independently are alkyl groups, preferably alkyl groups having from 1 to 6 carbon atoms, more preferably alkyl groups having from 1 to 3 carbon atoms, and particularly preferably methyl groups.

mx is 1 or 2 and preferably 2.

lx is 0 or 1 and preferably 1.

R^{M9} and R^{M10} each independently represent a hydrogen atom or an alkyl group, and are more preferably an alkyl group. The alkyl group here is preferably an alkyl group having from 1 to 12 carbons, more preferably an alkyl group having from 1 to 6 carbons, even more preferably a methyl group, an ethyl group, a propyl group, or a butyl group, and particularly preferably a methyl group.

R^{M11}, R^{M12}, R^{M13}, and R^{M14} each independently represent a hydrogen atom or an organic group; The organic group here is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and among them, a methyl group is particularly preferable. R^{M12} and R^{M13} are each independently preferably an alkyl group, and R^{M11} and R^{M14} are preferably a hydrogen atom.

R^{M15} each independently represents an alkyl group having from 1 to 10 carbon atoms, an alkyloxy group having from 1 to 10 carbon atoms, an alkylthio group having from 1 to 10 carbon atoms, an aryl group having from 6 to 10 carbon atoms, an aryloxy group having from 6 to 10 carbon atoms, an arylthio group having from 6 to 10 carbon atoms, a halogen atom, a hydroxyl group, or a mercapto group, and is preferably an alkyl group having from 1 to 4 carbon atoms, a cycloalkyl group having from 3 to 6 carbon atoms, or an aryl group having from 6 to 10 carbon atoms.

px represents an integer of 0 to 3, and is preferably an integer of 0 to 2, more preferably 0 or 1, and even more preferably 0.

nx represents an integer of 1 to 20. nx may be an integer of 10 or less.

Note that, the resin composition of the present embodiment may contain only one of, or two or more of the compounds that are represented by Formula (M1) and have different values of at least nx. When the resin composition contains two or more of the compounds, the average value (average number of repeating units) n of nx in the compound represented by Formula (M1) in the resin composition is preferably 0.92 or more, more preferably 0.95 or more, still more preferably 1.0 or more, and further preferably 1.1 or more in order to obtain the resin composition having a low melting point (low softening point), low melt viscosity, and excellent handleability. n is preferably 10.0 or less, more preferably 8.0 or less, even more preferably 7.0 or less, and still more preferably 6.0 or less, and may be 5.0 or less. The same applies to the later-described Formula (M1-1) and the like.

The compound represented by Formula (M1) is preferably a compound represented by Formula (M1-1) below. 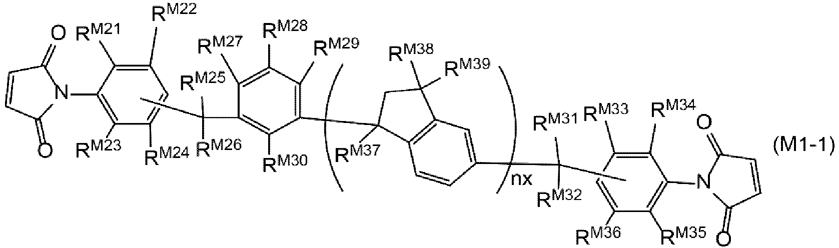 (In Formula (M1-1), R^{M21}, R^{M22}, R^{M23}, and R^{M24} each independently represent a hydrogen atom or an organic group; R^{M25} and R^{M26} each independently represent a hydrogen atom or an alkyl group; R^{M27,} R^{M28,} R^{M29}, and R^{M30} each independently represent a hydrogen atom or an organic group; R^{M31} and R^{M32} each independently represent a hydrogen atom or an alkyl group; R^{M33}, R^{M34}, R^{M35}, and R^{M36} each independently represent a hydrogen atom or an organic group; R^{M37} R^{M38}, and R^{M39} each independently represent a hydrogen atom or an alkyl group; and nx represents an integer of 1 or more and 20 or less.)

R^{M21}, R^{M22}, R^{M23}, and R^{M24} in the formula each independently represent a hydrogen atom or an organic group. The organic group here is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and particularly preferably a methyl group. R^{M21} and R^{M23} are each preferably an alkyl group, and R^{M22} and R^{M24} are each preferably a hydrogen atom.

R^{M25} and R^{M26} each independently represent a hydrogen atom or an alkyl group, and are preferably alkyl groups. The alkyl group here is preferably an alkyl group having from 1 to 12 carbons, more preferably an alkyl group having from 1 to 6 carbons, even more preferably a methyl group, an ethyl group, a propyl group, or a butyl group, and particularly preferably a methyl group.

R^{M27}, R^{M28}, R^{M29}, and R^{M30} each independently represent a hydrogen atom or an organic group, and are preferably hydrogen atoms. The organic group here is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and particularly preferably a methyl group.

R^{M31} and R^{M32} each independently represent a hydrogen atom or an alkyl group, and are preferably alkyl groups. The alkyl group here is preferably an alkyl group having from 1 to 12 carbons, more preferably an alkyl group having from 1 to 6 carbons, even more preferably a methyl group, an ethyl group, a propyl group, or a butyl group, and particularly preferably a methyl group.

R^{M33}, R^{M34}, R^{M35}, and R^{M36} each independently represent a hydrogen atom or an organic group; The organic group here is preferably an alkyl group, more preferably an alkyl group having from 1 to 12 carbons, even more preferably an alkyl group having from 1 to 6 carbons, still more preferably a methyl group, an ethyl group, a propyl group, or a butyl group, and particularly preferably a methyl group.

R^{M33} and R^{M36} are preferably a hydrogen atom, and R^{M34} and R^{M35} are preferably an alkyl group.

R^{M37}, R^{M38}, and R^{M39} each independently represent a hydrogen atom or an alkyl group, and are preferably alkyl groups. The alkyl group here is preferably an alkyl group having from 1 to 12 carbons, more preferably an alkyl group having from 1 to 6 carbons, even more preferably a methyl group, an ethyl group, a propyl group, or a butyl group, and particularly preferably a methyl group.

nx represents an integer of 1 or more and 20 or less. nx may be an integer of 10 or less.

The compound represented by Formula (M1-1) is preferably a compound represented by Formula (M1-2) below. 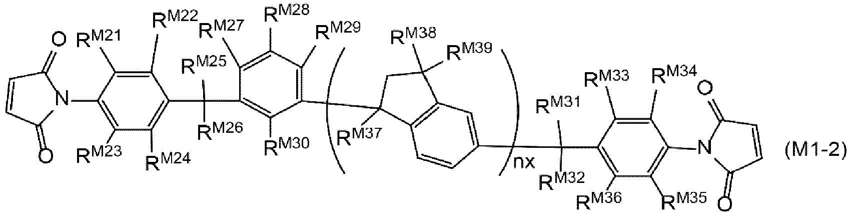 (In Formula (M1-2), R^{M21}, R^{M22}, R^{M23}, and R^{M24} each independently represent a hydrogen atom or an organic group; R^{M25} and R^{M26} each independently represent a hydrogen atom or an alkyl group; R^{M27,} R^{M28}, R^{M29}, and R^{M30} each independently represent a hydrogen atom or an organic group; R^{M31} and R^{M32} each independently represent a hydrogen atom or an alkyl group; R^{M33}, R^{M34}, R^{M35}, and R^{M36} each independently represent a hydrogen atom or an organic group; R^{M37} R^{M38}, and R^{M39} each independently represent a hydrogen atom or an alkyl group; and nx represents an integer of 1 or more and 20 or less.)

In Formula (M1-2), R^{M21}, R^{M22}, R^{M23}, R^{M24}, R^{M25}, R^{M26}, R^{M27}, R^{M28}, R^{M29}, R^{M30}, R^{M31}, R^{M32}, R^{M33}, R^{M34}, R^{M35}, R^{M36} R^{M37}, R^{M38}, R^{M39}, and nx have the same meanings as R^{M21}, R^{M22}, R^{M23}, R^{M24}, R^{M25}, R^{M26}, R^{M27}, R^{M28}, R^{M29}, R^{M30}, R^{M31}, R^{M32}, R^{M33}, R^{M34}, R^{M35}, R^{M36}, R^{M37}, R^{M38}, R^{M39}, and nx in Formula (M1-1), respectively, and preferred ranges thereof are also the same.

Moreover, the compound represented by Formula (M1-1) is preferably a compound represented by Formula (M1-3) below, and more preferably a compound represented by Formula (M1-4) below: 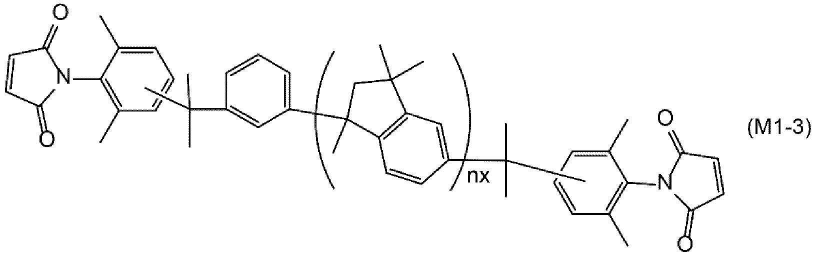
(In Formula (M1-3), nx represents an integer of 1 or more and 20 or less.)
nx may be an integer of 10 or less. 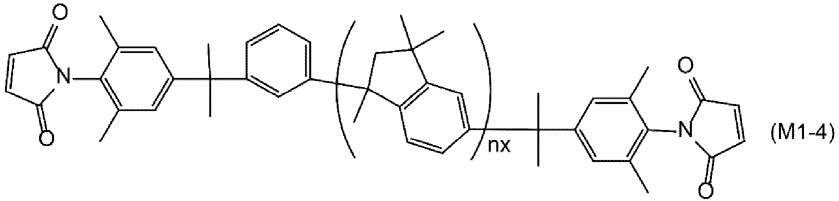
(In Formula (M1-4), nx represents an integer of 1 or more and 20 or less.)

The molecular weight of the compound represented by Formula (M1) is preferably 500 or more, more preferably 600 or more, and still more preferably 700 or more. With the molecular weight being greater than or equal to the lower limit value, the low dielectric properties and low water absorption of the resulting cured product tend to be further improved. The molecular weight of the compound represented by Formula (M1) is preferably 10000 or less, more preferably 9000 or less, still more preferably 7000 or less, further preferably 5000 or less, and even more preferably 4000 or less. With the molecular weight being less than or equal to the upper limit value, the thermal resistance and handleability of the resulting cured product tend to be further improved. 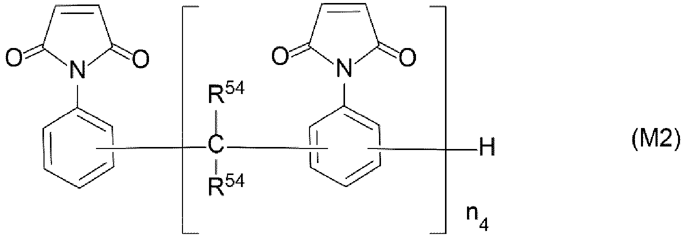 (In Formula (M2), R⁵⁴ each independently represents a hydrogen atom or a methyl group; and n₄ represents an integer of 1 or more.)

n₄ is preferably an integer of 1 to 10 or less, more preferably an integer of 1 to 5, still more preferably an integer of 1 to 3, further preferably 1 or 2, and may be 1.

The compound represented by Formula (M2) may be a mixture of compounds with different n₄, and is preferably the mixture. It may be a mixture of compounds that differ in other moieties as described for the compound represented by Formula (M0). 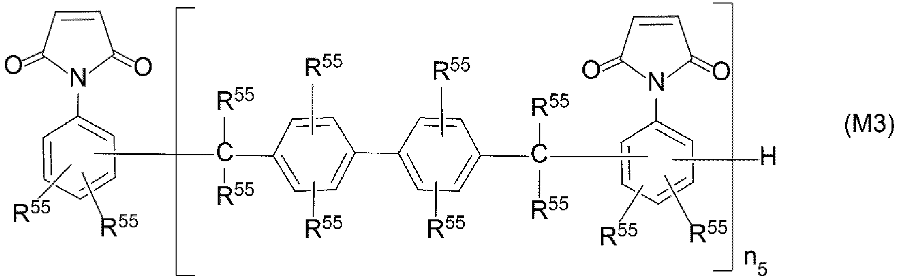 (In Formula (M3), R⁵⁵ each independently represents a hydrogen atom, an alkyl group with 1 to 8 carbons, or a phenyl group; and n₅ represents an integer of 1 or more and 10 or less.)

R⁵⁵ is preferably each independently a hydrogen atom, a methyl group, an ethyl group, a n-propyl group, an isopropyl group, a n-butyl group, an isobutyl group, a t-butyl group, a n-pentyl group, or a phenyl group, more preferably one of a hydrogen atom and a methyl group, and still more preferably a hydrogen atom.

n₅ is preferably an integer of 1 or more and 5 or less, more preferably an integer of 1 to 3, and even more preferably 1 or 2.

The compound represented by Formula (M3) may be a mixture of compounds with different n₅, and is preferably the mixture. It may be a mixture of compounds that differ in other moieties as described for the compound represented by Formula (M0). 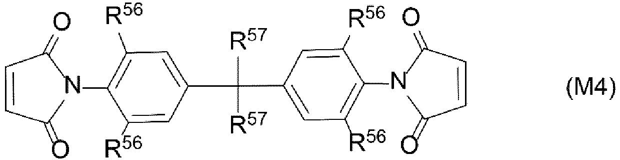 (In Formula (M4), R⁵⁶ each independently represents a hydrogen atom, a methyl group, or an ethyl group, and R⁵⁷ each independently represents a hydrogen atom or a methyl group.) 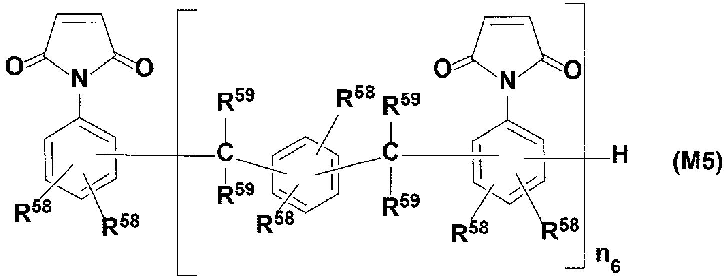 (In Formula (M5), R⁵⁸ each independently represents a hydrogen atom, an alkyl group having from 1 to 8 carbons, or a phenyl group; R⁵⁹ each independently represents a hydrogen atom or a methyl group; and n₆ represents an integer of 1 or more.)

R⁵⁸ is preferably each independently a hydrogen atom, a methyl group, an ethyl group, a n-propyl group, an isopropyl group, a n-butyl group, an isobutyl group, a t-butyl group, a n-pentyl group, or a phenyl group, more preferably one of a hydrogen atom and a methyl group, and still more preferably a hydrogen atom.

R⁵⁹ is preferably a methyl group.

n₆ is preferably an integer of 1 to 10, more preferably an integer of 1 to 5, even more preferably an integer of 1 to 3, and still more preferably 1 or 2, and may be 1.

The compound represented by Formula (M5) may be a mixture of compounds with different n₆, and is preferably the mixture. It may be a mixture of compounds that differ in other moieties as described for the compound represented by Formula (M0).

Apart from the description set forth above, regarding the maleimide compound, reference can be made to the compounds described in paragraphs [0061] to [0066] of WO 2020/262577 A and JP 7160151 B and the like, and the contents thereof are incorporated herein.

The maleimide compound may be produced by a known method, or a commercially available product may be used. Examples of the commercially available product include "BMI-80" (available from K.I Chemical Industry Co., Ltd.) as the compound represented by Formula (MO)," NE-X-9470 S" (available from DIC Corporation) as the compound represented by Formula (M1), "BMI-2300" (available from Daiwakasei Industry Co., LTD.) as the compound represented by Formula (M2), "MIR-3000" (available from Nippon Kayaku Co., Ltd.) as the compound represented by Formula (M3), "BMI-70" (available from K.I Chemical Industry Co., Ltd.) as the compound represented by Formula (M4), "MIR-5000" (available from Nippon Kayaku Co., Ltd.), "MIZ-001" (available from Nippon Kayaku Co., Ltd.), and "NE-X-9500" (available from DIC Corporation) as the compound represented by Formula (M5).

Examples of the maleimide compound other than those described above include N-phenylmaleimide, an oligomer of phenylmethane maleimide, m-phenylene bismaleimide, 2,2-bis(4-(4-maleimidophenoxy)-phenyl)propane, 4-methyl-1,3-phenylene bismaleimide, 1,6-bismaleimide-(2,2,4-trimethyl)hexane, 4,4'-diphenylether bismaleimide, 4,4'-diphenylsulfone bismaleimide, 1,3-bis(3-maleimidophenoxy)benzene, 1,3-bis(4-maleimidophenoxy)benzene, and prepolymers of these maleimide compounds, and prepolymers of these maleimide compounds and an amine.

When the resin composition of the present embodiment contains a maleimide compound, the lower limit value of the content of the maleimide compound is preferably 1 part by mass or more, more preferably 5 parts by mass or more, further more preferably 10 parts by mass or more, still more preferably 20 parts by mass or more, and even more preferably 25 parts by mass or more, per 100 parts by mass of the resin solid content in the resin composition. When the content of the maleimide compound is 1 part by mass or more, the flame resistance of the resulting cured product tends to improve. The upper limit value of the content of the maleimide compound is preferably 70 parts by mass or less, more preferably 60 parts by mass or less, still more preferably 50 parts by mass or less, and may be 40 parts by mass or less, per 100 parts by mass of the resin solid content in the resin composition. When the content of the maleimide compound is 70 parts by mass or less, the peel strength of metal foil and the low water absorbability tend to improve.

The resin composition of the present embodiment may contain only one of, or two or more of the maleimide compounds. When two or more of them are contained, the total amount thereof is preferably within the range set forth above.

### <<<Cyanate ester compound>>>

The resin composition of the present embodiment may contain a cyanate ester compound.

The cyanate ester compound is not particularly limited as long as it is a compound containing one or more (preferably 2 or more, more preferably 2 to 12, further more preferably 2 to 6, still more preferably 2 to 4, even more preferably 2 or 3, even still more preferably 2) cyanate groups (cyanato groups) per molecule, and a wide variety of compounds commonly used in the field of printed wiring boards can be used. The cyanate ester compound is preferably a compound in which the cyanate group is directly bonded to an aromatic backbone (aromatic ring).

Examples of the cyanate ester compound include at least one selected from the group consisting of phenol novolac-type cyanate ester compounds, naphthol aralkyl-type cyanate ester compounds (naphthol aralkyl-type cyanates), naphthylene ether-type cyanate ester compounds, biphenyl aralkyl-type cyanate ester compounds, xylene resin-type cyanate ester compounds, tris phenol methane-type cyanate ester compounds, adamantane backbone-type cyanate ester compounds, bisphenol M-type cyanate ester compounds, bisphenol A-type cyanate ester compounds, and diallyl bisphenol A-type cyanate ester compounds. Among these, in terms of further improving the low water absorption of the resulting cured product, the cyanate ester compound is preferably at least one selected from the group consisting of phenol novolac-type cyanate ester compounds, naphthol aralkyl-type cyanate ester compounds, naphthylene ether-type cyanate ester compounds, xylene resin-type cyanate ester compounds, bisphenol M-type cyanate ester compounds, bisphenol A-type cyanate ester compounds, and diallyl bisphenol A-type cyanate ester compounds, more preferably at least one selected from the group consisting of phenol novolac-type cyanate ester compounds and naphthol aralkyl-type cyanate ester compounds, and even more preferably naphthol aralkyl-type cyanate ester compounds. Such a cyanate ester compound may be prepared by a known method, or a commercially available product may be used. Note that, a cyanate ester compound having a naphthol aralkyl backbone, a naphthylene ether backbone, a xylene backbone, a trisphenol methane backbone, or an adamantane backbone has a relatively large number of functional group equivalents and will have a small number of unreacted cyanate ester groups, and thus cured products of the resin compositions using these cyanate ester compounds tend to be even more excellent in low water absorption. Moreover, the resin composition tends to have a further improved plating adhesion, mainly because of having an aromatic skeleton or an adamantane skeleton.

The naphthol aralkyl-type cyanate ester compound is preferably a compound represented by Formula (1) below. 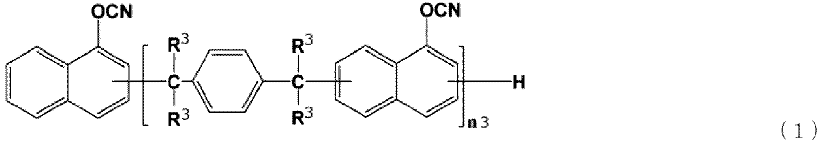 (In Formula (1), R³ each independently represents a hydrogen atom or a methyl group, and n3 represents an integer of 1 or more.)

In Formula (1), R³ each independently represents a hydrogen atom or a methyl group, and among these, a hydrogen atom is preferable.

In Formula (1), n3 is an integer of 1 or more, and preferably an integer of 1 to 20, more preferably an integer of 1 to 10, and even more preferably an integer of 1 to 6.

The novolac-type cyanate ester compound is not particularly limited, but, for example, is preferably a compound represented by Formula (VII) below: 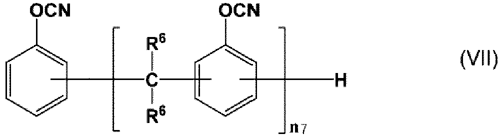 (In Formula (VII), R⁶ each independently represents a hydrogen atom or a methyl group; and n7 represents an integer of 1 or more.)

In Formula (VII), R⁶ each independently represents a hydrogen atom or a methyl group, and among these a hydrogen atom is preferable.

In Formula (VII), n7 is an integer of 1 or more, and preferably an integer of 1 to 20, more preferably an integer of 1 to 10, and further more preferably an integer of 1 to 6.

As the bisphenol A-type cyanate ester compound, one or more selected from the group consisting of 2,2-bis(4-cyanatophenyl)propane and a prepolymer of 2,2-bis(4-cyanatophenyl) propane may be used.

The resin composition according to the present embodiments preferably contains the cyanate ester compound to such an extent that the effects of the present invention are not compromised. When the resin composition of the present embodiment contains a cyanate ester compound, the lower limit value of the content thereof is preferably 0.1 parts by mass or more, more preferably 0.2 parts by mass or more, and still more preferably 0.5 parts by mass or more per 100 parts by mass of the resin solid content in the resin composition, and may be 3 parts by mass or more, 5 parts by mass or more, or 10 parts by mass or more depending on the intended use. With the content of the cyanate ester compound being 0.1 part by mass or more, the resulting cured product tends to improve in thermal resistance, combustion resistance, chemical resistance, low relative permittivity, low dielectric dissipation factor, and insulation. When the resin composition of the present embodiment contains a cyanate ester compound, the upper limit value of the content of the cyanate ester compound is preferably 70 parts by mass or less, more preferably 50 parts by mass or less, further more preferably 40 parts by mass or less, still more preferably 30 parts by mass or less, and even more preferably 20 parts by mass or less per 100 parts by mass of the resin solid content in the resin composition, and may be 10 parts by mass or less, 5 parts by mass or less, or 3 parts by mass or less depending on the intended use.

The resin composition in the present embodiment may contain only one of, or two or more of the cyanate ester compounds. When two or more of them are contained, the total amount thereof is preferably within the range set forth above.

### <<<Epoxy compound>>>

The resin composition of the present embodiment may contain an epoxy compound.

The epoxy compound is not particularly limited as long as it is a compound or resin having one or more (preferably from 2 to 12, more preferably from 2 to 6, even more preferably from 2 to 4, still more preferably 2 or 3, and yet more preferably 2) epoxy groups per molecule, and a wide variety of compounds commonly used in the field of printed wiring boards can be used.

Examples of the epoxy compound include bisphenol A-type epoxy resins, bisphenol E-type epoxy resins, bisphenol F-type epoxy resins, bisphenol S-type epoxy resins, phenol novolac-type epoxy resins, bisphenol A novolac-type epoxy resins, glycidyl ester-type epoxy resins, aralkyl novolac-type epoxy resins, biphenyl aralkyl-type epoxy resins, naphthylene ether-type epoxy resins, cresol novolac-type epoxy resins, multifunctional phenol-type epoxy resins, naphthalene-type epoxy resins, anthracene-type epoxy resins, naphthalene skeleton-modified novolac-type epoxy resins, phenol aralkyl-type epoxy resins, naphthol aralkyl-type epoxy resins, dicyclopentadiene-type epoxy resins, biphenyl-type epoxy resins, alicyclic epoxy resins, polyol-type epoxy resins, phosphorus-containing epoxy resins, glycidyl amine, glycidyl ester, compounds obtained from an epoxidation of a double bond in butadiene or the like, and compounds obtained from a reaction of a hydroxyl group-containing silicone resin with epichlorohydrin. The use of such a compound improves the moldability and adhesion of the resin composition. Among these, the epoxy compound is preferably a biphenyl aralkyl-type epoxy resin, a naphthylene ether-type epoxy resin, a multifunctional phenol-type epoxy resin, or a naphthalene-type epoxy resin, and more preferably a biphenyl aralkyl-type epoxy resin, in terms of further improving the flame resistance and thermal resistance.

The resin composition of the present embodiment preferably contains the epoxy compound to such an extent that the effects of the present invention are not compromised. When the resin composition according to the present embodiments contains the epoxy compound, the content of the epoxy compound is preferably 0.1 parts by mass or more, more preferably 1 part by mass or more, and even more preferably 2 parts by mass or more per 100 parts by mass of the resin solid content in the resin composition. When the content of the epoxy compound is 0.1 parts by mass or more, the peel strength of metal foil and toughness tend to improve. When the resin composition of the present embodiment contains the epoxy compound, the upper limit value of the content of the epoxy compound is preferably 50 parts by mass or less, more preferably 30 parts by mass or less, still more preferably 20 parts by mass or less, and even more preferably 10 parts by mass or less, and may be 8 parts by mass or less, or 5 parts by mass or less, per 100 parts by mass of the resin solid content in the resin composition. With the content of the epoxy compound being 50 parts by mass or less, the resulting cured product tends to improve in electrical properties.

The resin composition of the present embodiment may contain only one of, or two or more of the epoxy compounds. When two or more of them are contained, the total amount thereof is preferably within the range set forth above.

Alternatively, the resin composition of the present embodiment may be configured to be substantially free from any epoxy compound. The wording "substantially free" means that the content of the epoxy compound is less than 0.1 parts by mass per 100 parts by mass of the resin solid content in the resin composition, and the content is preferably less than 0.01 parts by mass, and may be less than 0.001 parts by mass.

### <<<Phenolic compound>>>

The resin composition of the present embodiment may contain a phenolic compound.

The phenolic compound is any phenolic compound having one or more (preferably from 2 to 12, more preferably from 2 to 6, even more preferably from 2 to 4, still more preferably 2 or 3, and yet more preferably 2) phenolic hydroxyl groups per molecule and is not particularly limited, and a wide variety of compounds commonly used in the field of printed wiring boards can be used.

Examples of the phenolic compound include bisphenol A-type phenolic resins, bisphenol E-type phenolic resins, bisphenol F-type phenolic resins, bisphenol S-type phenolic resins, phenol novolac resins, bisphenol A novolac-type phenolic resins, glycidyl ester-type phenolic resins, aralkyl novolac phenolic resins, biphenyl aralkyl-type phenolic resins, cresol novolac-type phenolic resins, multifunctional phenolic resins, naphthol resins, naphthol novolac resins, multifunctional naphthol resins, anthracene-type phenolic resins, naphthalene skeleton-modified novolac-type phenolic resins, phenol aralkyl-type phenolic resins, naphthol aralkyl-type phenolic resins, dicyclopentadiene-type phenolic resins, biphenyl-type phenolic resins, alicyclic phenolic resins, polyol-type phenolic resins, phosphorus-containing phenolic resins, and hydroxyl group-containing silicone resins. Among these, in terms of further improving the flame resistance of the resulting cured product, the phenolic compound is preferably at least one selected from the group consisting of biphenyl aralkyl-type phenolic resins, naphthol aralkyl-type phenolic resins, phosphorus-containing phenolic resins, and hydroxyl group-containing silicone resins.

The resin composition of the present embodiment preferably contains the phenolic compound to such an extent that the effects of the present invention are not compromised. When the resin composition of the present embodiment contains the phenolic compound, the content of the phenolic compound is preferably 0.1 parts by mass or more and preferably 50 parts by mass or less per 100 parts by mass of the resin solid content in the resin composition.

The resin composition of the present embodiment may contain only one of, or two or more of the phenolic compounds. When two or more of them are contained, the total amount thereof is preferably within the range set forth above.

Alternatively, the resin composition of the present embodiment may be configured to be substantially free from any phenolic compounds. The wording "substantially free" means that the content of the phenolic compound is less than 0.1 parts by mass per 100 parts by mass of the resin solid content in the resin composition.

### <<<Oxetane resin>>>

The resin composition of the present embodiment may contain an oxetane resin.

The oxetane resin is not particularly limited as long as it is a compound having one or more (preferably from 2 to 12, more preferably from 2 to 6, even more preferably from 2 to 4, still more preferably 2 or 3, and yet more preferably 2) oxetanyl groups, and a wide variety of compounds commonly used in the field of printed wiring boards can be used.

Examples of the oxetane resin include oxetane, alkyl oxetane (such as 2-methyloxetane, 2,2-dimethyloxetane, 3-methyloxetane, 3,3-dimethyloxetane, etc.), 3-methyl-3-methoxymethyl oxetane, 3,3-di(trifluoromethyl)oxetane, 2-chloromethyl oxetane, 3,3-bis(chloromethyl)oxetane, biphenyl type oxetane, OXT-101 (available from Toagosei Co., Ltd.), and OXT-121 (available from Toagosei Co., Ltd.).

The resin composition of the present embodiment preferably contains the oxetane resin to such an extent that the effects of the present invention are not compromised. When the resin composition of the present embodiment contains the oxetane resin, the content of the oxetane resin is preferably 0.1 parts by mass or more, more preferably 1 part by mass or more, and even more preferably 2 parts by mass or more, per 100 parts by mass of the resin solid content in the resin composition. With the content of the oxetane resin being 0.1 parts by mass or more, the peel strength of metal foil and toughness tend to improve. When the resin composition of the present embodiment contains an oxetane resin, the upper limit value of the content of the oxetane resin is preferably 50 parts by mass or less, more preferably 30 parts by mass or less, still more preferably 20 parts by mass or less, even more preferably 10 parts by mass or less, and may be 8 parts by mass or less, per 100 parts by mass of the resin solid content in the resin composition. With the content of the oxetane resin being 50 parts by mass or less, the resulting cured product tend to improve in electrical properties.

The resin composition of the present embodiment may contain only one of, or two or more of the oxetane resins. When two or more of them are contained, the total amount thereof is preferably within the range set forth above.

Alternatively, the resin composition of the present embodiment may be configured to be substantially free from any oxetane resin. The wording "substantially free" means that the content of the oxetane resin is less than 0.1 parts by mass per 100 parts by mass of the resin solid content in the resin composition.

### <<<Benzoxazine compound>>>

The resin composition of the present embodiment may contain a benzoxazine compound.

The benzoxazine compound is not particularly limited as long as it is a compound having two or more (preferably from 2 to 12, more preferably from 2 to 6, even more preferably from 2 to 4, still more preferably 2 or 3, and yet more preferably 2) dihydrobenzoxazine rings per molecule, and a wide variety of compounds commonly used in the field of printed wiring boards can be used.

Examples of the benzoxazine compound include bisphenol A type benzoxazine BA-BXZ (available from Konishi Chemical Ind. Co., Ltd.), bisphenol F type benzoxazine BF-BXZ (available from Konishi Chemical Ind. Co., Ltd.), and bisphenol S type benzoxazine BS-BXZ (available from Konishi Chemical Ind. Co., Ltd.).

The resin composition of the present embodiment preferably contains the benzoxazine compound to such an extent that the effects of the present invention are not compromised. When the resin composition of the present embodiment contains the benzoxazine compound, the content of the benzoxazine compound is preferably 0.1 parts by mass or more and preferably 50 parts by mass or less per 100 parts by mass of the resin solid content in the resin composition.

The resin composition of the present embodiment may contain only one of, or two or more of the benzoxazine compounds. When two or more of them are contained, the total amount thereof is preferably within the range set forth above.

Alternatively, the resin composition of the present embodiment may be configured to be substantially free from any benzoxazine compound. The wording "substantially free" means that the content of the benzoxazine compound is less than 0.1 parts by mass per 100 parts by mass of the resin solid content in the resin composition.

### <<Compound containing (meth)allyl group>>

The resin composition of the present embodiment preferably contains a compound containing a (meth)allyl group, and more preferably contains a compound containing an allyl group.

The compound containing a (meth)allyl group is preferably a compound containing two or more (meth)allyl groups, and more preferably a compound containing two or more allyl groups.

The compound containing a (meth)allyl group preferably includes at least one selected from the group consisting of an allyl isocyanurate compound, an allyl group-substituted nadimide compound, an allyl compound having a glycoluril structure, and diallyl phthalate, more preferably includes at least one selected from the group consisting of an allyl isocyanurate compound, an allyl group-substituted nadimide compound, and an allyl compound having a glycoluril structure, even more preferably includes an allyl group-substituted nadimide compound, and an alkenyl-substituted nadimide compound is further preferable.

The alkenyl-substituted nadimide compound is not particularly limited as long as the compound has one or more alkenyl-substituted nadimide groups per molecule. Among these, a compound represented by Formula (AN-1) is preferred. With the use of such an alkenyl-substituted nadimide compound, the coefficient of thermal expansion and the thermal resistance of the resulting cured product tend to be further improved. 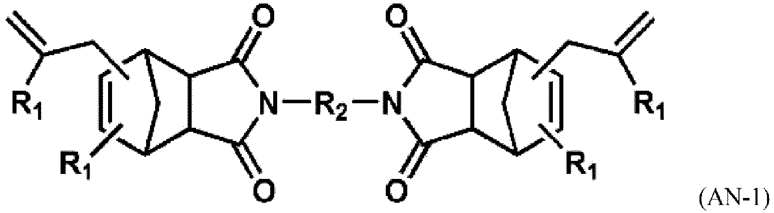 (In Formula (AN-1), R₁ each independently represents a hydrogen atom or an alkyl group having from 1 to 6 carbon atoms; and R₂ represents an alkylene group having from 1 to 6 carbon atoms, a phenylene group, a biphenylene group, a naphthylene group, a group represented by Formula (AN-2), or a group represented by Formula (AN-3). 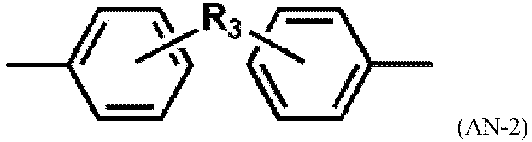 (In Formula (AN-2), R₃ represents a methylene group, an isopropylidene group, -C(=O)-, -O-, -S-, or -S(=O)₂-.) 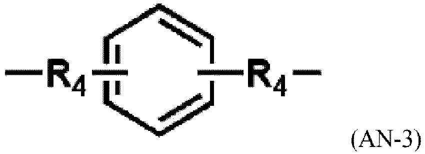 (In Formula (AN-3), R₄ each independently represents an alkylene group having from 1 to 4 carbon atoms or a cycloalkylene group having from 5 to 8 carbon atoms.)

Among the compounds represented by Formula (AN-1), a compound represented by Formula (AN-4) and a compound represented by Formula (AN-5) are preferable. With the use of such an alkenyl-substituted nadimide compound, the coefficient of thermal expansion and the thermal resistance of the resulting cured product tend to be further improved.

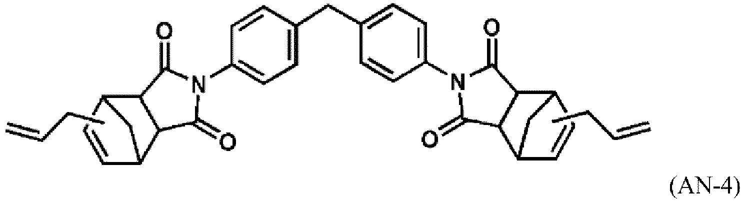

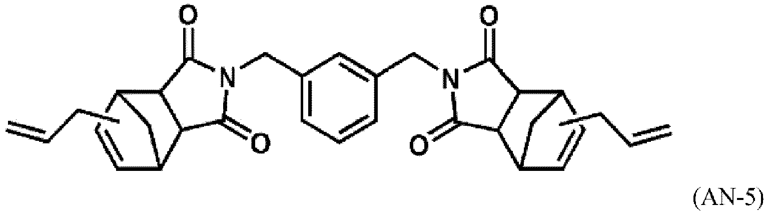

In addition, a commercially available product can be used as the alkenyl-substituted nadimide compound. Examples of commercially available products include, but are not particularly limited to, BANI-M (a compound represented by Formula (AN-4), available from Maruzen Petrochemical Co., Ltd.) and BANI-X (a compound represented by Formula (AN-5), available from Maruzen Petrochemical Co., Ltd.).

The resin composition of the present embodiment preferably contains a compound containing a (meth)allyl group (preferably, alkenyl-substituted nadimide compounds) to such an extent that the effect of the present invention is not compromised. When the resin composition of the present embodiment contains a compound containing a (meth)allyl group (Preferably, alkenyl-substituted nadimide compounds), the content thereof is preferably 0.1 parts by mass or more and preferably 50 parts by mass or less, per 100 parts by mass of the resin solid content in the resin composition.

The resin composition in the present embodiment may contain only one of, or two or more of the compounds containing a (meth)allyl group (Preferably, alkenyl-substituted nadimide compounds). When two or more of them are contained, the total amount thereof is preferably within the range set forth above.

Alternatively, the resin composition in the present embodiment may be configured to be substantially free from any alkenyl-substituted nadimide compound (moreover, compounds containing (meth)allyl groups). The wording "substantially free" means that the content of the alkenyl-substituted nadimide compound (moreover, compounds containing (meth)allyl groups) is less than 0.1 parts by mass per 100 parts by mass of the resin solid content in the resin composition.

The content (total amount) of the thermosetting resin in the resin composition of the present embodiment is preferably 3 parts by mass or more, more preferably 5 parts by mass or more, further more preferably 10 parts by mass or more, still more preferably 20 parts by mass or more, even more preferably 30 parts by mass or more, yet even more preferably 40 parts by mass or more, and may be 50 parts by mass or more, per 100 parts by mass of the resin solid content. When the content of the thermosetting resin is adjusted to be greater than or equal to the lower limit value, thermal resistance, plating adhesion, and low thermal expansion tend to be further improved. The upper limit value of the content of the thermosetting resin is preferably 95 parts by mass or less, more preferably 90 parts by mass or less, still more preferably 85 parts by mass or less, even more preferably 75 parts by mass or less, yet even more preferably 70 parts by mass or less, and may be 65 parts by mass or less, per 100 parts by mass of the resin solid content. When the content of the thermosetting resin is adjusted to be less than or equal to the upper limit value, the low dielectric properties and low water absorption tend to be further improved.

The resin composition of the present embodiment may contain only one of, or two or more of thermosetting resins. When two or more of them are contained, the total amount thereof is preferably within the range set forth above.

### <<Inorganic filler>>

The resin composition of the present embodiment need not contain an inorganic filler, but may contain an inorganic filler.

With an inorganic filler being contained, the resin composition or a cured product thereof can be further improved in physical properties such as dielectric properties (low permittivity, low dielectric dissipation factor, etc.), flame resistance, and low thermal expansion. With reduced content of the inorganic filler, delamination between the resin composition layer and the metal foil, and delamination and blister at the interface between the resin composition layer and the circuit board can more effectively suppressed.

The inorganic filler to be used in the present embodiment is more preferably an inorganic filler excellent in low dielectric properties. For example, the inorganic filler to be used in the present embodiment preferably has a relative permittivity (Dk) of 8.0 or less, more preferably 6.0 or less, and still more preferably 4.0 or less as measured according to the resonance cavity perturbation method. The lower limit value of the relative permittivity is practically at least 2.0, for example. The inorganic filler to be used in the present embodiment preferably has a dielectric dissipation factor (Df) of 0.05 or less, and more preferably 0.01 or less, as measured according to the resonance cavity perturbation method. The lower limit value of the dielectric dissipation factor is practically at least 0.0001, for example.

The average particle diameter (D50) of the inorganic filler is not particularly limited, but is preferably 0.1 µm or more, and more preferably 0.5 µm or more. In terms of dispersibility, the inorganic filler preferably has an average particle diameter (D50) of 5 µm or less, and more preferably of 3 µm or less.

Note that, the average particle diameter (D50) means a value at which a cumulative value by volume reaches 50% of the total volume from small particles in the particle size distribution for a predetermined amount of powder added to a dispersion medium, measured by using a particle size distribution measuring apparatus based on a laser diffraction/scattering method or the like. When the resin composition contains a solvent, the dispersion medium here means this solvent.

The type of the inorganic filler to be used in the present embodiment is not particularly limited, and those generally used in the art can be suitably used. Specific examples of the inorganic fillers include silica, such as natural silica, fused silica, synthetic silica, amorphous silica, Aerosil, and hollow silica; metal oxides, such as alumina, white carbon, titanium white, titanium oxide, zinc oxide, magnesium oxide, and zirconium oxide; composite oxide, such as zinc borate, zinc stannate, forsterite, barium titanate, strontium titanate, and calcium titanate; nitrides, such as boron nitride, aggregated boron nitride, silicon nitride, and aluminum nitride; metal hydroxides (including hydrates), such as aluminum hydroxide, a heat-treated product of aluminum hydroxide (a heat-treated aluminum hydroxide having a part of the crystalline water reduced), boehmite, and magnesium hydroxide; molybdenum compounds, such as molybdenum oxide and zinc molybdate; and barium sulfate, clay, kaolin, talc, calcined clay, calcined kaolin, calcined talc, mica, E-glass, A-glass, NE-glass, C-glass, L-glass, D-glass, S-glass, M-glass G20, glass short fibers (including glass fine powders of E glass, T glass, D glass, S glass, Q glass, etc.), hollow glass, and spherical glass.

**In** the present embodiment, the inorganic filler preferably contains one or more selected from the group consisting of silica, aluminum hydroxide, aluminum nitride, boron nitride, forsterite, titanium oxide, barium titanate, strontium titanate, and calcium titanate, more preferably contains one or more selected from the group consisting of silica and aluminum hydroxide in terms of low dielectric properties, and still more preferably contains silica. With the use of these inorganic fillers, the cured product of the resin composition is improved in characteristics such as thermal resistance, dielectric properties, thermal expansion characteristics, dimensional stability, and flame retardancy.

The content of the inorganic filler in the resin composition of the present embodiment can be appropriately set according to desired characteristics, and is not particularly limited, but is 0 parts by mass or more, preferably 10 parts by mass or more, and more preferably 20 parts by mass or more, per 100 parts by mass of the resin solid content in the resin composition. When the content of the inorganic filler is adjusted to be greater than or equal to the lower limit value, low thermal expansion and low dielectric dissipation factor properties tend to be further improved. The upper limit value of the content of the inorganic filler is preferably 250 parts by mass or less, more preferably 200 parts by mass or less, still more preferably 180 parts by mass or less, and even more preferably 150 parts by mass or less, and may be 120 parts by mass or less, 100 parts by mass or less, 80 parts by mass or less, or 60 parts by mass or less, per 100 parts by mass of the resin solid content. When the content of the inorganic filler is adjusted to be less than or equal to the upper limit value, delamination and blister at the interface between the resin composition layer and the circuit board can be more effectively suppressed, and also moldability tends to be further improved.

In the resin composition of the present embodiment, as one example of a preferred embodiment, mention may be made of an aspect in which the content of the inorganic filler accounts for 10 mass% to 70 mass% (preferably from 15 mass% to 65 mass%) of the components excluding the solvent.

The resin composition of the present embodiment may contain only one of, or two or more of the inorganic fillers. When two or more of them are contained, the total amount thereof is preferably within the range set forth above.

The resin composition of the present embodiment may further contain a silane coupling agent. When the silane coupling agent is contained, the dispersibility of the inorganic filler tends to be further improved and the adhesive strength between the resin component and the inorganic filler tends to be further improved.

The silane coupling agent is not particularly limited, mention may be made of silane coupling agents commonly used in surface treatment of inorganic materials, and examples thereof include aminosilane-based compounds (such as γ-aminopropyltriethoxysilane, N-β-(aminoethyl)-γ-aminopropyltrimethoxysilane etc.), epoxysilane-based compounds (such as γ-glycidoxypropyltrimethoxysilane etc.), vinylsilane-based compounds (such as vinyltrimethoxysilane etc.), styrylsilane-based compounds (such as styryltrimethoxysilane etc.), acrylsilane-based compounds (such as γ-acryloxypropyltrimethoxysilane etc.), cationic silane-based compounds (such as N-β-(N-vinylbenzylaminoethyl)-γ-aminopropyltrimethoxysilane hydrochloride etc.), and phenylsilane-based compounds. One of the silane coupling agents may be used singly, or two or more of the silane coupling agents may be used in combination. Among these, the silane coupling agent is preferably an epoxysilane-based compound. Examples of the epoxysilane-based compound include "KBM-403", "KBM-303", "KBM-402", and "KBE-403", which are products available from Shin-Etsu Chemical Co., Ltd.

The content of the silane coupling agent is not particularly limited, but may be from 0.1 to 5.0 parts by mass per 100 parts by mass of resin solid content.

The resin composition of the present embodiment may contain an organic filler. Examples of the organic filler include rubber powders such as styrene type-, butadiene type-, and acrylic type-rubber powder, core-shell type rubber powders, silicone resin powders, silicone rubber powders, silicone composite powders, and fluororesin fillers.

In the present embodiment, the resin composition is preferably substantially free from any organic filler. The wording "substantially free" means that the content of the organic filler accounts for 10 mass% or less, preferably 5 mass% or less, more preferably 3 mass% or less, and still more preferably 1 mass% or less of the content of the inorganic filler.

### <<Monomer or oligomer having ethylenically unsaturated group>>

In the resin composition of the present embodiment, a monomer or an oligomer having an ethylenically unsaturated group can be concomitantly used in order to enhance thermosetting properties, low dielectric properties, and curability with active energy rays (such as photocuring properties with ultraviolet rays, etc.). The oligomer or monomer having an ethylenically unsaturated group to be used in the present embodiments is not particularly limited as long as it is an oligomer or monomer having one or more ethylenically unsaturated groups per molecule, and examples thereof include a monomer or oligomer having a (meth)acryloyl group, a vinyl group, or the like.

Note that, as used herein, a compound corresponding to a monomer or oligomer having an ethylenically unsaturated group and also corresponding to a polyphenylene ether compound with a terminal unsaturated carbon-carbon double bond is referred to as a polyphenylene ether compound with a terminal unsaturated carbon-carbon double bond.

The resin composition of the present embodiment may contain a low molecular weight vinyl compound having a molecular weight of less than 1000 and containing an ethylenically unsaturated group (hereinafter, simply referred to as a "the low molecular weight vinyl compound" in some cases) as a monomer or oligomer having an ethylenically unsaturated group. Blending of the low molecular weight vinyl compound tends to further improve the moisture absorption thermal resistance of the resulting cured product.

The low molecular weight vinyl compound to be used in the present embodiment is preferably composed only of atoms selected from the group consisting of a carbon atom, a hydrogen atom, an oxygen atom, a nitrogen atom, and a silicon atom, more preferably composed only of atoms selected from the group consisting of a carbon atom, a hydrogen atom, an oxygen atom, and a silicon atom, and even more preferably composed only of atoms selected from the group consisting of a carbon atom, a hydrogen atom, and an oxygen atom.

The low molecular weight vinyl compound to be used in the present embodiment may have a polar group, or may have no polar group. The low molecular weight vinyl compound to be used in the present embodiment preferably has no polar group. Examples of the polar group include an amino group, a carboxyl group, a hydroxy group, and a nitro group.

In the present embodiment, the molecular weight of the low molecular weight vinyl compound is preferably 70 or more, more preferably 80 or more, and even more preferably 90 or more. there is a tendency that when the low molecular weight vinyl compound has a molecular weight greater than or equal to the lower limit value, the volatilization of the low molecular weight vinyl compound from the resin composition of the present embodiment, from a cured product thereof, or the like, tends to be suppressed. The upper limit value of the molecular weight of the low molecular weight vinyl compound is preferably 500 or less, more preferably 400 or less, even more preferably 300 or less, and still more preferably 200 or less, and may be 150 or less. When the low molecular weight vinyl compound has a molecular weight less than or equal to the upper limit value, an effect of enhancing the reactivity with the polymer (V) having a constitutional unit represented by Formula (V) tends to be further improved.

When the resin composition of the present embodiment contains two or more of the low molecular weight vinyl compounds, the average molecular weight value of the low molecular weight vinyl compounds is preferably within the range set forth above, and the molecular weight of each compound is more preferably within the above preferred range.

In the present embodiment, a boiling point of the low molecular weight vinyl compound is preferably 110°C or higher, more preferably 115°C or higher, and still more preferably 120°C or higher. With the boiling point being at least the lower limit value, volatilization of the low molecular weight vinyl compound can be suppressed during heat curing of the resin composition, and the low molecular weight vinyl compound is allowed to more effectively react with the vinyl group contained in the polymer (V) having a constitutional unit represented by Formula (V). The boiling point of the low molecular weight vinyl compound is preferably 300°C or lower, more preferably 250°C or lower, and still more preferably 200°C or lower. With the boiling point being the upper limit value or less, the low molecular weight vinyl compound is less likely to remain as a residual solvent in the cured product.

When the resin composition of the present embodiment contains two or more of the low molecular weight vinyl compounds, the average value of the boiling points is required to be within the range set forth above, but the boiling points of the respective compounds each are preferably within the preferred range.

Examples of the low molecular weight vinyl compound include a (meth)acrylate compound, an aromatic vinyl compound (preferably a styrene-based compound), a saturated fatty acid vinyl compound, a vinyl cyanide compound, an ethylenically unsaturated carboxylic acid, an ethylenically unsaturated carboxylic acid anhydride, an ethylenically unsaturated dicarboxylic acid monoalkyl ester, an ethylenically unsaturated carboxylic acid amide, a vinyl silane compound (such as vinyltrialkoxysilane etc.), an acrylic silane compound (such as acrylic trialkoxysilane etc.), a methacrylic silane compound (such as methacrylic trialkoxysilane etc.), and a styryl silane compound (such as styryl trialkoxysilane etc.).

A first form of the low molecular weight vinyl compound is at least one selected from the group consisting of (meth)acrylate compounds, aromatic vinyl compounds, saturated fatty acid vinyl compounds, vinyl cyanide compounds, ethylenically unsaturated carboxylic acids, ethylenically unsaturated carboxylic acid anhydrides, ethylenically unsaturated dicarboxylic acid monoalkyl esters, and ethylenically unsaturated carboxylic amides.

A second form of the low molecular weight vinyl compound is at least one selected from the group consisting of a (meth)acrylic acid ester compound, an aromatic vinyl compound, a saturated fatty acid vinyl compound, a vinylsilane compound, an acrylsilane compound, a methacrylic silane compound and a styrylsilane compound, and an aromatic vinyl compound and/or a vinylsilane compound is preferred.

Specific examples of the low molecular weight vinyl compound include methylstyrene, ethylvinylbenzene, vinyltrimethoxysilane, and vinyltriethoxysilane.

In the resin composition of the present embodiment, the monomer or oligomer having an ethylenically unsaturated group is preferably a methylstyrene monomer and/or a styrene oligomer. Regarding the details of the styrene oligomers, reference may be made to paragraph [0065] to [0067] of WO 2019/230945, the contents thereof are incorporated herein. Examples of the methylstyrene monomer include 4-methylstyrene.

Apart from the description set forth above, regarding details of the monomer or oligomer having an ethylenically unsaturated group, reference may be made to the description in paragraphs [0069] to [0087] of WO 2017/135168, and the contents thereof are incorporated herein.

When the resin composition of the present embodiment contains a monomer or oligomer having an ethylenically unsaturated group, the content thereof is preferably 0.5 parts by mass or more, more preferably 1 part by mass or more, still more preferably 2 parts by mass or more, and even more preferably 3 parts by mass or more per 100 parts by mass of the resin solid content. When the content is adjusted to be greater than or equal to the lower limit value, the low dielectric properties tend to be further improved. The upper limit value of the content of the monomer or oligomer having an ethylenically unsaturated group is preferably 25 parts by mass or less, more preferably 20 parts by mass or less, and still more preferably 10 parts by mass or less per 100 parts by mass of the resin solid content. When the content is adjusted to be less than or equal to the upper limit value, the thermal resistance tends to be further improved.

The resin composition of the present embodiment may contain only one of, or two or more of the monomer or oligomer having an ethylenically unsaturated group. When two or more of them are contained, the total amount thereof is preferably within the range set forth above.

### <<Elastomer>>

The resin composition of the present embodiment may contain an elastomer.

In the present embodiment, the elastomer is not particularly limited, and examples include at least one selected from the group consisting of polyisoprene, polybutadiene, styrene-butadiene, butyl rubber, ethylene-propylene rubber, styrene-butadiene-ethylene, styrene-butadiene-styrene, styrene-isoprene-styrene, styrene-ethylene-butylene-styrene, styrene-propylene-styrene, styrene-ethylene-propylene-styrene, fluoro-rubber, silicone rubber, hydrogenated compounds thereof, alkyl compounds thereof, and copolymers thereof.

The elastomer may be a thermoplastic elastomer or a thermosetting elastomer, but is preferably a thermoplastic elastomer.

The number average molecular weight of the elastomer to be used in the present embodiment is preferably 50000 or greater. When the elastomer has a number average molecular weight of 50000 or greater, the resulting cured product tends to be more excellent in low dielectric properties. The number average molecular weight is preferably 60000 or greater, more preferably 70000 or greater, and even more preferably 80000 or greater. The upper limit value of the number average molecular weight of the thermal elastomer is preferably 400000 or less, more preferably 350000 or less, and even more preferably 300000 or less. When the elastomer has a number average molecular weight less than or equal to the upper limit value, the solubility of the elastomer component in the resin composition tends to improve.

When the resin composition of the present embodiment contains two or more of the elastomers, the number average molecular weight of their mixture preferably within the range set forth above.

In the present embodiment, the elastomer is preferably a thermoplastic elastomer containing a styrene monomer unit and a conjugated diene monomer unit (hereinafter referred to as "thermoplastic elastomer (E)"). When such a thermoplastic elastomer (E) is used, the resultant cured product is more excellent in low dielectric properties.

The thermoplastic elastomer (E) contains a styrene monomer unit. When the thermoplastic elastomer (E) contains a styrene monomer unit, the solubility of the thermoplastic elastomer (E) in the resin composition is improved. Examples of the styrene monomer include styrene, α-methylstyrene, p-methylstyrene, divinylbenzene(vinylstyrene), N,N-dimethyl-p-aminoethyl styrene, and N,N-diethyl-p-aminoethyl styrene, among these, one or more selected from the group consisting of styrene, α-methylstyrene, and p-methylstyrene is preferable in terms of availability and productivity. Among them, styrene is particularly preferable.

The content of the styrene monomer unit in the thermoplastic elastomer (E) is preferably in a range of from 10 to 50 mass%, more preferably in a range of from 13 to 45 mass%, and even more preferably in a range of from 15 to 40 mass% of all the monomer units. When the content of the styrene monomer unit is 50 mass% or less, adhesion and tackiness to a base material or the like are further improved. The content of the styrene monomer unit is preferably 10 mass% or greater, because an increase in adhesiveness can be suppressed, an adhesive residue or a stop mark is less likely to occur, and easy release property between adhesive faces tends to improve.

The thermoplastic elastomer (E) may contain only one of, or two or more of the styrene monomer units. When two or more of the styrene monomer units are contained, the total amount thereof is preferably within the range set forth above.

Not that, regarding the measurement method of the content of the styrene monomer unit in the thermoplastic elastomer (E), reference can be made to WO 2017/126469, and the contents thereof are incorporated herein. The same shall apply to the conjugated diene monomer unit described below.

The thermoplastic elastomer (E) contains a conjugated diene monomer unit. When the thermoplastic elastomer (E) contains a conjugated diene monomer unit, the solubility of the thermoplastic elastomer (E) in the resin composition is improved. The conjugated diene monomer is not particularly limited as long as it is a diolefin having a pair of conjugated double bonds. Examples of the conjugated diene monomer include 1,3-butadiene, 2-methyl-1,3-butadiene (isoprene), 2,3-dimethyl-1,3-butadiene, 1,3-pentadiene, 2-methyl-1,3-pentadiene, 1,3-hexadiene, and farnesene; 1,3-butadiene and/or isoprene is preferable; and 1,3-butadiene is more preferable.

The thermoplastic elastomer (E) may contain only one of, or two or more of the conjugated diene monomer units.

In the thermoplastic elastomer (E), a mass ratio of the styrene monomer unit to the conjugated diene monomer unit (styrene monomer unit/conjugated diene monomer unit) is preferably in a range of from 5/95 to 80/20, more preferably in a range of from 7/93 to 77/23, and even more preferably in a range of from 10/90 to 70/30. When the mass ratio of the styrene monomer unit to the conjugated diene monomer unit is in a range of from 5/95 to 80/20, an increase in adhesiveness can be suppressed and a high adhesive strength can be maintained, and easy release property between adhesive faces are improved.

In the thermoplastic elastomer (E), all of the conjugated diene bonds of the thermoplastic elastomer may be hydrogenated, some of the conjugated diene bonds may be hydrogenated, or the conjugated diene bonds may be unhydrogenated.

The thermoplastic elastomer (E) may contain or need not contain an additional monomer unit, in addition to the styrene monomer unit and the conjugated diene monomer unit. Examples of the additional monomer unit include an aromatic vinyl compound unit other than the styrene monomer unit.

In the thermoplastic elastomer (E), a total of the styrene monomer unit and the conjugated diene monomer unit preferably accounts for 90 mass% or greater, more preferably 95 mass% or greater, even more preferably 97 mass% or greater, and still more preferably 99 mass% or greater of all the monomer units.

The thermoplastic elastomer (E) may contain only one of each of the styrene monomer units and the conjugated diene monomer units, or two or more of them. When two or more of them are contained, the total amount thereof is preferably within the range set forth above.

The thermoplastic elastomer (E) may be a block polymer or a random polymer. The thermoplastic elastomer (E) may be a hydrogenated elastomer in which the conjugated diene monomer units are hydrogenated, an unhydrogenated elastomer in which the conjugated diene monomer units are not hydrogenated, or a partially hydrogenated elastomer in which some of the conjugated diene monomer units are hydrogenated.

In one embodiment of the present embodiments, the thermoplastic elastomer (E) is a hydrogenated elastomer. As used herein, the term "hydrogenated elastomer" means, for example, a thermoplastic elastomer having hydrogenated double bonds on the basis of the conjugated diene monomer unit, and is intended to include the thermoplastic elastomer having a hydrogenation percentage (hydrogenation rate) of 100% and also a thermoplastic elastomer having a hydrogenation rate of 80% or greater. The hydrogenation rate of the hydrogenated elastomer is preferably 85% or greater, more preferably 90% or greater, and even more preferably 95% or greater. In the present embodiment, the hydrogenation rate is calculated from the measurement results of ¹H-NMR spectrum measurement.

In one embodiment of the present embodiment, the thermoplastic elastomer (E) is an unhydrogenated elastomer. As used herein, the term "unhydrogenated elastomer" is intended to include an elastomer in which a percentage of hydrogenated double bonds among double bonds on the basis of the conjugated diene monomer units, i.e., a hydrogenation percentage (hydrogenation rate) is 20% or less. The hydrogenation rate in the unhydrogenated elastomer is preferably 15% or less, more preferably 10% or less, and even more preferably 5% or less.

On the other hand, a term "partially hydrogenated elastomer" means a thermoplastic elastomer in which some of double bonds on the basis of the conjugated diene monomer units are hydrogenated, and typically refers to a thermoplastic elastomer in which a hydrogenation percentage (hydrogenation rate) is lower than 80% and greater than 20%.

The thermoplastic elastomer (E) may have an acidic functional group and/or a basic functional group. Examples of the basic functional group include an amino group, an imino group, a nitrile group, a pyridyl group, a quinoline group, and an amide group. Examples of the acidic functional group include a carboxy group, an acid anhydride group, a phenolic hydroxyl group, a phosphoric acid group, and a sulfo group.

Examples of commercially available products of the thermoplastic elastomer (E) to be used in the present embodiment include: SEPTON (trade name) 2104 available from Kuraray Co., Ltd.; S.O.E. (trade name) S1606, S1613, S1609, S1605, Tuftec M1943, M1913, M1911, and Tuftec MP10 available from Asahi Kasei Corp.; and DYNARON (trade name) 9901P, TR2250 available from JSR Corporation.

When the resin composition of the present embodiment contains an elastomer (preferably, the thermoplastic elastomer (E)), the content thereof is preferably 1 part by mass or more, more preferably 5 parts by mass or more, still more preferably 8 parts by mass or more, and even more preferably 10 parts by mass or more, and depending on the intended use, the content is yet even more preferably 15 parts by mass or more, and further still more preferably 20 parts by mass or more, per 100 parts by mass of the resin solid content. When the content of the elastomer is adjusted to be greater than or equal to the lower limit value, the low dielectric properties tend to be further improved. The upper limit value of the content of the elastomer is preferably 45 parts by mass or less, more preferably 40 parts by mass or less, still more preferably 35 parts by mass or less, even more preferably 30 parts by mass or less, and may be 25 parts by mass or less, per 100 parts by mass of the resin solid content. When the content of the elastomer is adjusted to be less than or equal to the upper limit value, the thermal resistance tends to be further improved.

The resin composition of the present embodiment may contain only one of, or two or more of the elastomers. When two or more of them are contained, the total amount thereof is preferably within the range set forth above.

### <<Active ester compound>>

The resin composition of the present embodiment may contain an active ester compound.

The active ester compound is not particularly limited, and examples thereof include compounds having two or more (preferably from 2 to 12, more preferably from 2 to 6, even more preferably from 2 to 4, still more preferably 2 or 3, and yet more preferably 2) active ester groups per molecule.

The active ester compound may be a linear, branched, or cyclic compound. Among these, in terms of further improving the thermal resistance of the resulting cured product, the active ester compound is preferably an active ester compound obtained from a reaction of a carboxylic acid compound and/or a thiocarboxylic acid compound with a hydroxy compound and/or a thiol compound; more preferably an active ester compound obtained from a reaction of a carboxylic acid compound with at least one compound selected from the group consisting of a phenolic compound, a naphthol compound and a thiol compound; still more preferably an aromatic compound that has two or more active ester groups per molecule and is obtained from a reaction of a carboxylic acid compound with an aromatic compound having a phenolic hydroxyl group; and particularly preferably an aromatic compound that has two or more active ester groups per molecule and is obtained from a reaction of a compound having two or more carboxylic acids per molecule with an aromatic compound having a phenolic hydroxyl group.

Examples of the carboxylic acid compound include one or more selected from the group consisting of: benzoic acid, acetic acid, succinic acid, maleic acid, itaconic acid, phthalic acid, isophthalic acid, terephthalic acid, and pyromellitic acid. Among these, in terms of further improving the thermal resistance of the resulting cured product, the carboxylic acid compound is preferably one or more selected from the group consisting of succinic acid, maleic acid, itaconic acid, phthalic acid, isophthalic acid, and terephthalic acid, and more preferably one or more selected from the group consisting of isophthalic acid and terephthalic acid.

Examples of the thiocarboxylic acid compound include one or more selected from thioacetic acid and thiobenzoic acid.

Examples of the phenolic compound or naphthol compound include one or more selected from the group consisting of hydroquinone, resorcin, bisphenol A, bisphenol F, bisphenol S, phenolphthalein, methylated bisphenol A, methylated bisphenol F, methylated bisphenol S, phenol, o-cresol, m-cresol, p-cresol, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyl diphenol, and phenol novolac. In terms of further improving the thermal resistance and solubility of the resulting cured product in a solvent, the phenolic compound or naphthol compound is preferably bisphenol A, bisphenol F, bisphenol S, methylated bisphenol A, methylated bisphenol F, methylated bisphenol S, catechol, α-naphthol, β-naphthol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyl diphenol, or phenol novolac; more preferably one or more selected from the group consisting of catechol, 1,5-dihydroxynaphthalene, 1,6-dihydroxynaphthalene, 2,6-dihydroxynaphthalene, dihydroxybenzophenone, trihydroxybenzophenone, tetrahydroxybenzophenone, phloroglucin, benzenetriol, dicyclopentadienyl diphenol, and phenol novolac; even more preferably one or more selected from the group consisting of 1,5-dihydroxynaphthalene, 1,6-dihydroxynaphthalene, 2,6-dihydroxynaphthalene, dihydroxybenzophenone, trihydroxybenzophenone, tetrahydroxybenzophenone, dicyclopentadienyl diphenol, and phenol novolac; and particularly preferably one or more selected from the group consisting of dihydroxybenzophenone, trihydroxybenzophenone, tetrahydroxybenzophenone, dicyclopentadienyl diphenol, and phenol novolac (preferably one or more selected from the group consisting of dicyclopentadienyl diphenol and phenol novolak, and more preferably dicyclopentadienyl diphenol).

Examples of the thiol compound include one or more selected from the group consisting of benzenedithiol and triazine-dithiol.

In terms of further improving miscibility with an epoxy compound, the active ester compound is preferably a compound having two or more carboxylic acids per molecule and containing an aliphatic chain, and in terms of further improving the thermal resistance, the active ester compound is preferably a compound having an aromatic ring. More specific examples of the active ester compound include the active ester compounds described in JP 2004-277460 A.

A commercially available active ester compound may be used, or the active ester compound may be prepared by a known method. Examples of commercially available products include a compound containing a dicyclopentadienyl diphenol structure (such as EXB9451, EXB9460, EXB9460S, HPC-8000-65T (all available from DIC Corporation), etc.), an acetylated product of phenol novolac (such as DC808 (available from Mitsubishi Chemical Corporation)), and a benzoylated product of phenol novolac (such as YLH1026, YLH1030, and YLH1048 (all available from Mitsubishi Chemical Corporation)), and EXB9460S is preferable in terms of further improving the storage stability of the varnish and the low thermal expansion property when the resin composition is cured (cured product).

The active ester compound can be prepared by a known method and can be obtained, for example, by a condensation reaction of a carboxylic acid compound with a hydroxy compound. Specific examples include a method in which (a) a carboxylic acid compound or its halide, (b) a hydroxy compound, and (c) an aromatic monohydroxy compound are allowed to react at a ratio of carboxy groups or acid halide groups in (a) : phenolic hydroxyl groups in (b) : (c) is 1 mol : 0.05 to 0.75 mol : 0.25 to 0.95 mol.

The active ester compound is preferably contained to such an extent that the effects of the present invention are not compromised. When the resin composition of the present embodiment contains an active ester compound, the content thereof is preferably 0.1 parts by mass or more and 50 parts by mass or less per 100 parts by mass of the resin solid content in the resin composition.

The resin composition of the present embodiment may contain only one of, or two or more of the active ester compounds. When two or more of them are contained, the total amount thereof is preferably within the range set forth above.

The resin composition of the present embodiment may be configured to be substantially free from any active ester compound. The wording "substantially free" means that the content of the active ester compound is less than 1 part by mass per 100 parts by mass of the resin solid content in the resin composition, and the content is preferably less than 0.1 parts by mass, and more preferably 0.01 parts by mass.

### <<Flame retardant>>

The resin composition of the present embodiment may contain a flame retardant. Examples of the flame retardant include a phosphorus-based flame retardant, a halogen-based flame retardant, an inorganic flame retardant, and a silicone-based flame retardant, and a phosphorus-based flame retardant is preferred.

A known flame retardant can be used as the flame retardant, and examples thereof include: halogen-based flame retardants, such as a brominated epoxy resin, brominated polycarbonate, brominated polystyrene, brominated styrene, brominated phthalimide, tetrabromobisphenol A, pentabromobenzyl (meth)acrylate, pentabromotoluene, tribromophenol, hexabromobenzene, decabromodiphenyl ether, bis-1,2-pentabromophenylethane, chlorinated polystyrene, and chlorinated paraffin; phosphorus-based flame retardants, such as red phosphorus, tricresyl phosphate, triphenyl phosphate, cresyl diphenyl phosphate, trixylenyl phosphate, trialkyl phosphate, dialkyl phosphate, tris(chloroethyl) phosphate, phosphazene, 1,3-phenylene bis(2,6-dixylenyl phosphate), and 10-(2,5-dihydroxyphenyl)-10H-9-oxa-10-phosphaphenanthrene-10-oxide; inorganic flame retardants, such as aluminum hydroxide, magnesium hydroxide, partial boehmite, boehmite, zinc borate, and antimony trioxide; and silicone-based flame retardants, such as a silicone rubber and a silicone resin.

In the present embodiment, 1,3-phenylene bis(2,6-dixylenyl phosphate) is preferable among these because of not compromising the low dielectric properties.

When the resin composition of the present embodiment contains a flame retardant, the content of the flame retardant is preferably 1 part by mass or greater, and more preferably 5 parts by mass or greater, per 100 parts by mass of the resin solid content in the resin composition. The lower limit value of the content of the flame retardant is preferably 25 parts by mass or less, and more preferably 20 parts by mass or less.

One of the flame retardants may be used singly, or two or more of the flame retardants may be used in combination. When two or more of the flame retardants are used, the total amount thereof to be within the range set forth above.

### <Dispersant>

The resin composition of the present embodiment may contain a dispersant. A dispersant commonly used in paints can be suitably used as the dispersant, and the type of the dispersant is not particularly limited. A copolymer-based wet dispersant is preferably used as the dispersant, and specific examples thereof include DISPERBYK (trade name) -110, 111, 161, 180, 2009, 2152, and 2155 and BYK (trade name) -W996, W9010, W903, and W940 available from BYK Japan K.K.

When the resin composition of the present embodiment contains a dispersant, the lower limit value of the content thereof is preferably 0.01 parts by mass or more, more preferably 0.1 parts by mass or more, and may be 0.3 parts by mass or more per 100 parts by mass of the resin solid content in the resin composition. The upper limit value of the content of the dispersant is preferably 10 parts by mass or less, more preferably 5 parts by mass or less, and even more preferably 3 parts by mass or less per 100 parts by mass of the resin solid content in the resin composition.

One of the dispersants may be used singly, or two or more of the dispersants may be used in combination. When two or more of the flame retardants are used, the total amount thereof to be within the range set forth above.

### <<Curing accelerator>>

The resin composition of the present embodiment may further contain a curing accelerator. The curing accelerator is not particularly limited, but examples thereof include: imidazoles, such as 2-ethyl-4-methylimidazole and triphenylimidazole; organic peroxides, such as benzoyl peroxide, lauroyl peroxide, acetyl peroxide, parachlorobenzoyl peroxide, and di-tert-butyl-di-perphthalate; azo compounds, such as azobisisobutyronitrile; tertiary amines, such as N,N-dimethylbenzylamine, N,N-dimethylaniline, N,N-dimethyl toluidine, 2-N-ethylanilinoethanol, tri-n-butylamine, pyridine, quinoline, N-methylmorpholine, triethanolamine, triethylenediamine, tetramethylbutanediamine, and N-methylpiperidine; phenols, such as phenol, xylenol, cresol, resorcin, and catechol; organometallic salts, such as lead naphthenate, lead stearate, zinc naphthenate, zinc octylate, manganese octylate, tin oleate, dibutyltin malate, manganese naphthenate, cobalt naphthenate, and iron acetylacetone; these organometallic salts dissolved in hydroxyl group-containing compounds such as phenol and bisphenol; inorganic metal salts, such as tin chloride, zinc chloride, and aluminum chloride; and organotin compounds, such as dioctyl tin oxide and other alkyl tins, and alkyl tin oxides.

Preferred curing accelerators are an imidazole and an organometallic salt, and a combination of both an imidazole and an organometallic salt is more preferably used.

The resin composition of the present embodiment may be configured to be substantially free from any organic peroxide (such as an organic peroxide having a molecular weight of from 30 to 500). The wording "substantially free" means that the content of the organic peroxide is less than 0.1 parts by mass per 100 parts by mass of the resin solid content in the resin composition of the present embodiment, and the content of the organic peroxide is preferably 0.01 parts by mass or less. When the content of the organic peroxide is within such a range, a cured product more excellent in various performances can be obtained.

The resin composition of the present embodiment may be configured to be substantially free from any azo compound (such as an azo compound having a molecular weight of from 30 to 500). The wording "substantially free" means that the content of the organic peroxide is less than 0.1 parts by mass per 100 parts by mass of the resin solid content in the resin composition of the present embodiment, and the content of the organic peroxide is preferably 0.01 parts by mass or less. When the content of the organic peroxide is within such a range, a cured product more excellent in various performances can be obtained.

When the resin composition of the present embodiment contains a curing accelerator, the lower limit value of the content of the curing accelerator is preferably 0.005 parts by mass or more, more preferably 0.01 parts by mass or more, and even more preferably 0.1 parts by mass or more per 100 parts by mass of the resin solid content in the resin composition. The upper limit value of the content of the curing accelerator is preferably 10 parts by mass or less, more preferably 5 parts by mass or less, and even more preferably 2 parts by mass or less per 100 parts by mass of the resin solid content in the resin composition.

One of the curing accelerators may be used singly, or two or more of the curing accelerators may be used in combination. When two or more of the flame retardants are used, the total amount thereof to be within the range set forth above.

### <<Solvent>>

The resin composition of the present embodiment may contain a solvent and preferably contains an organic solvent. When the resin composition of the present embodiment contains a solvent, the resin composition is in a form (of solution or varnish) in which at least some, or preferably all of the various resin solid contents described above are dissolved or homogeneously mixed in the solvent. The solvent is not particularly limited as long as it is a polar organic solvent or non-polar organic solvent capable of dissolving or homogeneously mixing at least some, or preferably all of the various resin solid contents described above; examples of the polar organic solvent include ketones (e.g., acetone, methyl ethyl ketone, and methyl isobutyl ketone), cellosolves (e.g., propylene glycol monomethyl ether and propylene glycol monomethyl ether acetate), esters (e.g., ethyl lactate, methyl acetate, ethyl acetate, butyl acetate, isoamyl acetate, ethyl lactate, methyl methoxypropionate, and methyl hydroxyisobutyrate), and amides (e.g., dimethoxy acetamide and dimethylformamide); examples of the non-polar organic solvent include aromatic hydrocarbons (e.g., toluene and xylene).

One of the solvents may be used singly, or two or more of the solvents may be used in combination. When two or more of the flame retardants are used, the total amount thereof to be within the range set forth above.

### <<Ultraviolet absorber>>

The resin composition of the present embodiment may contain an ultraviolet absorber.

The type of the ultraviolet absorber is not particularly limited, but examples of the ultraviolet absorber include benzotriazole-based ultraviolet absorbers, benzophenone-based ultraviolet absorbers, triazine-based ultraviolet absorbers, cyclic iminoester-based ultraviolet absorbers, cyanoacrylate-based ultraviolet absorbers, conjugated diene-based ultraviolet absorbers, methyldibenzoyl-based ultraviolet absorbers, coumarin-based ultraviolet absorbers, salicylate-based ultraviolet absorbers, acrylonitrile-based ultraviolet absorbers, and benzodithiazole-based ultraviolet absorbers, and coumarin-based ultraviolet absorbers are preferred.

Examples of the benzotriazole-based ultraviolet absorber include 2-(2-hydroxy-5-methylphenyl)benzotriazole, 2-(2-hydroxy-5-tert-octylphenyl)benzotriazole, 2-(2-hydroxy-3,5-dicumylphenyl)phenylbenzotriazole, 2-(2-hydroxy-3-tert-butyl-5-methylphenyl)-5-chlorobenzotriazole, 2,2'-methylenebis[4-(1,1,3,3-tetramethylbutyl)-6-(2N-benzotriazole-2-yl)phenol], 2-(2-hydroxy-3,5-di-tert-butylphenyl)benzotriazole, 2-(2-hydroxy-3,5-di-tert-butylphenyl)-5-chlorobenzotriazole, 2-(2-hydroxy-3,5-di-tert-amylphenyl)benzotriazole, and 2-(2-hydroxy-5-tert-octylphenyl)benzotriazole, 2-(2-hydroxy-5-tert-butylphenyl)benzotriazole, 2-(2-hydroxy-4-octoxyphenyl)benzotriazole, 2,2'-methylenebis(4-cumyl-6-benzotriazole phenyl), 2,2'-p-phenylenebis(1,3-benzoxazine-4-one), and 2-[2-hydroxy-3-(3,4,5,6-tetrahydrophthalimidomethyl)-5-methylphenyl]benzotriazole.

Examples of the benzophenone-based ultraviolet absorbers include 2,4-dihydroxybenzophenone, 2-hydroxy-4-methoxybenzophenone, 2-hydroxy-4-octoxybenzophenone, 2-hydroxy-4-benzyloxybenzophenone, 2-hydroxy-4-methoxy-5-sulfoxybenzophenone, 2-hydroxy-4-methoxy-5-sulfoxytrihydrate benzophenone, 2,2'-dihydroxy-4-methoxybenzophenone, 2,2',4,4'-tetrahydroxybenzophenone, 2,2'-dihydroxy-4,4'-dimethoxybenzophenone, 2,2'-dihydroxy-4,4'-dimethoxy-5-sodium sulfoxybenzophenone, bis(5-benzoyl-4-hydroxy-2-methoxyphenyl) methane, 2-hydroxy-4-n-dodecyloxybenzophenone, 2-hydroxy-4-methoxy-2'-carboxybenzophenone.

Examples of the triazine-based ultraviolet absorber include 2-(4,6-diphenyl-1,3,5-triazine-2-yl)-5-[(hexyl)oxy]-phenol and 2-(4,6-bis(2,4-dimethylphenyl)-1,3,5-triazine-2-yl)-5-[(octyl)oxy]-phenol.

Examples of the cyclic iminoester-based ultraviolet absorbers include 2,2'-bis(3,1-benzoxazine-4-one), 2,2'-p-phenylenebis(3,1-benzoxazine-4-one), 2,2'-m-phenylenebis(3,1-benzoxazine-4-one), 2,2'-(4,4'-diphenylene)bis(3,1-benzoxazine-4-one), 2,2'-(2,6-naphthalene)bis(3,1-benzoxazine-4-one), 2,2'-(1,5-naphthalene)bis(3,1-benzoxazine-4-one), 2,2'-(2-methyl-p-phenylene)bis(3,1-benzoxazine-4-one), 2,2'-(2-nitro-p-phenylene)bis(3,1-benzoxazine-4-one) and 2,2'-(2-chloro-p-phenylene)bis(3,1-benzoxazine-4-one).

Examples of the cyanoacrylate-based ultraviolet absorber include 1,3-bis-[(2'-cyano-3',3'-diphenylacryloyl)oxy]-2,2-bis[(2-cyano-3,3-diphenylacryloyl)oxy]methyl)propane and 1,3-bis-[(2-cyano-3,3-diphenylacryloyl)oxy]benzene.

Examples of the coumarin-based ultraviolet absorber include 7-(diethylamino)coumarin, coumarin(7-diethylamino-4-methylcoumarin, 7-hydroxy-4-methylcoumarin), ketocoumarin, and carbonyl biscoumarin.

Apart from the description set forth above, reference may be made to the description in paragraphs [0065] to [0077] of JP 2022-000700 A and the description in paragraphs [0019] to [0032] of JP 2020-189783 A, and the contents thereof are incorporated herein.

When the resin composition of the present embodiment contains an ultraviolet absorber, the content thereof is preferably more than 0 parts by mass, more preferably 0.1 parts by mass or more, still more preferably 0.2 parts by mass or more, even more preferably 0.3 parts by mass or more, and yet even more preferably 0.4 parts by mass or more, per 100 parts by mass of the resin solid content. The content of the ultraviolet absorber is preferably 3.0 parts by mass or less, more preferably 2.5 parts by mass or less, further more preferably 2.0 parts by mass or less, still more preferably 1.5 parts by mass or less, even more preferably 1.0 parts by mass or less, and yet even more preferably 0.8 parts by mass or less, per 100 parts by mass of the resin solid content. When the content of the ultraviolet absorber is adjusted to be less than or equal to the upper limit value, the dielectric dissipation factor of the resulting cured product tends to be enabled to be further

### improved.

The resin composition of the present embodiment may contain only one of, or two or more of the ultraviolet absorbers. When two or more of them are contained, the total amount thereof is preferably within the range set forth above.

### <<Nonmetallic organic dye>>

The resin composition of the present embodiment may contain a nonmetallic organic dye.

Examples of the nonmetallic organic dye include a cyanine dye, a triphenylmethane dye, an anthraquinone dye, a xanthene dye, an azo dye, a benzopyran dye, an indigo dye, a quinoline dye, a perinone dye, and a perylene dye, and an anthraquinone dye and/or a perinone dye are preferable. Regarding details of these nonmetallic organic dyes, reference may be made to the description of JP H02-089683 A and the description of paragraph [0031] of JP 2011-102384 A, and the contents thereof are incorporated herein.

When the resin composition of the present embodiment contains a nonmetallic organic dye, the content thereof is preferably more than 0 parts by mass, more preferably 0.2 parts by mass or more, still more preferably 0.3 parts by mass or more, even more preferably 0.4 parts by mass or more, and yet even more preferably 0.45 parts by mass or more, per 100 parts by mass of the resin solid content. The content of the nonmetallic organic dye is preferably 2.0 parts by mass or less, more preferably 1.75 parts by mass or less, still more preferably 1.5 parts by mass or less, even more preferably 1.25 parts by mass or less, and yet even more preferably 1.0 parts by mass or less, per 100 parts by mass of the resin solid content. When the content is adjusted to be less than or equal to the upper limit value, the dielectric dissipation factor of the resulting cured product tends to be further reduced and the glass transition temperature tends to improve.

The resin composition of the present embodiment may contain only one of, or two or more of the nonmetallic organic dyes. When two or more of them are contained, the total amount thereof is preferably within the range set forth above.

The resin composition of the present embodiment can be configured to be substantially free from any carbon black, and furthermore, free from any conductive substance. The wording "substantially free" of carbon black, and/or furthermore a conductive substance, means that the content of carbon black (and furthermore, a conductive substance) is less than 10 mass% of the content of the nonmetallic organic dye contained in the resin composition, preferably 5 mass% or less, more preferably 1 mass% or less, and still more preferably 0.1 mass% or less. With such a configuration, the insulating properties of the resulting resin composition or cured product can be further enhanced.

### <<Other components>>

The resin composition of the present embodiment may contain various polymer compounds such as thermoplastic resins other than elastomers, and oligomers thereof, and various additives, apart from the components set forth above. Examples of the additive include an antioxidant, a photopolymerization initiator, a fluorescent brightener, a photosensitizer, a dye, a pigment, a thickener, a flow modifier, a lubricant, an antifoaming agent, a leveling agent, a gloss agent, and a polymerization inhibitor. One of these additives may be used singly, or two or more of these additives may be used in combination.

The resin composition of the present embodiment can also be configured to be substantially free from any polymerization initiator. The wording "substantially free" means that the content of the polymerization initiator is less than 0.1 parts by mass per 100 parts by mass of the resin solid content in the resin composition of the present embodiment, and the content is preferably 0.01 parts by mass or less. When the content of the organic peroxide is within such a range, a cured product more excellent in various performances can be obtained.

A cured product of the resin composition of the present embodiment preferably has a low dielectric dissipation factor (Df). Specifically, the dielectric dissipation factor (Df) is preferably 0.1 or less, more preferably 0.01 or less, further more preferably 0.003 or less, and still more preferably 0.001 or less as measured at 10 GHz according to the resonance cavity perturbation method. The lower limit value of the dielectric dissipation factor (Df) is not particularly specified, but is practically at least 0.0001, for example.

A cured product of the resin composition of the present embodiment preferably has a low relative permittivity (Dk). Specifically, the relative permittivity (Dk) is preferably 7 or less, more preferably 3 or less, and still more preferably 2.5 or less as measured at 10 GHz according to the resonance cavity perturbation method. The lower limit value of the relative permittivity (Dk) is not particularly limited, but is practically at least 1, for example.

The dielectric properties of the cured product of the resin composition are measured by the following method.

When the resin composition contains a solvent, the solvent is removed by distillation to give a resin composition powder. Into a mold with sides of 100 mm and a thickness of 0.8 mm is filled the resin composition powder, and a copper foil (3EC-M2S-VLP, available from Mitsui Mining & Smelting Corporation) having a thickness of 12 µm is disposed on both surfaces of the mold, followed by vacuum pressing at a pressure of 30 kg/cm² and at a temperature of 220°C for 120 minutes, and then the copper foils on both surfaces is removed by etching to give a cured plate with sides of 100 mm and a thickness of 0.8 mm.

The resultant cured plate is processed into a size of 1.0 mm × 100 mm, dried at 120°C for 60 minutes, and then a relative permittivity (Dk) and a dielectric dissipation factor (Df) after drying are measured at 10 GHz with a cavity resonator based on the perturbation method. The measurement is to be conducted at a temperature of 23°C.

As the cavity resonator based on the perturbation method, Agilent 8722ES available from Agilent Technologies, Inc. can be used.

### <Resin composite sheet>

The resin composite sheet of the present embodiment is a resin composite sheet, which is to be used for producing a metal foil-clad laminate, in which a resin composite sheet including a metal foil and a resin composition layer disposed on one side of the metal foil is laminated on a surface of a circuit board A including an insulating layer and a conductor circuit layer, by a method using a vacuum laminator and including the following steps, the resin composition containing a thermosetting resin, wherein a content of an inorganic filler is from 0 to 250 parts by mass per 100 parts by mass of a resin solid content contained in the resin composition.
Step 1: a step of reducing the content of moisture and/or a solvent contained in the circuit board A to obtain the circuit board B;
Step 2: a step of disposing the resin composite sheet including a metal foil and a resin composition layer disposed on one side of the metal foil on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

That is, the resin composite sheet in the present embodiment is preferably the resin composite sheet C to be used in the method for producing a metal foil-clad laminate. Accordingly, the details of the resin composite sheet C are also synonymous with the matters described in the section of the method for producing a metal foil-clad laminate. The method for producing a metal foil-clad laminate is also synonymous with the matters described in the section of the method for producing the metal foil-clad laminate.

### <Method for producing a printed wiring board>

The method for producing a printed wiring board of the present embodiment includes the method for producing a metal foil-clad laminate of the present embodiment.

Regarding the details (features) of the method for producing a printed wiring board of the present embodiment, reference may be made to the matters described in the section of the method for producing a metal foil-clad laminate of the present embodiment.

Regarding other details of the printed wiring board, reference may be made to the description in paragraph [0101] of JP 2022-99579 A, and the contents thereof are incorporated herein.

### <Method for producing a semiconductor device>

The method for producing a semiconductor device of the present embodiment includes the method for producing a metal foil-clad laminate of the present embodiment.

Regarding the details (features) of the method for producing a semiconductor device of the present embodiment, reference may be made to the matters described in the section of the method for producing a metal foil-clad laminate of the present embodiment.

For other details of the semiconductor device, reference may be made to the description in paragraph [0102] to [0104] of JP 2022-99579 A and the description in paragraph [0115] of JP 2022-089837 A, and the contents thereof are incorporated herein.

### Examples

Hereinafter, the present invention will be described more specifically with reference to Examples. Materials, usage amounts, proportions, processing details, and processing procedures described in the following Examples can be changed as appropriate without departing from the spirit of the invention. Thus, the scope of the present invention is not limited to the specific examples described below.

If it is difficult to obtain the measuring instrument or the like used in Examples due to discontinuation or the like, another instrument with equivalent performance can be used for the measurement.

In the following embodiments, heating temperatures and pressurizing pressures are preset temperatures and preset pressures of the devices.

### <Measurement of weight average molecular weight and number average molecular weight>

The weight average molecular weights (Mw) and the number average molecular weights (Mn) of various resins and compounds were measured by a gel permeation chromatography (GPC) method. A liquid feeding pump (LC-20AD available from Shimadzu Corporation), a differential refractive index detector (RID-20A available from Shimadzu Corporation), and GPC columns (GPC KF-801, 802, 803, 804 available from Showa Denko K.K.) were used, and the measurement was conducted by using tetrahydrofuran as a solvent, a flow rate of 1.0 mL/min, a column temperature of 40°C, and a calibration curve using monodisperse polystyrene.

### <Synthesis Example 1: Synthesis of naphthol aralkyl-type cyanate ester compound (SNCN)>

In 1800 g of dichloromethane were dissolved 300 g (1.28 mol in terms of OH group) of a 1-naphthol aralkyl resin (available from NIPPON STEEL Chemical & Material Co., Ltd.) and 194.6 g (1.92 mol) of triethylamine (1.5 mol per mol of hydroxy group), and this solution was used as a solution 1.

Over 30 minutes, the solution 1 was poured into a mixture of 125.9 g (2.05 mol) of cyanogen chloride (1.6 mol per mol of hydroxy group), 293.8 g of dichloromethane, 194.5 g (1.92 mol) of 36% hydrochloric acid (1.5 mol per mol of hydroxy group), and 1205.9 g of water, with stirring and kept the liquid temperature at -2°C to -0.5°C. After completion of pouring of the solution 1, the mixture was stirred for 30 min at the same temperature, then a solution (solution 2) of 65 g (0.64 mol) of triethylamine (0.5 mol per mol of hydroxy group) dissolved in 65 g of dichloromethane was poured into the mixture over 10 minutes. After completion of pouring the solution 2, the mixture was stirred for 30 minutes at the same temperature, and the reaction was completed.

The reaction solution was then allowed to stand, and the organic phase was separated from the aqueous phase. The resulting organic phase was washed five times with 1300 g of water. The wastewater at the fifth water washing was found to have an electrical conductivity of 5 µS/cm, and it was confirmed that the removable ionic compound was sufficiently removed by washing with water.

The organic phase after water washing was concentrated under reduced pressure and finally concentrated to dryness at 90°C for 1 hour to obtain 331 g of an intended naphthol aralkyl-type cyanate ester compound (SNCN) (an orange viscous material). The resulting SNCN was found to have a weight average molecular weight of 600. The SNCN indicated an IR spectrum having an absorption (of a cyanate ester group) at 2250 cm⁻¹ and no absorptions of hydroxy group.

### <Synthesis Example 2: Synthesis of modified polyphenylene ether compound>

### <<Synthesis of bifunctional phenylene ether oligomer>>

Into a 12-L vertical reactor equipped with a stirrer, a thermometer, an air inlet tube, and a baffle plate were placed 9.36 g (42.1 mmol) of CuBr2, 1.81 g (10.5 mmol) of N,N'-di-t-butylethylenediamine, 67.77 g (671.0 mmol) of n-butyldimethylamine, and 2600 g of toluene, and this mixture was stirred at a reaction temperature of 40°C, and then while a mixed gas of nitrogen and air adjusted to have an oxygen concentration of 8 vol.% being bubbled into this mixture at a flow rate of 5.2 L/min, a mixed solution of 129.32 g (0.48 mol) of 2,2',3,3',5,5'-hexamethyl-(1,1'-biphenol)-4,4'-diol, 878.4 g (7.2 mol) of 2,6-dimethylphenol, 1.22 g (7.2 mmol) of N,N'-di-t-butylethylenediamine, 26.35 g (260.9 mmol) of n-butyldimethylamine dissolved in 2300 g of methanol in advance was added dropwise thereto over 230 minutes, and stirred. After completion of the dropwise addition, 1500 g of water in which 48.06 g (126.4 mmol) of tetrasodium ethylenediaminetetraacetate had been dissolved was added to cease the reaction. The aqueous layer was separated from the organic layer, and the organic layer was washed with 1N aqueous hydrochloric acid solution and then with pure water. The resulting solution was concentrated to 50 mass% with an evaporator, and 1981 g of a solution of a bifunctional phenylene ether oligomer (a resin "A") in toluene was obtained. The resin "A" was found to have a number average molecular weight of 1975 in terms of polystyrene by a GPC method, a weight average molecular weight of 3514 in terms of polystyrene by a GPC method, and a hydroxyl group equivalent of 990.

### <<Synthesis of modified polyphenylene ether compound>>

Into a reactor equipped with a stirrer, a thermometer, and a reflux tube were placed 833.4 g of a solution of the resin "A" in toluene, 76.7 g of vinylbenzyl chloride ("CMS-P" available from AGC Seimi Chemical Co., Ltd.), 1600 g of methylene chloride, 6.2 g of benzyldimethylamine, 199.5 g of pure water, and 83.6 g of a 30.5 mass% NaOH aqueous solution, and the mixture was stirred at a reaction temperature of 40°C. After stirring for 24 hours, the organic layer was washed with a 1N aqueous hydrochloric acid solution and then with pure water. The resulting solution was concentrated with an evaporator and this concentrate was added dropwise to methanol for solidification, followed by filtration to collect a solid, which was then vacuum-dried to obtain 450.1 g of a modified polyphenylene ether compound. The modified polyphenylene ether compound was found to have a number average molecular weight of 2250 in terms of polystyrene by a GPC method, a weight average molecular weight of 3920 in terms of polystyrene by a GPC method, and a vinyl group equivalent of 1189 g/vinyl group.

### <Synthesis Example 3: Synthesis of polymer (va) having constitutional unit represented by Formula (V)>

Into a reactor were placed 2.25 mol (292.9 g) of divinylbenzene, 1.32 mol (172.0 g) of ethylvinylbenzene, 11.43 mol (1190.3 g) of styrene, and 15.0 mol (1532.0 g) of n-propyl acetate, then 600 mmol of a diethyl ether complex of boron trifluoride was added thereto at 70°C, and the mixture was allowed to react for 4 hours. After the polymerization reaction was ceased with an aqueous solution of sodium hydrogen carbonate, the oil layer was washed three times with pure water, followed by vacuum devolatilization at 60°C and thereby recovering a polymer (va) having a constitutional unit represented by Formula (V). The resulting polymer (va) having the constitutional unit represented by Formula (V) was weighed to confirm that 860.8 g of the polymer (va) having the constitutional unit represented by Formula (V) was produced.

### <Example 1>

30 parts by mass of the maleimide compound (NE-X-9470 S, available from DIC Corporation), 1 part by mass of the maleimide compound (MIR-3000-70 MT, available from Nippon Kayaku Co., Ltd.), 1 part by mass of the naphthol aralkyl cyanate ester compound (SNCN) obtained in the section <Synthesis Example 1>, 15 parts by mass of the modified polyphenylene ether compound obtained in the section <Synthesis Example 2>, 15 parts by mass of a phosphorus-based flame retardant (PX-200, available from DAIHACHI CHEMICAL INDUSTRY CO., LTD.), 25 parts by mass of a styrene thermoplastic elastomer (SBS, TR2250, Mn115000, available from JSR Corporation), 10 parts by mass of the polymer (va) having a constitutional unit represented by Formula (V) obtained in the section <Synthesis Example 3>, 3 parts by mass of 4-methylstyrene (boiling point: 175°C), 20 parts by mass of silica (average particle diameter (D50, the same applies hereinafter.): 1.1 µm, classified product of SC4500SQ available from ADMATECHS COMPANY LIMITED), 20 parts by mass of silica (average particle diameter of 0.7 µm, SFP-130MC, available from Denka Company Limited), 0.005 parts by mass of manganese octylate, 0.6 parts by mass of TPIZ (2,4,5-triphenylimidazole, a catalyst), and 0.25 parts by mass of an imidazole catalyst (2E4MZ, available from SHIKOKU CHEMICALS CORPORATION) were dissolved in methyl ethyl ketone (solvent) and mixed to give a varnish. Note that, each amount added indicates the amount of solid content.

### Maleimide compound (NE-X-9470S)

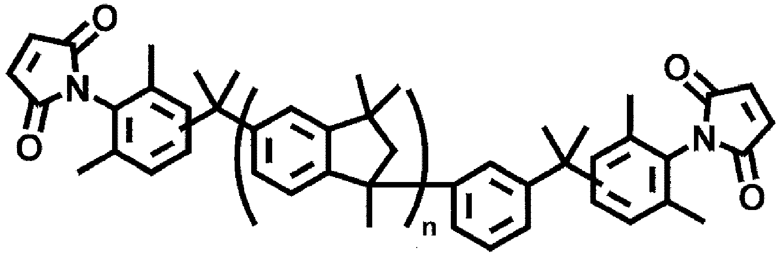

n is an integer of 1 to 20.

The resultant varnish was applied onto an ultrathin copper foil surface side of an ultrathin copper foil with a carrier copper foil (carrier copper foil thickness: 12 µm, ultrathin copper foil thickness: 1.5 µm, MT-FL, manufactured by MITSUI MINING & SMELTING CO.,LTD.) so the thickness of the resin composition layer after drying as to be 30 µm, and the solvent was removed by drying at 150°C for 5 minutes to give a resin composite sheet C including the resin composition layer and the ultrathin copper foil with a carrier copper foil.

A circuit board A having L(pattern width) / S(gap between patterns) = 40 / 40 (µm) was obtained by patterning a copper-foil-clad laminate CCL-HL832NS(T/T 0.8 mmt, LC, trade name) available from MITSUBISHI GAS CHEMICAL COMPANY, INC. The resultant circuit board A had a size of 515 × 415 mm, an average thickness of a portion provided with the conductor circuit: 10 µm, and a thickness of the insulating layer: 800 µm.

Subsequently, the circuit board A was dried by heating at a temperature of 130°C for 2 hours with a dryer available from ESPEC CORPORATION to give a dried circuit board B (Step 1). Immediately after drying the circuit board B, two of the resin composite sheets C having a size of 520 × 420 mm were prepared, and disposed on both surfaces of the circuit board so that the resin composition layer side is in contact with the circuit board.

This processing object having the resin composite sheets disposed on both surfaces of the circuit board B was put into a vacuum laminator available from NIKKO MATERIALS CO., LTD., vacuum was produced over 30 seconds, and then vacuum rubber pressing was conducted for 30 seconds at a temperature of 150°C and at a pressure of 10 kgf/cm² to give a laminated substrate D (Step 2). Furthermore, plane pressing was conducted with a pressing metal plate at a temperature of 150°C and at a pressure of 10 kgf/cm² for 60 seconds (Step 3) to give a laminated substrate E.

Thereafter, a dryer available from ESPEC CORPORATION was used and the resultant laminated substrate E was heated at a temperature of 150°C for 1 hour, and then the temperature was raised to 220°C and another heating was conducted for another 2 hours to give a cured board F (Step 4). The mass reduction ratio of the laminated substrate before and after the heating in Step 4 (heating at 150°C for 1 hour and heating at 220°C for 2 hours) was found to be 0.1 mass%.

The cured board was taken out from the dryer, cooled down to approximately room temperature, and then the copper foil was peeled off from the resultant cured board F, and the surface conditions thereof were visually checked and no occurrence of local delamination (blister) was confirmed.

### <Example 2>

The drying of the circuit board A was changed from Example 1, and a vacuum dryer (available from Yamato Scientific Co., Ltd.) was used at a temperature of 130°C for 1 hour under vacuum to dry a circuit board A having a size of 515 × 415 mm. Thereafter was conducted the same method as in Example 1, and a cured board F was produced. The carrier copper foil was peeled off from the resultant cured board F and the surface conditions thereof were visually checked, and no occurrence of local delamination (blister) was confirmed.

### <Example 3>

The drying of the circuit board A was changed from Example 1, and a dryer (available from ESPEC CORP.) was used at a temperature of 150°C for 1 hour in a nitrogen atmosphere to dry a circuit board A having a size of 515 × 415 mm. Thereafter was conducted the same method as in Example 1, and a cured board F was produced. The carrier copper foil was peeled off from the resultant cured board F and the surface conditions thereof were visually checked, and no occurrence of local delamination (blister) was confirmed.

### <Example 4>

Fifteen parts by mass of the naphthol aralkyl cyanate ester compound (SNCN) obtained in the section <Synthesis Example 1>, 35 parts by mass of the maleimide compound (BMI-80, 2,2-bis(4-(4-maleimidophenoxy)phenyl)propane, available from K.I Chemical Industry Co., Ltd.)), 25 parts by mass of the modified polyphenylene ether compound obtained in the section <Synthesis Example 2>, 15 parts by mass of a phosphorus-based flame retardant (PX-200, available from DAIHACHI CHEMICAL INDUSTRY CO., LTD., 1,3-phenylenebis(2,6-dixylenyl phosphate)), 5 parts by mass of a styrene oligomer (Kristalex 3085, available from Eastman Chemical Company), 5 parts by mass of a styrene thermoplastic elastomer (SEPS, available from Kuraray Co., Ltd., SEPTON2104), 62.5 parts by mass of silica (classified product of SC4500SQ available from ADMATECHS COMPANY LIMITED, average particle diameter: 1.1 µm), 62.5 parts by mass of silica (average particle diameter: 0.7 µm, SFP-130MC, available from Denka Company Limited), 1.0 part by mass of a wetting and dispersing additive (DISPERBYK-161, available from BYK), 3.0 parts by mass of a silane coupling agent (KBM-403, available from Shin-Etsu Chemical Co., Ltd.), 0.4 parts by mass of a wetting and dispersing additive (DISPERBYK-2009, available from BYK), 0.5 parts by mass of an ultraviolet absorber (HR-1, available from CHUO SYNTHETIC CHEMICAL CO., LTD.), 0.5 parts by mass of a nonmetallic organic dye (Kayaset Black A-N, available from Nippon Kayaku Co., Ltd.), 0.005 parts by mass of manganese octylate, and 0.9 parts by mass of triphenylimidazole were dissolved in methyl ethyl ketone and mixed to give a varnish. Note that, each amount added indicates the amount of solid content.

The resultant varnish was applied onto an ultrathin copper foil surface side of an ultrathin copper foil with a carrier copper foil (carrier copper foil thickness: 12 µm, ultrathin copper foil thickness: 1.5 µm, MT-FL, manufactured by MITSUI MINING & SMELTING CO.,LTD.) so the thickness of the resin composition layer after drying as to be 30 µm, and the solvent was removed by drying at 150°C for 5 minutes to give a resin composite sheet C including the resin composition layer and the ultrathin copper foil with a carrier copper foil.

A circuit board A same as used in Example 1 was heated at a temperature of 130°C for 4 hours with a dryer (available from ESPEC CORP.) and the circuit board A having a size of 515 × 415 mm was dried. Thereafter was conducted the same method as in Example 1, and a cured board F was produced. The carrier copper foil was peeled off from the resultant cured board F and the surface conditions thereof were visually checked, and no occurrence of local delamination (blister) was confirmed.

### <Comparative Example 1>

In the same way as in Example 1, two resin composite sheets composed of a resin composition layer having a size of 520 × 420 mm and an ultrathin copper foil with a carrier copper foil were prepared. Thereafter, each of the resin composition sheet was disposed on both surfaces of a circuit board (not subjected to drying, having a size of 515 × 415 mm), which is the same as that used in Example 1, such that the resin composition layer side is in contact with the circuit board.

This processing object having the resin composite sheet disposed on both surfaces of the circuit board was put into a vacuum laminator (available from Nikko Materials Co., Ltd.), a vacuum was produced over 30 seconds, and then vacuum rubber pressing was conducted for 30 seconds at a temperature of 150°C and at a pressure of 10 kgf/cm². Subsequently, planar pressing was conducted with a pressing metal plate at a temperature of 150°C and at a pressure of 10 kgf/cm² for 60 seconds to give a laminated substrate.

Thereafter, a dryer (available from ESPEC CORP.) was used to heat the resultant laminated substrate at a temperature of 150°C for 1 hour, and then the temperature was raised to 220°C and another heating was conducted for another 2 hours to give a cured board. The mass reduction ratio of the laminated substrate before and after the heating in Step 4 (heating at 150°C for 1 hour and heating at 220°C for 2 hours) was found to be 0.08 mass%.

After the cured board had been taken out from the dryer and cooled down to approximately room temperature, the carrier copper foil was peeled off from the resultant cured board, and the surface condition was visually checked and an occurrence of local delamination (blister) was confirmed.

### <Comparative Example 2>

In the same way as in Example 1, two resin composite sheets composed of a resin composition layer having a size of 520 × 420 mm and an ultrathin copper foil with a carrier copper foil were prepared. Thereafter, each of the resin composition sheet was disposed on both surfaces of a circuit board (not subjected to drying, having a size of 515 × 415 mm), which is the same as that used in Example 1, such that the resin composition layer side is in contact with the circuit board.

This processing object having the resin composite sheet disposed on both surfaces of the circuit board was formed into a laminate by hot pressing with a multi-stage vacuum press machine (available from Kitagawa Seiki Co., Ltd.) under conditions of a laminate temperature of 220°C, a specific pressure of 30 kgf/cm², and a retention time of 1 hour. Approximately 3 hours was needed for this vacuum pressing step including heating up and cooling down.

After the resultant cured board was taken out from the press machine, the carrier copper foil was peeled off from the cured board, and the surface conditions were visually confirmed, and no occurrence of local delamination (blister) was confirmed.

**[Table 1]**

| | Example 1 | Example 2 | Example 3 | Example 4 | Comparative Example 1 | Comparative Example 2 |
|---|---|---|---|---|---|---|
| Lamination method | Vacuum lamination | Vacuum lamination | Vacuum lamination | Vacuum lamination | Vacuum lamination | Vacuum hot press |
| Drying conditions of circuit board | Under the atmosphere 130°C, 2 hours | Under vacuum 130°C, 1 hour | Under a nitrogen atmosphere 150°C, 1 hour | Under the atmosphere 130°C, 4 hours | No drying | No drying |
| Silica in resin composition in resin composite sheet (amount per 100 parts by mass of resin solid content) | 40 parts by mass | 40 parts by mass | 40 parts by mass | 125 parts by mass | 40 parts by mass | 40 parts by mass |
| Occurrence of delamination (blister) | No | No | No | No | Yes | No |
| Mass productivity [lamination time] | Good [2 min] | Good [2 min] | Good [2 min] | Good [2 min] | Good [2 min] | Poor [4 hours] |

### <Observation of Example 1>

The flatness of the substrate after the carrier copper foil was peeled off from the cured board F obtained in Example 1 was visually evaluated.

Two resin composite sheets prepared by the method described in Example 1 were disposed so the resin composition layer surfaces as to contact with each other, followed by vacuum lamination and thermal curing in the same way as in Example 1, the carrier copper foil was peeled off, and then the ultrathin copper foil was further etched to give a cured plate, and this plate was used as a sample to measure the glass transition temperature of the resin composition layer. The glass transition temperature was measured in accordance with the description of paragraph [0142] of JP 2022-099579 A.

### <Reference Example 1>

A laminated substrate was obtained in the same way as in Example 1 except that a PET film (available from Unitika Corporation) having a thickness of 38 µm was used in place of the ultrathin copper foil with a carrier copper foil in the resin composite sheet.

During heating the laminated substrate, the PET film stuck onto the resin upon heating at 220°C (200°C or higher), so that the PET film was not able to be removed after the heating.

Therefore, the PET film had been removed from the laminated substrate, and then heating was conducted at 220°C in the same way as in Example 1. As a result, the flatness of the cured board after resin curing was compromised.

The presence or absence of blister (delamination) between the PET film and the resin composition layer was also checked.

The glass transition temperature of the cured board was measured in the same way as in the section <Observation of Example 1> described above.

### <Reference Example 2>

A cured board was obtained in a similar way to Reference Example 1 except that a PET film was not removed and the heating temperature of the laminated substrate was changed to lower than 200°C, and the following evaluation was conducted.

The presence of absence of blister (delamination) between the PET film and the resin composition layer was checked.

The glass transition temperature of the cured board was measured in the same way as in the section <Observation of Example 1> described above.

As a result, the resin composition was not sufficiently cured, and the glass transition temperature of the resultant cured board decreased.

Table 2 summarizes the results of Reference Example 1 and Reference Example 2 together with the results of Example 1.

**[Table 2]**

| | Example 1 | Reference Example 1 | Reference Example 2 |
|---|---|---|---|
| Material | Resin composite sheet (with copper foil) | Film with resin | Film with resin |
| Lamination method | Vacuum lamination | Vacuum lamination | Vacuum lamination |
| Maximum temperature in post atmosphere | 220°C | 220°C | <200°C |
| Presence or absence of carrier under post atmosphere | Yes (Copper foil) | No | Yes (PET) |
| Occurrence of delamination (blister) | No | No | No |
| Glass transition temperature | High | High | Low |
| Flatness | High | Low | High |

### Industrial Applicability

The method for producing a metal foil-clad laminate of the present invention provides a metal foil-clad laminate with an excellent mass productivity and enabled to suppress the delamination between a resin composition layer and a metal foil.

Furthermore, the printed wiring board described in Patent Document 1 is produced in a method in which, after the adhesive film is cured to form an insulating layer, for example, a copper foil is further laminated and subjected to necessary processing to form a conductor circuit layer, thereby producing a multilayer printed wiring board, however, such a step can be omitted in the present invention.

Therefore, the method for producing a metal foil-clad laminate of the present invention is extremely useful.

### Reference Signs List

11 Insulating layer
12 Conductor circuit layer
13 Resin composition layer
14 Metal foil
15 Carrier

## Claims

1. A method for producing a metal foil-clad laminate, which is a method where a vacuum laminator is used to produce a metal foil-clad laminate in which a resin composite sheet C comprising a metal foil and a resin composition layer disposed on one side of the metal foil is laminated on a surface of a circuit board A comprising an insulating layer and a conductor circuit layer, the method comprising steps set forth below;
Step 1: a step of reducing a content of moisture and/or a solvent contained in the circuit board A to obtain a circuit board B;
Step 2: a step of disposing the resin composite sheet C comprising a metal foil and a resin composition layer disposed on one side of the metal foil on at least one surface of the circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

2. The method for producing a metal foil-clad laminate according to claim 1, further comprising, after the step 3, conducting a below-mentioned step;
Step 4: a step of heating the laminated substrate E obtained in the step 3 to cure the resin composition layer to obtain a cured board F.

3. The method for producing a metal foil-clad laminate according to claim 2, wherein a mass reduction ratio of the laminated substrate E by the heating in the step 4 is 1.0 mass% or less.

4. The method for producing a metal foil-clad laminate according to claim 2 or 3, wherein the steps 2 to 4 are conducted repeatedly for the cured board F.

5. The method for producing a metal foil-clad laminate according to claim 2 or 3, wherein the heating in the step 4 is conducted at a temperature of from 100 to 250°C.

6. The method for producing a metal foil-clad laminate according to claim 2 or 3, wherein in the heating of the step 4, the temperature is raised in stages with two or more stages.

7. The method for producing a metal foil-clad laminate according to claim 2 or 3, wherein the heating in the step 4 is conducted at a temperature of from 100 to 180°C, and then further conducted at a temperature of higher than 180°C and 250°C or lower.

8. The method for producing a metal foil-clad laminate according to claim 1 or 2, wherein the circuit board B obtained in the step 1 is made less likely to absorb moisture.

9. The method for producing a metal foil-clad laminate according to claim 1 or 2, wherein the step 2 is conducted immediately after the step 1.

10. The method for producing a metal foil-clad laminate according to claim 1 or 2, wherein the circuit board B obtained in the step 1 is stored in an atmosphere where moisture absorption is less likely to occur, and then the step 2 is conducted.

11. The method for producing a metal foil-clad laminate according to claim 1 or 2, comprising, in the step 1, obtaining the circuit board B in which a content of moisture contained in the circuit board A is reduced.

12. The method for producing a metal foil-clad laminate according to claim 1 or 2, wherein the heating in the step 1 is conducted at a temperature of from 30 to 200°C.

13. The method for producing a metal foil-clad laminate according to claim 1 or 2, wherein the heating in the step 2 is conducted at a temperature of from 80 to 190°C and at a pressure of from 3 to 30 kgf/cm².

14. The method for producing a metal foil-clad laminate according to claim 1 or 2, wherein the heating in the step 3 is conducted at a temperature of from 80 to 190°C and at a pressure of from 3 to 30 kgf/cm².

15. The method for producing a metal foil-clad laminate according to claim 1 or 2, wherein the metal foil is a copper foil.

16. The method for producing a metal foil-clad laminate according to claim 1 or 2, wherein the resin composite sheet C comprises a carrier substrate, the metal foil, and the resin composition layer, in this order.

17. The method for producing a metal foil-clad laminate according to claim 1 or 2, wherein the resin composition comprises a thermosetting resin, and an inorganic filler in an amount of from 0 to 250 parts by mass per 100 parts by mass of a resin solid content contained in the resin composition.

18. A resin composition, which is a resin composition to be used for producing a metal foil-clad laminate, in which a resin composite sheet C comprising a metal foil and a resin composition layer disposed on one side of the metal foil is laminated on a surface of a circuit board A comprising an insulating layer and a conductor circuit layer, by a method using a vacuum laminator and comprising steps set forth below, the resin composition comprising a thermosetting resin, wherein a content of an inorganic filler is from 0 to 250 parts by mass per 100 parts by mass of a resin solid content contained in the resin composition;
Step 1: a step of reducing a content of moisture and/or a solvent contained in the circuit board A to obtain a circuit board B;
Step 2: a step of disposing the resin composite sheet C comprising a metal foil and a resin composition layer disposed on one side of the metal foil on at least one surface of the circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet C is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

19. The resin composition according to claim 18, wherein the thermosetting resin contains at least one selected from the group consisting of a polymer having a constitutional unit represented by Formula (V), a polyphenylene ether compound with a terminal unsaturated carbon-carbon double bond, a maleimide compound, a cyanate ester compound, an epoxy compound, a phenolic compound, an oxetane resin, a benzoxazine compound, and an alkenyl-substituted nadimide compound, 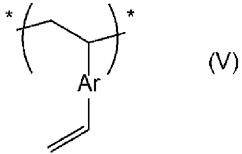 where in Formula (V), Ar represents an aromatic hydrocarbon linking group; and * represents a bonding position.

20. The resin composition according to claim 18 or 19, wherein
the resin composition contains an inorganic filler, and
the inorganic filler contains silica.

21. The resin composition according to claim 18 or 19, wherein
the resin composition contains an inorganic filler, and
the inorganic filler has an average particle diameter (D50) of 0.1 µm or more and 5 µm or less.

22. A resin composite sheet, which is a resin composition sheet to be used for producing a metal foil-clad laminate, in which the resin composite sheet comprising a metal foil and a resin composition layer disposed on one side of the metal foil is laminated on a surface of a circuit board A comprising an insulating layer and a conductor circuit layer, by a method using a vacuum laminator and comprising steps set forth below, the resin composition comprising a thermosetting resin, wherein a content of an inorganic filler is from 0 to 250 parts by mass per 100 parts by mass of a resin solid content contained in the resin composition;
Step 1: a step of reducing a content of moisture and/or a solvent contained in the circuit board A to obtain a circuit board B;
Step 2: a step of disposing the resin composite sheet comprising a metal foil and a resin composition layer disposed on one side of the metal foil on at least one surface of a circuit board B in a way that a side of the resin composition layer is in contact with the circuit board B, and heating and applying pressure from a surface on a side of the metal foil under an environment of reduced pressure or vacuum to obtain a laminated substrate D in which the resin composite sheet is laminated on at least one surface of the circuit board B; and
Step 3: a step of heating and applying pressure from a surface on a side of the metal foil of the laminated substrate D obtained in the step 2 by using a pressing metal plate or a laminating metal roll to smooth a surface of the resin composition layer of the laminated substrate D to obtain a laminated substrate E.

23. The resin composite sheet according to claim 22, wherein the resin composite sheet comprises a carrier substrate, the metal foil, and the resin composition layer, in this order.

24. The resin composite sheet according to claim 22 or 23, wherein the metal foil is a copper foil.

25. The resin composite sheet according to claim 22 or 23, wherein the thermosetting resin contains at least one selected from the group consisting of a polymer having a constitutional unit represented by Formula (V), a polyphenylene ether compound with a terminal unsaturated carbon-carbon double bond, a maleimide compound, a cyanate ester compound, an epoxy compound, a phenolic compound, an oxetane resin, a benzoxazine compound, and an alkenyl-substituted nadimide compound; 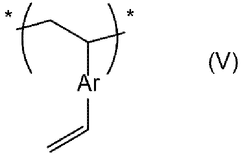 where in Formula (V), Ar represents an aromatic hydrocarbon linking group; and * represents a bonding position.

26. The resin composite sheet according to claim 22 or 23, wherein the resin composition contains an inorganic filler, and
the inorganic filler contains silica.

27. The resin composite sheet according to claim 22 or 23, wherein the resin composition contains an inorganic filler, and
the inorganic filler has an average particle diameter (D50) of 0.1 µm or more and 5 µm or less.

28. A method for producing a printed wiring board, the method comprising the method for producing a metal foil-clad laminate according to claim 1 or 2.

29. A method for producing a semiconductor device, the method comprising the method for producing a metal foil-clad laminate according to claim 1 or 2.
